(19) Europäisches Patentamt
European Patent Office
Office européen des brevets

(11) **EP 2 068 450 A2**

(12) **EUROPEAN PATENT APPLICATION**


(43) Date of publication:
**10.06.2009 Bulletin 2009/24**

(51) Int Cl.:
***H03M 13/11*** *(2006.01)* ***H03M 13/29*** *(2006.01)*

(21) Application number: **09153390.1**

(22) Date of filing: **12.08.2005**

(84) Designated Contracting States:
**DE FR GB IT**

(30) Priority: **14.01.2005 PCT/JP2005/000367**

(62) Document number(s) of the earlier application(s) in accordance with Art. 76 EPC:
**05780271.2 / 1 837 999**



(71) Applicant: **Fujitsu Limited**
**Kawasaki-shi, Kanagawa 211-8588 (JP)**

(72) Inventors:
- **Miyazaki, Shunji**
**Kawasaki-shi, Kanagawa 211-8588 (JP)**
- **Obuchi, Kazuhisa**
**Kawasaki-shi, Kanagawa 211-8588 (JP)**
- **Yano,Tetsuya**
**Kawasaki-shi, Kanagawa 211-8588 (JP)**

(74) Representative: **Stebbing, Timothy Charles**
**Haseltine Lake**
**Lincoln House, 5th Floor**
**300 High Holborn**
**London WC1V 7JH (GB)**


Remarks:
This application was filed on 23-02-2009 as a divisional application to the application mentioned under INID code 62.

(54) **Dummy bit insertion for systematic codes**


(57) In a system in which systematic code, comprising information alphabet elements to which parity alphabet elements have been added, is transmitted and received, (1) K0 dummy alphabet elements are added to K information alphabet elements to generate first code of K1 (=K+K0) information alphabet elements; (2) M parity alphabet elements, created from the first code of K1 information alphabet elements, are added to this first code of K1 information alphabet elements, and the K0 dummy alphabet elements are deleted to generate systematic code of N (=K+M) alphabet elements; and (3) the systematic code is received on the receiving side, the K0 dummy alphabet elements are added to the received systematic code, and decoding of the code of N1 alphabet elements obtained by adding the K0 dummy alphabet elements, is performed.


*FIG. 1*

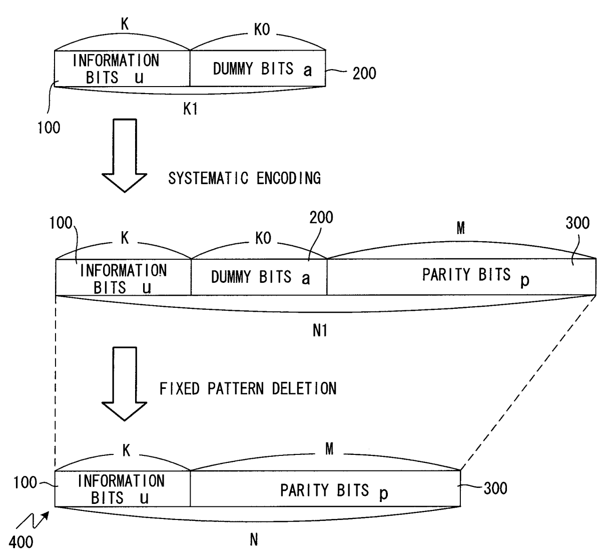


EP 2 068 450 A2

## Description

### Technical Field

This invention relates to an encoding method, a decoding method, and devices for these respective methods, in a system for transmission and reception of systematic codes, in which parity alphabet elements are added to the information alphabet elements.

### Background Art

· Systematic codes and block codes

In general, by reference to Fig.35 encoding using an information alphabet element having q different values (a typical example is bit, q=2), is making a correspondence between a block $I_1$ consisted of K information alphabet elements (information bits) and a block I2 consisted of N information alphabet elements wherein N is greater than K and an 1-to-1 association of all the possible patterns of the block $I_1$ (of which there are $q^K$) with patterns of the block I2 is established.
Here, a code of block I2 which is configured such that K alphabet elements among the N alphabet elements are same as the original information alphabet elements is called a systematic code. The remaining M = N-K alphabet elements are called the parity alphabet elements, and normally are obtained by addition or other stipulated processing of the K information alphabet elements.
That is, a block code is a code in which, among the constituent bits of a codeword consisting of N bits, K bits are information, and the remaining M (=N-K) bits are parity bits used for error detection and correction; and a systematic code is a block code in which the beginning K bits of a codeword are information bits, and thereafter (N-K) parity bits follow.
On the transmission side, using a K×N generator matrix G=(gij); i=0,...,K-1; j=0,...,N-1 and K information alphabet elements $u=(u_0,u_1,...,u_{K-1})$, employing the equation

$$x = uG \tag{1}$$

to generate a code of N alphabet elements $x=(x_0,x_1,...,x_{N-1})$, then this code x becomes a block code, and the information alphabet elements u are block-encoded.
On the reception side, the information alphabet elements u are estimated from the received data for the code vector x. To this end, the following parity check relation is used for x.

$$xH^T = 0 \tag{2}$$

Here, H=(hij); i=0,...,M-1; j=0,...,N-1 is the parity check matrix, and $H^T$ is the transpose of H (with rows and columns substituted). From equations (1) and (2), H and G satisfy the following relation.

$$GH^T = 0 \tag{3}$$

From this it follows that if either H or G is given, the encoding rule is uniquely determined.
Fig. 36 shows the configuration of a communication system in which block encoding is performed in a transmitter, and decoding is performed in a receiver; the transmitter 1 comprises an encoding portion 1a, which encodes information u comprising K bits to generate an N-bit block code x, and a modulation portion 1b which modulates and transmits the block code. The receiver 2 comprises a demodulation portion 2a which demodulates signals received via the transmission path 3, and a decoding portion 2b which decodes the N bits of received information to obtain the originally transmitted K bits of information.
The encoding portion 1a comprises a parity generator 1c which generates M (=N-K) parity bits p, and an P/S conversion portion 1d which combines K bits of the information u and M parity bits p to output an N (=K+M)-bit block code x. The encoding portion 1a outputs a block code x according to equation (1), and as one example, if x is systematic code, the encoding portion 1a can numerically be represented by the generator matrix G shown in Fig. 37. The decoding portion 2a comprises a decoder 2c which performs error detection/correction processing of reception likelihood data y, decodes the originally transmitted K bits of information, and outputs estimation information. The block code x transmitted from the transmitter 1 is affected by the transmission path 3, and is not input to the decoder 2c in the same state as when transmitted, and so data is input to the decoder 2c as likelihood data. Likelihood data comprises reliability that a code bit is 0 or 1, and a sign (0 if +1, 1 if -1). The decoder 2c performs stipulated decoding processing based on likelihood data for each code bit, and estimates the information bits u. The decoding portion 2b performs decoding according to equation (2); as an example, if x is systematic code and the generator matrix G is the matrix shown in Fig. 37, then the decoding portion 2b can be represented by the transpose matrix of the parity check matrix H shown in Fig. 38.

· LDPC codes

LDPC (Low-Density Parity-Check) codes is a general term for codes defined by a check matrix H with a low ratio of the number of elements different from 0 in the block code (when q=2, then number of "1"s) to the total number of elements.
In particular, when the number of elements (number of "1"s) in each of the rows and in each of the columns of the check matrix H is constant, the code is called a "regular LDPC code", and is characterized by the code length N and by the weights ($w_c$, $w_r$) which are the numbers of elements in each of the columns and rows respectively. On the other hand, codes of the type for which different weights in each of the columns and rows in the check matrix H are permitted are called "irregular LDPC codes", and are characterized by the code length N and by the row and column weight distribution (($\lambda_j$, $\rho_k$); j=1,...,$j_{max}$; k=1,...,$k_{max}$)). Here, $\lambda_j$ indicates the ratio of the number of elements other than 0 (the number of "1"s) belonging to columns with weight j to the total number. Fig. 39 explains the weight distribution; in an M×N check matrix H, if the number of columns in which the number of "1"s is j is $N_j$, and the total number of "1"s in the check matrix H is E, then the weight distribution $\lambda_j$ is

$$\lambda_j = j \times N_j / E$$

and the ratio $f_j$ of the number of columns with j "1"s to the total number of columns is

$$f_j = N_j / N$$

For example, if j=3 and $N_j$=$_4$, then $\lambda_3$=12/E, and $f_j$=4/N. $\rho_k$ is the ratio of the number of elements different from 0 (the number of "1"s) belonging to rows with weight k to the total number of elements, and can be defined similarly to $\lambda_j$. A regular LDPC code can also be regarded as a special case of an irregular LDPC code.
Whether an LDPC code is regular or irregular, the specific check matrix is not uniquely determined merely by specifying the code length N and weight distribution. In other words, it is possible that numerous specific methods for placement of "1"s (methods for placement of elements different from "0") exist which satisfy a stipulated weight distribution, and these methods each define different codes. The error rate characteristic of a code depends on the weight distribution and on the specific method of placement of "1"s in the check matrix satisfying the weight distribution. The circuit scale, processing time, processing quantity, and similar of the encoder and decoder are in essence affected only by the weight distribution.

· Turbo codes

Turbo codes are systematic codes which, by adopting maximum a posteriori probability (MAP) decoding, can reduce errors in decoding results each time decoding is repeated.
Fig. 40 shows the configuration of a turbo encoder portion 1a in the configuration of a communication system comprising a turbo encoder and a turbo decoder; Fig. 41 shows the configuration of a turbo decoder portion 2b.
In Fig. 40, u (={u1,u2,u3,...,$u_N$}) is the transmitted information data of length N; xa, xb, xc are coded data resulting from encoding of the information data u by the turbo encoder portion 1a; ya, yb, yc are the reception signals received as a result of propagation of the encoded data xa, xb, xc over the communication path 3 and being affected by noise and fading; and u' is the decoding result of decoding of the reception data ya, yb, yc in the turbo decoder portion 2b.
In the turbo encoder portion 1a, the encoded data xa is the information data u itself, the encoded data xb is data resulting from convolution encoding of the information data u by the encoder ENC1, and the encoded data xc is the data resulting

from interleaving ($\pi$) and convolution encoding of the information data u by the encoder ENC2. That is, the turbo code is a systematic code combining two or more element codes; xa is information bits, and xb and xc are parity bits. The P/S conversion portion 1d converts the encoded data xa, xb, xc into serial data and outputs the result.

In the turbo decoder 2b in Fig. 41, among the reception signals ya, yb and yc, the first element decoder DEC1 uses ya and yb to perform decoding. The element decoder DEC1 is a soft-decision output element decoder which outputs decoding result likelihoods. Next, the second element decoder DEC2 uses the likelihood output from the first element decoder DEC1 and yc to perform similar decoding. The second element decoder DEC2 is also a soft-decision output element decoder, which outputs decoding result likelihoods. In this case, yc is the reception signal corresponding to xc, resulting from interleaving the original data u and encoding, and so the likelihood output from the first element decoder DEC1 is interleaved ($\pi$) prior to input to the second element decoder DEC2. The likelihood output from the second element decoder DEC2 is deinterleaved ($\pi^{-1}$) and is then input to the first element decoder DEC1 as feedback. The result of a "0", "1" hard decision of the deinterleaved result of the second element decoder DEC2 becomes the turbo decoding result (decoded data) u'. Thereafter, by repeating the above decoding operation a prescribed number of times, the error rate of the decoding result u' is decreased. As the first and second element decoders DEC1 and DEC2 in this turbo element decoder, MAP element decoders can be used.

· Puncturing

If a code C1 of information length K and code length N1 is given, then the code rate of this code C1 is R1 = K/N1. There are cases in which a code having a higher code rate than R1 must be constructed using this code C1; in such cases, puncturing is performed. That is, N0 bits are removed from among the N1 code bits by the transmitter, as indicated in Fig. 42, and the result is transmitted as having code length N (=N1-N0). Because the positions of the removed bits are known, the receiver interpolates data such that each bit has equal probability and performs decoding processing, to infer the code C1. In this puncturing, the code rate becomes R = K/N (>R1).

· Repetition

When a code C1 with information length K and code length N1 is given, there are cases in which a code having a lower code rate than R1 (= K/N1) must be constructed using this code C1; in such cases, repetition is performed. That is, as shown in Fig. 43, the transmitter adds N0 elements overall to the code C1 in which the N0 elements are created by repeating one or more times for a number of alphabet elements among the N1 elements (not limited to parity elements), and the result is transmitted as a codeword with N (=N1+N0) alphabet elements. The receiver performs diversity combination for the repeated alphabet data (as the simplest method, simply performs addition), to perform decoding of the code C1.

· LDPC code nulling

In a nulling method for an LDPC code, K0 all-"0"s bits are set at the beginning of K information bits and encoding and decoding processing are performed, as shown in Fig. 44, to adjust the code rate R (where R<R1) (see the non-patent document 1). In the nulling method for LDPC codes, the code rate is R1 = (K0+K)/N1. The weight distribution coefficients $L_j^{(R1)}$ which characterize the check matrix for a code with code rate R1 are given by the density evolution method (see the Non patent document 2).

A code with code rate R (=K/N) is equivalent to adding K0 all-"0"s information bits to the beginning of K information bits, performing encoding using a K1×N1 generator matrix, transmitting the encoded data, and on the receiving side decoding by using an M×N check matrix with K0 columns removed from the beginning of the M×N1 check matrix. Hence the weight distribution coefficients $L_j^{(R)}$ for the N columns of the M×N check matrix of the LDPC code with code rate R is set such that

$$L_j^{(R)} = \frac{1-R1}{1-R} L_j^{(R1)} \quad (4)$$

Because the number of parity bits M does not change, M = N-K = N1-K1, and so the following relation obtains.

$$1-R1=\frac{M}{N1},1-R=\frac{M}{N} \Rightarrow N=\frac{1-R1}{1-R}N1 \quad (5)$$

In the nulling method for an LDPC code, no stipulations are made regarding the method of transmission of a code produced by encoding using a K1×N1 generator matrix.

· Filler bit addition (code segmentation)

In the W-CDMA system of a third-generation wireless mobile communication system IMT-2000 based on 3GPP, standards call for encoding of data using turbo codes. Hence in order to make the information bit size 40 bits when the information bit size is less than 40 bits, "0"-value bits are inserted as filler bits at the beginning, as shown in Fig. 45. In addition, when the information bit size is a large size exceeding 5114, the information bits are divided into a plurality of blocks having the same size insofar as possible, and in order to bring the remaining number into agreement, "0"-value bits are inserted as filler bits at the beginning. Then, the respective blocks are encoded, and are modulated and transmitted, including the filler bits.
Hence with respect to the addition of a prescribed number of bits and encoding, the method is similar to that of Fig. 44; here, however, the number of bits is such that the code rate does not change greatly.

· Problems

(1) When encoding in the same format (code length N, information length K), the error rate characteristic differs depending on the encoding method. In an information communication system, if the circuit scale for implementation and the processing amount are approximately the same, and if the power per bit is the same, then the encoding method must be selected such that the error rate is as low as possible.
In particular, with respect to LDPC codes, if an attempt is made to improve characteristics for the same format (code length N, information length K), the weight distribution of the check matrix H must be optimized, and complicated numerical calculations become necessary. Moreover, a code which satisfies a required code rate and can be implemented simply is not necessarily the optimal code in terms of characteristics.

(2) In an information communication system, when a plurality of formats (code length, information length) are employed adaptively in data transmission, encoders must be prepared according to each of the different formats, so that the circuit scale is increased. In the rate matching method, an encoder is prepared only for a code (called a "mother code") corresponding to one code rate, as described above, and by either removing a portion of the encoded code (puncturing) or repeating a portion (repetition) in the encoder, different formats can be supported, and the circuit scale can be reduced.
However, in the rate matching method, a code having a low code rate is used as the mother code, and puncturing is employed in order to prepare other codes with higher code rates than this; but because puncturing entails deletion of information necessary for decoding, there is the problem that characteristics are greatly degraded. Conversely, when a code having a higher code rate is prepared as the mother code, and a code with a lower code rate is to be prepared using repetition, decoding of a code with a shorter code length is performed, and so there is the problem that adequate characteristics are not obtained.
Further, if the encoder and decoder are restricted to use a code with the same format, then when using puncturing (see Fig. 42), processing (deletion, estimation) of the alphabet elements to be deleted in encoding and decoding processing becomes necessary. On the other hand, when using repetition (Fig. 43), the repeated alphabet data must be transmitted over the transmission path, and resources for this are necessary.

(3) It is conceivable that the "nulling method" of the example of the prior art be applied in order to resolve the above problems (1) and (2). However, in the nulling method of the prior art, the all-"0"s which are added are also transmitted and subjected to decoding processing, so that reliability is lowered due to transmission errors, and there is the problem that decoding errors are increased.

(4) Further, the nulling method of the prior art is limited to an all-"0"s pattern, and there is the problem that freedom in defining the code is not used effectively.

(5) Also, in the nulling method, equation (4) is used to adjust the weight distribution of the check matrix from the mother code weight distribution $L_j^{(R1)}$ based on the code rate. However, there is the problem that the distribution does not provide optimum characteristics for the given code rate.

(6) In methods of the prior art entailing addition of filler bits, the filler bits are transmitted as-is, and so there is the problem that wasteful transmission costs are necessary.

In light of the above, an object of this invention is to improve the error rate in encoding methods, decoding methods, and devices thereof in which dummy bits are added to information bits.
A further object of the invention is to realize codes with a plurality of code rates through a single encoder, without the occurrence of problems in a rate matching method.
A further object of the invention is to realize the optimum dummy bit distribution for an LDPC code with a given code rate and a given weight distribution.
A further object of the invention is to define different codes by causing dummy bit patterns to be different, by this means to increase the freedom of code design and realize optimum codes, or to realize applications such as authentication of a plurality of terminals.
A further object of the invention is to avoid transmission of dummy bits from the transmitting side to the receiving side, and to reduce power consumption by the transmitter and receiver and reduce the band used by the transmission path.
A further object of the invention is to avoid transmission of dummy bits from the transmitting side to the receiving side, and to add dummy bits having maximum likelihoods on the receiving side to the received data when performing decoding, to reduce decoding errors.
Non patent document 1: T. Tian, C. Jones, and J.D. Villasenor, "Rate-Compatible Low-Density Parity-Check Codes", submitted to Int. Sym, on Information Theory, 2004)
Non patent document 2: S. Chung, T. Richardson, and R. Urbanke, "Analysis of sum-product decoding of low-density parity-check codes using a Gaussian approximation", IEEE Trans, Inform. Theory, vol. 47, pp. 657-670, Feb. 2001

## Disclosure of the Invention

A first invention comprises a first step of adding K0 dummy alphabet elements in a prescribed pattern to K information alphabet elements to generate a first code of K1 (=K+K0) information alphabet elements; a second step of adding, to the first code of K1 information alphabet elements, M parity alphabet elements created from this first code of K1 information alphabet elements to generate a second code of N1 (=K1+M) information alphabet elements; and a third step of deleting said K0 dummy alphabet elements in the prescribed pattern from the second code of N1 information alphabet elements, to generate systematic codes of N (=K+M) alphabet element.
The second step of the above encoding method comprises a step of creating M parity alphabet elements from the first code of K1 information alphabet elements, and a step of adding the M parity alphabet elements to this first code of K1 information alphabet elements to generate a second code of N1 (=M+K1) information alphabet elements.
In the above encoding method, when the K information alphabet elements are divided uniformly into K0 divisions, said K0 dummy alphabet elements in the prescribed pattern are inserted at each division position one by one.
In the above encoding method, when the systematic code is an LDPC code, if the known weight distribution of the N1×M check matrix used in decoding is ($\lambda_j$, $\rho_k$), and the optimum weight distribution of the N×M check matrix resulting from exclusion of the K0 columns from this check matrix is ($\lambda_j'$, $\rho_k'$), then the K0 columns are determined such that the weight distribution of the N×M check matrix resulting from exclusion of K0 columns from the N1×M check matrix is said optimum weight distribution ($\lambda_j'$, $\rho_k'$), and the positions corresponding to the K0 columns thus determined are used as insertion positions of the K0 dummy alphabet elements in the prescribed pattern.
In the above encoding method, the insertion positions of the K0 dummy alphabet elements in the prescribed pattern are determined such that the minimum Hamming distance becomes greater.
In the above encoding method, different patterns are assigned to mobile terminals as dummy alphabet element patterns, and the prescribed pattern of a prescribed mobile terminal is used to perform encoding and transmit encoded data to the mobile terminal.
In the above encoding method, a computation in conformity with said dummy alphabet elements in the prescribed pattern necessary for the creation of the M parity alphabet elements is executed in advance and the computation results are stored in a memory, and the stored computation results are employed upon computation of the parity alphabet elements.
A second invention is a decoding method for a code data encoded by the above encoding methods, and has a step of receiving, from the encoding side, said systematic code of N alphabet elements; a step of adding, to the received systematic code, said K0 dummy alphabet elements in the prescribed pattern; and a step of performing decoding processing of the code of N1 information alphabet elements which is obtained by adding the dummy alphabet elements.
In the above decoding method, a computation in conformity with said dummy alphabet elements in the prescribed pattern necessary for decoding is executed in advance and the computation results are stored in a memory, and upon decoding the stored computation results are utilized.

A third invention is an encoding device in a system in which a systematic code, comprising information alphabet elements to which parity alphabet elements are added, is transmitted and received, and comprises a prescribed pattern addition portion, which adds K0 dummy alphabet elements in a prescribed pattern to K information alphabet elements to generate a first code of K1 (=K+K0) information alphabet elements; an encoding portion, which adds M parity alphabet elements, created from the first code of K1 information alphabet elements, to this first code of K1 information alphabet elements to generate a second code of N1 (=K1+M) information alphabet elements, obtained by adding; and a systematic code generation portion, which deletes said K0 dummy alphabet elements in the prescribed pattern, included in the second code of N1 information alphabet elements, to generate systematic code of N(=K+M) alphabet elements.

The encoding portion comprises a parity generator, which creates the M parity alphabet elements from said first code of K1 information alphabet elements, and a combination portion, which adds the M parity alphabet elements to said first code of K1 information alphabet elements to generate the second code of N1 (=M+K1) information alphabet elements.

Further, an encoding device of this invention comprises a dummy bit addition portion, which adds dummy bits to information bits; a turbo encoding portion, which performs turbo encoding by adding the parity bits created from the information bits to these information bits; a dummy bit deletion portion, which deletes dummy bits from the turbo code; and a transmission portion, which transmits the systematic code from which dummy bits have been deleted. On the receiving side the systematic code is received, and the dummy bits deleted on the transmitting side are added to the received systematic code at maximum likelihoods, then turbo decoding is performed.

A fourth invention is a receiver which receives code data encoded by the above encoding device, comprising a receiving portion which receives systematic codes comprising N alphabet elements from the encoding side, a prescribed pattern addition portion which adds the K0 prescribed pattern alphabet elements to the received systematic code, and a decoder which performs decoding processing of the N1 information alphabet elements thus obtained.

Brief Description of the Drawings

Fig. 1 explains an encoding method of the invention;

Fig. 2 shows the configuration of a wireless communication system in which systematic code data, comprising information alphabet elements with parity bits added, is transmitted and received;

Fig. 3 explains a generator matrix G1 and check matrix H1 of the invention;

Fig. 4 explains a Tanner graph;

Fig. 5 explains another Tanner graph;

Fig. 6 is a subgraph of a Tanner graph when the 0th column of check matrix H is $[111000...0]^T$;

Fig. 7 is a subgraph of a Tanner graph when the 0th column of check matrix H is [1110100...0];

Fig. 8 explains the definition of terms used in a Sum-Product Algorithm (SPA);

Fig. 9 explains messages $q_{ij}(b)$, $r_{ji}(b)$;

Fig. 10 explains dummy bit addition positions;

Fig. 11 explains a method of placement when the K0 dummy bit insertion positions are at equal intervals;

Fig. 12 shows the configuration of a dummy bit addition portion;

Fig. 13 explains the method of determination of optimum dummy bit addition positions in a third embodiment;

Fig. 14 shows the flow of dummy bit addition position determination processing in the third embodiment;

Fig. 15 shows the flow of dummy bit addition position determination processing in a fourth embodiment;

Fig. 16 explains a fifth embodiment;

Fig. 17 shows the configuration of the encoder in a sixth embodiment;

Fig. 18 shows the configuration of the decoder in a seventh embodiment;

Fig. 19 shows the first processing flow of a Sum-Product Algorithm (SPA) using logarithmic likelihood ratio in the seventh embodiment;

Fig. 20 shows the second processing flow of a Sum-Product Algorithm (SPA) using logarithmic likelihood ratio in the seventh embodiment;

Fig. 21 explains the encoding/decoding method using turbo codes of an eighth embodiment;

Fig. 22 shows the configuration of a turbo encoder which is an encoder in a mobile communication system;

Fig. 23 shows the configuration of a decoding portion in a mobile communication system;

Fig. 24 explains the encoding/decoding method in a first modified example of the eighth embodiment;

Fig. 25 shows the configuration of the wireless communication system of the first modified example;

Fig. 26 explains the encoding/decoding method in a second modified example of the eighth embodiment;

Fig. 27 explains the advantageous results of the second modified example;

Fig. 28 shows the configuration of the wireless communication system of the second modified example;

Fig. 29 explains the encoding/decoding method in a third modified example;

Fig. 30 shows the configuration of the wireless communication system in the third modified example;

Fig. 31 explains the encoding/decoding method in a fourth modified example;

Fig. 32 shows the configuration of the wireless communication system in the fourth modified example;

Fig. 33 explains the encoding/decoding method in a fifth modified example;

Fig. 34 shows the configuration of the wireless communication system in the fifth modified example;

Fig. 35 explains systematic codes and block codes;

Fig. 36 shows the configuration of a communication system in which block encoding is performed in a transmitter, and decoding is performed in a receiver;

Fig. 37 explains a generator matrix G in an encoding portion;

Fig. 38 explains a check matrix H in a decoder;

Fig. 39 explains a weight distribution;

Fig. 40 shows the configuration of a communication system comprising a turbo encoder and a turbo decoder;

Fig. 41 shows the configuration of a turbo decoder;

Fig. 42 explains puncturing;

Fig. 43 explains repetition;

Fig. 44 explains an LDPC code nulling method; and

Fig. 45 explains filler bit addition.

## Best Mode for Carrying Out the Invention

### (A) First Embodiment

#### (a) Encoding method

Fig. 1 explains an encoding method in a system to transmit and receive data using a systematic code, formed by adding parity alphabet elements to information alphabet elements. In the following explanation it is assumed that q=2, and in place of the term "alphabet", the word "bit" is used; however, this invention is not limited to the case q=2.
K0 dummy bits in a prescribed pattern 200 are added to K information bits 100 to form K1 (=K+K0) information bits. The dummy bits are not limited to specific patterns such as an all-"1"s pattern or an all-"0"s pattern or a pattern such as 1010...10 which alternates "1"s and "0"s, and any prescribed pattern can be used. This is similarly true for all of the following embodiments as well.
Next, M parity bits 300, created using the K1 (=K+K0) information bits, are added to the K1 information bits to generate N1 (=K1+M) information bits (systematic encoding). Then, K0 dummy bits 200 are deleted from the N1 information bits to generate N (=K+M) bits of systematic code 400. The systematic code encoded in this way is transmitted from the transmitter to the receiver, and is decoded at the receiver.

#### (b) Wireless communication system

Fig. 2 shows the configuration of a wireless communication system which transmits and receives systematic codes formed by adding parity bits to information bits. The encoding portion 11 of the transmitter 10 applies Forward Error Correction (FEC) to the information bits u in order to transmit data with high reliability, and the modulation portion 12 modulates the resulting code bits x and transmits the result to the receiver 20 over the wireless transmission path 30. The demodulation portion 21 of the receiver 20 demodulates the reception data, and inputs to the decoding portion 22 likelihood data y comprising the reliability that code bits are 0 or 1 and hard-decision codes ($+1\rightarrow 0$, $-1\rightarrow 1$). The decoding portion 22 performs stipulated decoding processing based on the likelihood data for each code bit, and estimates the information bits u. An LDPC code is used as the FEC code C1; the code type is a systematic code. A turbo code can be used as the FEC code; this is explained in the eighth embodiment.
The dummy bit addition portion 11a in the encoding portion 11 of the transmitter 10 adds K0 randomly selected bits 0, 1, as dummy bits to the K information bits u in randomly selected positions , and outputs K1 (= K+K0) information bits

$$(u,a) = (u_0,\ldots,u_{K-1},a_0,\ldots,a_{K0-1})$$

(see Fig. 1). The encoder 11b uses the K1×N1 generator matrix

$$G1 = (g_1ij);\ i=0 \text{ to } K1-1;\ j = 0 \text{ to } N1-1$$

and employs the following formula

$$(u,a)G1$$

to output N1 (=K+K0+M) information bits $x_1(u,a,p)$. Here, p comprises M parity bits:

$$p = (p_0,\ldots,p_{M-1})\ .$$

If the K×N generator matrix G when no dummy bits are inserted is as shown in (A) of Fig. 3, then the above K1×N1 generator matrix G1 is as shown in (B) of Fig. 3, and the parity bits p are

$$p = (uP, aQ) .$$

Further, the check matrix H1 used in decoding is as shown in (C) of Fig. 3.
The dummy bit deletion portion 11c deletes K0 dummy bits a from the N1 information bits $x_1$(u,a,p) output from the encoder 11b, to generate N information bits

$$x = (u,p) = (x_0, x_1, ..., x_{N-1}) .$$

The modulation portion 12 modulates and transmits the information bits x.
The encoder 11b outputs information bits (u,a,p) according to the above-described principle; but in actual practice, the parity generator 11b-1 takes K1 information bits (u,a) as input to create M parity bits p, and the combination portion 11b-2 combines the K1 information bits (u,a) with the M parity bits p to output N1 information bits (u,a,p).
The reception portion 21 of the receiver 20 receives and demodulates data which has passed through the propagation path 30 and has had noise added, and for each code bit, inputs likelihood data,

$$y = (y_0, y_1, ..., y_{N-1})$$

to the decoding portion 22. The dummy bit likelihood addition portion 22a of the decoder 22 adds likelihood data (a) with probability 1 corresponding to dummy bits added at the transmitter, to the likelihood data (y) and inputs the result as N1 (=N+K0) likelihood data items to the decoder 22b. The decoder 22b performs LDPC decoding processing or turbo decoding processing of the N1 likelihood data items (y,a), and outputs information bit estimation results. In the case of LDPC decoding processing, the well-known Sum-Product method is used to perform decoding processing to output the information bit estimation results.
The encoding portion 11 is implemented such that encoding with a maximum code rate R1 (=(K+K0)/N1) is possible. When K0 is modified to realize codes with a plurality of code rates, codes are output appropriately from the encoding portion 11 according to the magnitude of the code rate. By this means, no problems arise when using the rate matching method, and codes with a plurality of code rates can be realized by a single encoder.

(c) Sum-Product method

· Tanner graphs

Tanner graphs are useful to aid understanding of the Sum-Product method. As shown in (A) of Fig. 4, in a Tanner graph the M check nodes $f_0, f_1, ..., f_{M-1}$ associated with each row of an M×N check matrix are arranged above, and the N variable nodes $c_0, c_1, ..., c_{N-1}$ associated with each column are arranged below; when the matrix element of the ith row and jth column is 1, an edge connects the check node $f_i$ and the variable node $c_j$. For example, if the check matrix H is as shown in (B) of Fig. 4, then the Tanner graph is shown in (C) of Fig. 4.
The likelihood data $y = (y_0, y_1, ..., y_5)$ is input to the variable nodes $c_0, c_1, ..., c_5$. If y = x, then

$$xH^T = 0 \qquad (6)$$

obtains, and in the example of (C) of Fig. 4, as shown in Fig. 5,

$$x_0 + x_1 + x_2 = 0$$

$$x_2 + x_3 = 0$$

$$x_3 + x_4 + x_5 = 0$$

obtain.

· Repeated decoding algorithm

The Sum-Product method is a method in which, based on a Tanner graph, the a posteriori probability APP, described below, or the likelihood ratio LR, or the logarithmic likelihood ratio LLR, is determined repeatedly to estimate x, and an estimated value $\hat{x}$ satisfying equation (6) is determined. In the following explanation, in place of x, c is used, and it is assumed that code c = ($c_0$, $c_1$, ...,$c_{N-1}$) are transmitted. In this case, as the variable node notation, $c_0$, $c_1$, ... , $c_{N-1}$ is used; the terms "code" and "nodes" are used to distinguish between them.
When codes c = ($c_0$,$c_1$,...,$c_{N-1}$) is transmitted, the a posteriori probability APP, likelihood ratio LR, and logarithmic likelihood ratio LLR at the time the likelihood data y = ($y_0$,$y_1$,...,$y_{N-1}$) is received are represented by the following equations.

$$\begin{aligned} &APP: \quad \Pr(c_i = 1/y) \\ &LR: \quad l(c_i) \cong \frac{\Pr(c_i = 0/y)}{\Pr(c_i = 1/y)} \\ &LLR: \quad l(c_i) \cong \log\left(\frac{\Pr(c_i = 0/y)}{\Pr(c_i = 1/y)}\right) \end{aligned} \qquad (7)$$

In a Tanner graph, each variable node $c_i$ has an input message from a check node and likelihood data $y_i$, and passes an output message to an adjacent check node. When the 0th column of a check matrix H is $[111000...0]^T$, as shown in (A) of Fig. 6, a subgraph of the Tanner graph, as indicated in (B) of Fig. 6, has check nodes $f_0$, $f_1$, $f_2$ connected to a variable node $c_0$ to which the likelihood data $y_0$ is supplied. A message $m_{\uparrow 02}$ from variable node $c_0$ to check node $f_2$ is an output message which combines the messages from the check nodes $f_0$ and $f_1$ to the variable node $c_0$ and the likelihood data $y_0$ as shown in (C) of Fig. 6. This output message $m_{\uparrow 02}$ indicates the a posteriori probability $\Pr(c_0 = b|\text{input message})$, $b \in \{0,1\}$, that the code $c_0$ is 0 or 1, or the probability ratio, or the logarithmic probability ratio. In repeated half-cycles, $m_{\uparrow ij}$ are calculated for all combinations of nodes $c_i/f_j$.
When, as indicated in (A) of Fig. 7, the 0th row of the check matrix H is [1110100...0], then in a subgraph of the Tanner graph the check node $f_0$ is connected to the variable nodes $c_0$, $c_1$, $c_2$, $c_4$, as shown in (B) of Fig. 7. The message $m_{\downarrow 04}$ from the check node $f_0$ to the variable node $c_4$ is an output message which combines the messages from the variable nodes $c_0$, $c_1$, $c_2$ to the check node $f_0$, as shown in (C) of Fig. 7. This output message $m_{\downarrow 04}$ indicates the probability, or probability ratio, or logarithmic probability ratio, that for the input message the check formula $f_0$ is satisfied. The probability that for the input message the check formula $f_0$ is satisfied is represented by

$$\Pr(\text{check formula } f_0 \text{ satisfied}) \mid \text{input message}), \ b \in \{0,1\}$$

Through repetition of other half-cycles, $m_{\downarrow ji}$ are calculated for all node combinations $f_j/c_i$.

· Sum-Product algorithm (SPA) using a posteriori probability To begin with, terms used are defined as follows.

The set of all nodes connected to a check node $f_j$ is represented by $V_j$, as shown in (A) of Fig. 8, and the set of all variable nodes connected to check node $f_j$, but excluding variable node $c_i$, is represented by $v_j|i$. As shown in (B) of Fig. 8, the set of all check nodes connected to the variable node $c_i$ is represented by $C_i$, and the set of all check nodes connected to variable node $c_i$, but excluding check node $f_j$, is represented by $C_i|j$.
Further, messages from all variable nodes excluding node $c_i$ are represented by $M_v(\sim i)$, messages from all check nodes excluding node $f_j$ are represented by $M_c(\sim j)$, the a posteriori probability that code $c_i$ is 1 when likelihood data $y_i$ is received is represented by $P_i = Pr(c_i=1|y_i)$, and the satisfaction of the check formula comprising code $c_i$ is represented by $S_i$.
Further, it is assumed that

$$q_{ij}(b) = Pr(c_i=b \mid S_i, y_i, M_c(\sim j))$$

Here, $b\in\{0,1\}$. As shown in (C) of Fig. 8, in the case of the a posteriori probability (APP) algorithm $m_{\uparrow ij} = q_{ij}(b)$, in the case of the LR algorithm $m_{\uparrow ij} = q_{ij}(0)/q_{ij}(1)$, and in the case of the LLR algorithm $m_{\uparrow ij} = \log[q_{ij}(0)/q_{ij}(1)]$.
Moreover,

$$r_{ji}(b) = Pr(\text{check formula } f_j \text{ is satisfied} \mid ci = b, M_v(\sim i))$$

Here, $b\in\{0,1\}$. As shown in (D) of Fig. 8, in the case of the a posteriori probability (APP) algorithm $m_{\downarrow ji} = r_{ji}(b)$, in the case of the LR algorithm $m_{\downarrow ji} = r_{jd}(0)/r_{ji}(1)$, and in the case of the LLR algorithm $m_{\downarrow ji} = \log[r_{jj}(0)/r_{ji}(1)]$.
From the above definitions, the message $q_{ij}(b)$ shown in (A) of Fig. 9 is given by the following equations.

$$\begin{aligned} q_{ij}(0) &= \Pr(c_i = 0 \mid y_i, S_i, M_c(\sim j) \\ &= (1-P_i)\Pr(S_i \mid c_i = 0, y_i, M_c(\sim j))/\Pr(S_i) \\ &= K_{ij}(1-P_i)\prod_{j' \in C_i \backslash j} r_{j'i}(0) \end{aligned} \quad (8)$$

$$q_{ij}(1) = K_{ij}P_i \prod_{j' \in C_i \backslash j} r_{j'i}(1) \quad (9)$$

$K_{ij}$ is a coefficient which satisfies $q_{ij}(0)+q_{ij}(1) = 1$.
In a sequence of M binary digits $a_i$, the probability that $a_i$ is 1 is represented as $Pr(a_i=1) = p_i$. At this time, the probability that the sequence $\{a_i\}^M_{i=1}$ comprises an even number of "1"s is

$$\frac{1}{2} + \frac{1}{2}\prod_{l=i}^{M}(1-2p_i) \quad (10)$$

When the above equation and the fact that $p_i \rightarrow q_{ij}(1)$ are used, the equation

$$r_{ji}(0) = \frac{1}{2} + \frac{1}{2}\prod_{i' \in V_j \backslash i}(1 - 2q_{i'j}(1)) \qquad (11)$$

is obtained (see (B) in Fig. 9).
This is because, when code $c_i = 0$, in order that the check formula $f_j$ be satisfied, the bits of $\{c_{i'}: i' \in v_j¥i\}$ must have an even number of "1"s. If the check formula $f_j$ has an even number of "1"s, then $f_j \bmod 2 = 0$.
Further, the following equation obtains.

$$r_{ji}(1) = 1 - r_{ji}(0) \qquad (12)$$

From the above, the Sum-Product algorithm (SPA) using a posteriori probability is as follows.

Step 1 : For each of i = 0, 1, ..., n-1, the probability that code $c_i$ is 1 at the time the ith likelihood data $y_i$ is received is $P_i = Pr(c_i=1|y_i)$. At this time, for all i, j for which $h_{ij} = 1$, $q_{ij}(0) = 1-P_i$ and $q_{ij}(1) = P_i$.
Step 2: Equations (11) and (12) are used to update $\{r_{ji}(b)\}$.
Step 3: Equations (8) and (9) are used to update $\{q_{ji}(b)\}$.
Step 4: For i = 0, 1, ..., n-1, $Q_i(0)$ and $Q_i(1)$ are calculated using the following equations.

$$Q_i(0) = K_i(1 - P_i)\prod_{j \in C_i} r_{ji}(0) \qquad (13)$$

$$Q_i(1) = K_i P_i \prod_{j \in C_i} r_{ji}(1) \qquad (14)$$

Here the coefficients $K_i$ are chosen such that $Q_i(0)+Q_i(1) = 1$ obtains.
Step 5: If $Q_i(1) > Q_i(0)$, then let $\hat{c}_i = 1$, and if $Q_i(1) < Q_i(0)$, then let $\hat{c}_i = 0$.
Step 6: Finally, check whether the following equation

$$\hat{c}H^T = 0 \qquad (15)$$

obtains, or whether the maximum number of repetitions has been performed; if the above equation obtains, or if the maximum number of repetitions has been reached, then processing ends, and otherwise processing repeats from step 1.

· Sum-Product algorithm (SPA) using logarithmic likelihood ratios

In the above, the a posteriori probability Sum-Product algorithm (SPA) was explained; next, a Sum-Product algorithm (SPA) using logarithmic likelihood ratios is explained. Here

$$L(c_i) = \log\left(\frac{\Pr(c_i = 0 \mid y_i}{\Pr(c_i = 1 \mid y_i}\right)$$

$$L(r_{ji}) = \log\left(\frac{r_{ji}(0)}{r_{ji}(1)}\right)$$

$$L(q_{ij}) = \log\left(\frac{q_{ij}(0)}{q_{ij}(1)}\right)$$

$$L(Q_i) = \log\left(\frac{Q_i(0)}{Q_i(1)}\right)$$

Further, in a BEC (binary erasure channel), $L(q_{ij})$ is initialized as follows.

$$L(q_{ij}) = L(c_i) = \begin{cases} +\infty, & y_i = 0 \\ -\infty, & y_i = 1 \\ 0, & y_i = E \end{cases} \qquad (16)$$

Further, $L(q_{ij})$ is represented in terms of sign and amplitude as follows:

$$\begin{aligned} L(q_{ij}) &= \alpha_{ij}\beta_{ij} \\ \alpha_{ij} &= sign\left[L(q_{ij})\right] \\ \beta_{ij} &= \left|L(q_{ij})\right| \end{aligned}$$

As a result, $L(r_{ji})$ is obtained from the following equation.

$$L(r_{ji}) = \prod_{i' \in V_j \backslash i} \alpha_{i'j} \cdot \phi\left(\sum_{i' \in V_j \backslash i} \phi(\beta_{i'j})\right) \qquad (17)$$

Here,

$$\phi(x) = -\log[\tanh(x/2)] = \log\left(\frac{e^x+1}{e^x-1}\right) \qquad (18)$$

Also, $L(q_{ij})$ is given by the following equation:

$$L(q_{ij}) = L(c_i) + \sum_{j' \in C_i \setminus j} L(r_{j'i}) \qquad (19)$$

And, $L(Q_i)$ is determined from the following equation:

$$L(Q_i) = L(c_i) + \sum_{j \in C_i} L(r_{ji}) \qquad (20)$$

From the above, the Sum-Product algorithm (SPA) in the logarithmic domain is as follows.

Step 1: For each of i = 0, 1, ..., n-1, initialize $L(q_{ij})$ according to equation (16) for all i, j for which $h_{ij} = 1$.
Step 2: Equation (17) is used to update $L(r_{ji})$.
Step 3: Equation (19) is used to update $L(q_{ji})$.
Step 4: Equation (20) is used to determine $L(Q_i)$.
Step 5: For i = 0, 1, ..., n-1, if $L(Q_i) < 0$, then $\hat{c}_i = 1$, and if $L(Q_i) > 0$, then $\hat{c}_i = 0$.
Step 6: Finally, check whether the following equation

$$\hat{c}H^T = 0 \qquad (21)$$

obtains, or whether the maximum number of repetitions has been performed; if the above equation obtains, or if the maximum number of repetitions has been reached, then processing ends, and otherwise processing repeats from step 1.

According to the above first embodiment, because dummy bits are added and encoding is performed, the code rate is increased, and the characteristics as a code are worsened when dummy bits are included in information bits; but on the decoding side, decoding can be performed with likelihood data corresponding to a probability of 1 inserted at the bit positions corresponding to the dummy bits, so that the code characteristics (error detection and correction characteristics) can be improved. Even when for example the original code is a regular LDPC code, inserting likelihood data of infinitely great reliability corresponding to the dummy bits is equivalent to ignoring check matrix elements at dummy bit positions (from equation (18), $\phi(x)=0$), so that the characteristic is improved, and obtained is an effect which is equivalent to the effect of the encoding and decoding using an irregular LDPC code having a good characteristic. Moreover, there is the advantage that dummy bits are not transmitted, so that wasteful transmission costs are not incurred (the advantage that transmission efficiency does not decline).
Moreover, an encoding portion is installed enabling encoding at the minimum code rate, so that codes with a plurality of code rates can be realized using a single encoder.

(B) Second Embodiment

In Fig. 1, a case in which dummy bits 200 are added randomly to information bits 100 was explained; more specifically, addition can be performed as follows. (A) of Fig. 10 is an example in which dummy bits 200 are added all at once after information bits 100; (B) of Fig. 10 is an example in which dummy bits 200 are added all at once before information bits 100; and (C) of Fig. 10 is an example in which dummy bits 200 are added substantially uniformly to the information bits 100. Here, "substantially uniformly" means that there is no or almost no bias. As a method to add dummy bits substantially uniformly, for example, the rate-match pattern algorithm stipulated in 3GPP W-CDMA can be used to determine positions and add dummy bits. As a result of the dummy bit positions , the code characteristics change.
In particular, when an irregular LDPC code is used, among the columns of the check matrix $H_1$ corresponding to the dummy bits, columns of the same weight should be selected so that there is no bias. To this end, each of the weights is distributed evenly or randomly in columns of the check matrix $H_1$.
Fig. 11 explains a placement method in a case in which, among K1 (=K0+K) information bits in the first embodiment, the positions for insertion of K0 dummy bits are made substantially uniform, as shown in (C) of Fig. 10.

Within the range [0,1] of real numbers, the "real index" r(i) corresponding to each of the K0 dummy bits is defined as

$$r(i) = i/K0 \qquad (22)$$

At this time, the actual integer index s(i) is given by the following equation.

$$s(i) = [K \cdot r(i)+0.5] \qquad (23)$$

Here [z] is largest integer which is equal to or less than z. By changing i through 0, 1, ... , K0-1, the positions of the K0 dummy bits can be determined using equation (23).
Fig. 12 shows the configuration of the dummy bit addition portion 11a in Fig. 2; the K information bits are stored temporarily in the buffer portion 11a-1, the dummy bit generation portion 11a-2 generates K0 dummy bits, and the dummy bit position acquisition portion 11a-3 uses equation (23) to calculate K0 dummy bit positions, and inputs the positions to the combination portion 11a-4. The combination portion 11a-4 evenly inputs the K0 dummy bits 200 into the dummy bit positions of the information bits 100 one by one, as shown in Fig. 11, and outputs the result.

(C) Third Embodiment

The code characteristics change depending on the dummy bit addition positions. For this reason, in the third embodiment the optimum dummy bit addition positions for an LDPC code are determined, and dummy bits are added at these positions.
The check matrix $H_1$ when a fixed code is added is an M×N1 matrix, as shown in (C) of Fig. 3. Here M = N-K, and N1 = N+K0. The check matrix H' with no dummy bits added is the M×N matrix resulting by deletion of the $Q^T$ portion from the check matrix $H_1$. If an ideal situation is assumed, the encoding method of the first embodiment, in which dummy bits are inserted and encoding is performed, is no different in terms of characteristics from a method of deleting the columns (the $Q^T$ portion) corresponding to the dummy bits from the check matrix $H_1$, and using the M×N check matrix H' thus obtained to decode the received N likelihood data items y.
Hence as shown in Fig. 13, when the known weight distribution of the N1×M check matrix $H_1$ used in decoding is ($\lambda_j$, $\rho_k$), and the optimum weight distribution of the N×M check matrix H' resulting from removal of K0 columns of this check matrix is ($\lambda_j'$,$\rho_k'$), the K0 columns are determined such that the weight distribution of the N×M check matrix resulting from removal of K0 columns from the N1×M check matrix $H_1$ is ($\lambda_j'$,$\rho_k'$), and the positions corresponding to the K0 columns thus determined are regarded as the K0 bit insertion positions for dummy bits.
The optimum weight distribution ($\lambda_j'$,$\rho_k'$) of the N×M check matrix H' can be determined by applying a Density Evolution method, based on the Belief Propagation method, which is an LDPC code decoding method, to the likelihood distribution. The belief propagation method and density evolution method are widely known, and details are given in T.J. Richardson, M.A. Shokrollahi, and R.L. Urbank, "Design of Capacity-Approaching Irregular Low-Density Parity-Check Codes".
Fig. 14 shows the flow of dummy bit addition position determination processing in the third embodiment, which is performed by the dummy bit position acquisition portion 11a-3 of Fig. 12.
First, the optimum weight distribution ($\lambda_j'$,$\rho_k'$) of the N×M check matrix H' is determined using the density evolution method (step 501). Then, K0 columns are removed from the N1×M check matrix $H_1$, the weight distribution ($\lambda_j$,$\rho_k$) of which is known (step 502), and the weight distribution $\lambda_j''$, $\rho_k''$ of the N×M matrix remaining after the K0 columns are removed is calculated (step 503).
Then, a check is performed as to whether $\lambda_j'' = \lambda_j'$ and $\rho_k'' = \rho_k'$ (step 504), and if these equations do not obtain, processing returns to step 502, the K0 columns to be removed are changed, and the subsequent processing is repeated. If on the other hand $\lambda_j'' = \lambda_j'$ and $\rho_k'' = \rho_k'$, then the positions from which the K0 columns were removed at this time are taken to be the bit addition positions for dummy bits (step 505).
In step 504, a tolerance error $\Delta\varepsilon$ is determined in advance, so that when $|\lambda_j''-\lambda j'| < \Delta\varepsilon$ and $|\rho_k''-\rho_k'| < \Delta\varepsilon$ obtain, then the positions of removal of the K0 columns at this time can be taken to be the bit addition positions for dummy bits.
By means of the third embodiment, the optimum dummy bit positions for an LDPC code with given code rate and given weight distribution can be determined.

(D) Fourth Embodiment

Code characteristics change depending on dummy bit addition positions. In a fourth embodiment, in order to select positions for insertion of dummy bits, dummy bit addition positions are decided such that the minimum distance (minimum Hamming distance) is increased, and dummy bits are added at these positions. This is because a large minimum distance improves the error detection and correction capabilities, and improves the code characteristics.
An M×N1 check matrix $H_1$ is represented by column vectors as follows.

$$H_1 = [h_0, h_1, ...., h_{N1-1}] \qquad (24)$$

Here, $h_j = [h_{ij}]^T$; $i = 0,...,M$-1
In linear block codes, the minimum code distance is equal to the minimum Hamming weight for the code. When an arbitrarily d-1 column vectors are linearly independent, but at least a set of d column vectors are linearly dependent, the minimum distance is d.
A code C in which dummy bits are inserted, if different from an all-"0"s dummy bit pattern, is no longer a linear code, but with respect to the minimum distance is equivalent to a code with an all-"0"s pattern inserted. Because a code with an all-"0"s pattern inserted can be regarded as a linear code, the minimum distance is equivalent to the minimum Hamming weight of the code, and therefore the minimum distance is equivalent to the minimum Hamming weight for a code with dummy bits inserted as well.
Fig. 15 shows the flow of processing to decide dummy bit addition positions in the fourth embodiment, performed by the dummy bit position acquisition portion 11a-3 of Fig. 12.
Suppose that the minimum distance (Hamming weight) of the original mother code C1 is d0. In the N1×M check matrix $H_1$, d0-1 column vectors are linearly independent, and so the set of indexes $(i_0,...,i_{k0-1})$ of column vectors including d0-1 arbitrary column vectors and column vector(s) which is linearly dependent on the d0-1 arbitrary column vectors, is determined (step 601).
A check is then performed to determine whether K0 < k0 (step 602), and if K0 < k0, K0 indices are selected from among the k0 vectors, the selected column vector positions are taken to be dummy bit positions (step 603), and processing ends. At this time, the minimum distance of the code C with dummy bits inserted is the same as that of the original code C1.
In step 602, if K0 ≥ k0, then k0 vectors are selected and processing proceeds to the next step. Because at least an arbitrary d0 vectors are linearly independent, the remaining N1-k0 column vectors have a minimum distance d1 which is equal to d0+1 or greater. Among the N1-k0 vectors resulting from exclusion of the above k0 vectors, any arbitrary d1-1 vectors are linearly independent; a set $(i_{k0},..., i_{k1-1})$ of d1 dependent vectors is determined (step 604). Here, k1=k0+d1.
Next, a check as to whether k1 < K0 is performed (step 605), and if k1 ≥ K0 then step 603 is executed, K0 vectors are selected from among the k1 vectors, the selected column vector positions are taken to be dummy bit positions (step 603), and processing ends.
On the other hand, if in step 605 k1 < K0, then k0 is replaced with k1 (k0 = k1, step 606), and thereafter, the processing of 604 and subsequent processing is repeated until selection of K0 dummy bit positions is completed.
By means of the fourth embodiment, code characteristics can be improved.

(E) Fifth Embodiment

A wireless mobile communication system such as a CDMA mobile communication system, in which a plurality of mobile terminals can simultaneously access the same wireless resources, is considered. In such a wireless mobile communication system, status information is transmitted from a base station to each of the mobile terminals over a common channel. The mobile terminals receive the status information transmitted via the common channel, execute demodulation processing, and convert input reception code bits into likelihood data which is input to a decoder.
In each mobile terminal, individual dummy bits are provided in advance as an ID. The base station notifies each mobile terminal of prescribed status information over the common channel. At this time, as shown in Fig. 16, the encoding method of the first embodiment is applied when encoding the status information to be sent to each mobile terminal, and the destination mobile terminal ID is used as the dummy bits. Each mobile terminal generates likelihood data from the reception data for all frames of the common channel, adds the dummy bits which are the station's own ID, and performs decoding processing. Decoding fails for mobile stations other than the destination mobile station, and decoding succeeds only for the destination mobile station, so that the confidentiality of status information can be maintained. In Fig. 16, the information addressed to mobile terminal A is successfully received only by mobile terminal A, and the information addressed to mobile terminal B is successfully received only by mobile terminal B.
By means of the fifth embodiment, prescribed information can be transmitted to only the intended mobile terminal.

(F) Sixth Embodiment

The encoder 11b in the transmitter 10 of the first embodiment (see Fig. 2) employs

$$\mathbf{x}_1 = (u,a)G1$$

to output N1 (=K+K0+M) information bits $x_1$. The generator matrix G1 is the matrix shown in (B) of Fig. 3, and so the above equation becomes

$$\mathbf{x}_1 = (u,a)\begin{pmatrix} & P \\ I_{k1} & \\ & Q \end{pmatrix} = (u,a,uP,aQ) = (u,a,uP,b) \qquad (25)$$

Here,

$$p = uP+b \qquad (26)$$

is the parity bit vector, and b = aQ is the portion corresponding to the dummy bits, and is a fixed value. Hence b = aQ is calculated in advanced and stored in a table, and is utilized when performing the computation of equation (26).
Fig. 17 shows the configuration of the encoder 11b of the sixth embodiment; portions which are the same as for the encoder of Fig. 2 are assigned the same symbols. The dummy bit parity table 11b-3 stores the results of calculations in advance of b (=aQ) in equation (26). The parity generator 11b-1 computes uP, the first term on the right in equation (26), and the adder 11b-4 performs the addition of equation (26) and outputs the parity bits p. The combination portion 11b-2 inserts parity bits p into the information bits (u,a) and outputs the information bits $x_1$.

(G) Seventh Aspect

In the receiver of the first embodiment, the demodulation portion 21 inputs likelihood data, generated from the reception data, as-is to the decoder 22. As decoding processing, the Sum-Product algorithm is applied wherein the two likelihood computations of equations (17) and (19) are repeatedly performed on all code bits which include dummy bits. Equations (17) through (19) are again reproduced below as equations (27) through (29).

$$L(r_{ji}) = \prod_{i' \in V_j \backslash i} \alpha_{i'j} \cdot \phi\left( \sum_{i' \in V_j \backslash i} \phi(\beta_{i'j}) \right) \qquad (27)$$

Here,

$$\phi(x) = -\log[\tanh(x/2)] = \log\left(\frac{e^x+1}{e^x-1}\right) \qquad (28)$$

$$L(q_{ij}) = L(c_i) + \sum_{j' \in C_i \setminus j} L(r_{j'i}) \quad (29)$$

If the above equations are computed without modification, the computational quantity is substantial. Hence in the seventh embodiment, computation results relating to the dummy bits are determined in advance, as shown in Fig. 18, and are stored in a memory (in a dummy bit table) 23, and upon decoding the decoding portion 22 utilizes the stored computation results.

In the $L(r_{ji})$ of equation (17), if all the variable nodes of the set $V_j|i$ of variable nodes connected to the check node $f_j$ correspond to dummy bit positions, then $L(r_{ji})$ can be computed using the dummy bits, and so are calculated in advance and stored in memory 23. On the other hand, if in equation (17) a variable node $c_i$' is a dummy bit position, then from equation (16) $L(q_{ij}) = L(c_i) = \pm\infty$, and $\phi(\beta_{ij}') = 0$, so that this $\phi(\beta_{ij}') = 0$ is similarly stored in memory 23. And, in the $L(q_{ij})$ of equation (19), if a variable node $c_i$ is a dummy bit position, then from equation (16) $L(q_{ij}) = L(c_i) = \pm\infty$, so that this $L(q_{ij}) = L(c_i)$ is stored in memory 23.

Fig. 19 and Fig. 20 show the processing flow for the Sum-Product algorithm (SPA) using logarithmic likelihood ratios in the seventh embodiment.

The necessary values ($L(r_{ji})$, $L(q_{ij})$, $\phi(\beta_{ij}') = 0$, and similar) are calculated in advance and stored in memory 23, and in addition the number of repetitions I is set to 1 (step 701).

Then, for i = 0, 1,..., n-1 (where n = N1), the decoding portion 22 initializes $L(q_{ij})$ over all i, j for which $h_{ij} = 1$ according to equation (16) (step 702).

When initialization ends, the decoding portion 22 updates $L(r_{ji})$ based on equation (17) (step 703). That is, first i, j for which $h_{ij} = 1$ are selected (step 703a), and a judgment is made as to whether all the variable nodes of the set $V_j|i$ of variable nodes correspond to dummy bit positions (step 703b); if the result is "YES", the calculated values $L(r_{ji})$ stored in memory 23 are used (step 703c). However, if the result is "NO", $L(r_{ji})$ are calculated (step 703d). In this case, if a variable node $c_i$' is a dummy bit position, $\phi(\beta_{ij}') = 0$ is used. Then, the decoding portion 22 checks whether the above processing has ended for all combinations of i and j for which $h_{ij} = 1$ (step 703e), and if not ended, the combination of i and j is changed (step 703f), and the processing of step 703b and subsequent processing is repeated.

When calculation of all $L(r_{ji})$ is completed as described above, equation (19) is used to update $L(q_{ij})$ (step 704). That is, first i, j for which $h_{ij} = 1$ are selected (step 704a), and a judgment is made as to whether the variable node $c_i$ corresponds to a dummy bit position (step 704b); if "YES", the calculated value $L(q_{ij})$ stored in memory 23 is used (step 704c). If the result is "NO", however, $L(q_{ij})$ is calculated (step 704d).

Then, the decoding portion 22 checks whether the above processing has been completed for all combinations of i, j for which $h_{ij} = 1$ (step 704e), and if not completed, the combination of i and j is changed (step 704f) and the processing of step 704b and subsequent processing is repeated.

When calculation of all $L(q_{ij})$ by the above processing has been completed, equation (20) is used to determine $L(Q_i)$ (step 705). Then, for i = 0, 1, ..., n-1, if $L(Q_i) < 0$, then $\hat{c}_i$ is set equal to 1, but if $L(Q_i) > 0$ , then $\hat{c}_i$ is judged to be 0 (step 706). Finally, a check is performed to determine whether the equation

$$\hat{c}H^T = 0$$

obtains (step 707), and if the equation obtains, decoding processing ends. However, if the above equation does not obtain, a check is performed to determine whether the maximum number of repetitions has been reached ($I = I_{MAX}$) (step 708), and if the maximum number of repetitions has been reached, decoding processing ends; otherwise, I is incremented (step 709), and processing returns to step 703 and subsequent processing is performed.

By means of the sixth and seventh embodiments, the computation quantity can be reduced, and high-speed processing becomes possible.

(H) Eighth Embodiment

In the above embodiments, LDPC codes were used; however, turbo codes can also be used. When using a turbo code as the code, the wireless communication system can likewise have the same configuration as in Fig. 2.

Fig. 21 explains an encoding/decoding method using a turbo code; an example is shown in which the number of bits of the dummy bits 200 is made equal to the number of bits K of the information bits 100, and data is transmitted at a code rate of 1/5.
Referring to Fig. 2 and Fig. 21, when performing encoding, the dummy bit addition portion 11a in the encoding portion 11 of the transmitter 10 adds the dummy bits 200 to the information bits 100. Then, the turbocoder 11b encodes the information bits with dummy bits added, to generate turbo code 400 with a code rate of 1/3. That is, turbo code 400 is generated in which parity bits 300, created using the information bits with dummy bits added, are added to the information bits. Then, the dummy bit deletion portion 11c deletes the dummy bits 200 from the turbo code 400 to generate systematic code 500, and the systematic code is transmitted over the propagation path 30 to the receiver 20. The decoding portion 21 of the receiver receives the systematic code 500 and performs demodulation, and the decoding portion 22 adds to the demodulated systematic code the dummy bits 200 deleted on the transmitting side with maximum likelihood, and then performs turbo decoding and outputs the information bits 100. The method for adding dummy bits with maximum likelihood (infinite reliability) entails determining the absolute value of the reception signal likelihood (reliability), computing the average value thereof, multiplying the average value by a large coefficient, such as for example 10, and taking the positive and negative values obtained to be dummy bit "0"s and "1"s respectively.

Fig. 22 shows the configuration of the encoder 11b, which is a turbo encoder, in the mobile communication system of Fig. 2. The turbo encoder takes as input information bits u with dummy bits added, of information length K1 (=2K), input from a dummy bit addition portion 11a, not shown (see Fig. 2), performs encoding, and outputs as series data the encoded data xa, xb, xc.
The encoded data xa is the information bits u themselves (systematic bits); the encoded data xb is data resulting from convolution encoding by the element encoder 51a of the information bits u (first parity bits); and the encoded data xc is data resulting from convolution encoding by the element encoder 51c of information bits u after interleaving ($\pi$) by the interleaving portion 51b (second parity bits). The P/S conversion portion 51d converts the turbo codes xa, xb, xc into serial data, which is input to a dummy bit deletion portion 11c, not shown (see Fig. 2).
In the element encoders 51a and 51c of Fig. 22, EOR is an exclusive OR circuit, and D is a flip-flop forming a shift register. Also, in Fig. 22, tail bit switches 51d, 51e are provided to provide trellis termination (see 3GPP TS 25.212 V5.9.0 (2004-06)). In the turbo code, if the contents of the shift registers of the element encoders 51a, 51c at the time of trellis termination are always all-"0"s, then during turbo decoding the a posteriori probability can be correctly computed, and as a result precise decoding processing can be performed. For this reason, after the end of input of information bits u, the tail bit switch 51d is switched to the dashed-line position, so that the first EOR output of the element encoder 51a is always "0". By this means, the contents of the shift registers become all-"0"s after three clock cycles. Then, the input and output of the element encoder 51a for three clock cycles are added to the systematic bits xa and first parity bits xb as tail bits, and the result is output. Then, the tail bit switch 51e is switched to the dashed-line position, so that the first EOR output of the element encoder 51c is always "0". By this means, the contents of the shift registers become all-"0"s after three clock cycles. Then, the input for three clock cycles of the element encoder 51c is output as tail bits xd, and the output of the element encoder 51c is added to the second parity bits xc as tail bits and output.

Fig. 23 shows the configuration of decoding portions 22 in the mobile communication system of Fig. 2; as the decoder, a turbo decoder is used.
The pre-decoding processing portion 22a is equivalent to the dummy bit likelihood addition portion 22a of Fig. 2, and the separation portion 61a separates serially input data into encoded data ya', yb, yc, yd, the dummy bit addition portion 61b adds the dummy bits 200 deleted on the transmitting side to the systematic bits ya' with maximum likelihood, and the encoded data thus obtained ya, yb, yc, yd is input to the encoder 22b. In the turbo decoder 22b, the first element decoder 62a uses ya and yb among the reception signals ya, yb, yc, yd to perform decoding. The element decoder 61a is a soft-output element decoder, and outputs likelihoods of decoding results. Next, the second element decoder 62b uses the likelihoods output from the first element decoder 61a as well as yc and yd to similarly perform decoding, and outputs likelihoods as decoding results. Here yc is the reception signal corresponding to the result xc of encoding the interleaved original data u, and so likelihoods output from the first element decoder 62a are interleaved ($\pi$) by the interleaving portion 62c and input to the second element decoder 62b. The deinterleaving portion 62d deinterleaves ($\pi^{-1}$) the likeilihoods output from the second element decoder 62b, and feeds back the results to the first element decoder 62a. Thereafter, the above decoding operation is repeated a prescribed number of times, hard decisions are made for deinterleaved output of the second element decoder 62b, and the decision results are output as the decoding results.
By means of the eighth embodiment, decoding errors can be reduced by adding dummy bits with maximum likelihood to the reception data on the receiving side, without transmitting the dummy bits to the receiving side. Further, by deleting the dummy bits and performing modulation and transmission, power consumption by the transmitter and receiver as well as usage of transmission path capacity can be reduced.

(a) First modified example

Fig. 24 explains the encoding/decoding method of a first modified example of the eighth embodiment, showing an example in which the number of dummy bits 200 is made equal to the number of bits K of information bits 100. Fig.

25 shows the configuration of the wireless communication system of the first modified example; portions which are the same as in the first embodiment of Fig. 2 are assigned the same symbols. In the following modified example, 11a is a pre-encoding processing portion, 11c is a post-encoding processing portion, and 22a is a pre-decoding processing portion.

During encoding, the dummy bit addition portion 71 in the pre-encoding processing portion 11a comprised by the encoding portion 11 of the transmitter 10 adds dummy bits 200 to the information bits 100. Then, the turbo encoder 11b encodes the information bits with dummy bits added, to generate turbo code 400 with a code rate of 1/3. The dummy bit partial deletion portion 72 of the post-encoding processing portion 11c then deletes a portion of the dummy bits from the turbo code 400 and generates systematic code 500, and the transmission portion, comprising the modulation portion 12, transmits the systematic code 500 to the receiver 20 over the propagation path 30.

The demodulation portion 21 of the receiver 20 receives and demodulates the systematic code 500, the reception dummy bit deletion portion 73 of the pre-decoding processing portion 22a of the decoding portion 22 deletes the dummy bits 200' from the demodulated systematic code, and the dummy bit addition portion 74 adds dummy bits 200 which are same as the dummy bits added on the transmitting side, to the systematic code at maximum likelihood; then turbo decoding is performed by the turbo decoder 22b, and the information bits 100 are output.

By means of the first modified example, an excess portion of the dummy bits can be deleted and data is transmitted according to the data quantity (transmission bit rate) in the physical channel determined by a higher-level device.

(b) Second modified example

Fig. 26 explains the encoding/decoding method of a second modified example of the eighth embodiment, showing an example in which the number of dummy bits 200 is equal to the number of bits K of information bits 100. Fig. 27 explains the advantageous results of the second modified example, and Fig. 28 shows the configuration of the wireless communication system of the second modified example; portions which are the same as in Fig. 2 are assigned the same symbols.

When performing encoding, the dummy bit addition portion 71 in the pre-encoding processing portion 11a comprised by the encoding portion 11 of the transmitter 10 adds dummy bits 200 to the information bits 100. Then, the turbo encoder 11b encodes the information bits with the dummy bits added, and generates turbo code 400 with a code rate of 1/3. Then the dummy bit deletion portion 75 of the post-encoding processing portion 11c deletes the dummy bits from the turbo code 400 to generate systematic code 500, and the repetition processing portion 76 performs repetition processing of the systematic code 500 to add repetition bits 600. Repetition processing is processing in which a specified number of bits are selected from the systematic code 500, and a copy of these is created and added. The transmission portion comprising the modulation portion 12 transmits the systematic code 700 with repetition bits added to the receiver 20 over the propagation path 30.

The demodulation portion 21 of the receiver 20 receives and demodulates the systematic code 700, the repetition decoding portion 77 of the pre-decoding processing portion 22a of the decoding portion 22 uses the repetition bits to perform diversity combining (repetition decoding), and the dummy bit addition portion 78 adds dummy bits which are same as the dummy bits deleted on the transmitting side, to the repetition decoding results at maximum likelihood, after which the turbo decoder 22b performs turbo decoding and outputs the information bits 100.

By adding dummy bits to the information bits and performing turbo encoding, turbo code with a code rate of $R = 1/3$ is obtained, and by deleting dummy bits from the turbo code and transmitting the code, the code rate R can be made smaller than 1/3, and the larger the number of dummy bits, the lower the code rate can be made. Curve A in Fig. 27 shows the relation between code rate and the Eb/No necessary to obtain a prescribed bit error rate BER. That is, by adding dummy bits to reduce the code rate from 1/3 to 1/5, the Eb/No necessary to obtain a prescribed bit error rate BER can be reduced. In other words, if the Eb/No is fixed, the BER can be made smaller as the code rate is reduced from 1/3 to 1/5. However, if the code rate is made smaller than 1/5, characteristics gradually worsen, and as the code rate is reduced the BER increases. Hence in the second modified example, if the required code rate is larger than 1/5, characteristics are improved through processing to add dummy bits only. However, when the required code rate is smaller than 1/5, repetition processing is used to add repetition bits and obtain the required code rate. This is because even when repetition bits are added in repetition processing, the characteristic is not degraded, as indicated by curve B in Fig. 27.

As described above, in the second modified example, by adding repetition bits, worsening of decoding errors can be prevented.

(c) Third modified example

The third modified example is an example in which the repetition of the second modified example is changed to puncturing; Fig. 29 explains the encoding/decoding method of the third modified example, showing a case in which the number of dummy bits 200 is equal to the number K of information bits 100. Fig. 30 shows the configuration of the wireless communication system of the third modified example; portions which are the same as in Fig. 2 are assigned the same symbols. Puncturing is processing in which a specified number of bits are selected among the code bits, and these bits are deleted; on the receiving side, fixed values (likelihood value 0) are added as bit data at the deletion positions.
At the time of encoding, the dummy bit addition portion 71 in the pre-encoding processing portion 11a comprised by the encoding portion 11 of the transmitter 10 adds dummy bits 200 to the information bits 100. Then, the turbo encoder 11b encodes the information bits with the dummy bits added, and generates turbo code 400 with a code rate of 1/3. The dummy bit deletion portion 81 of the post-encoding processing portion 11c then deletes the dummy bits from the turbo code 400 and generates systematic code 500, and the punctured code portion 82 performs puncturing processing of the systematic code 500 to delete a prescribed number of parity bits at prescribed parity bit positions (puncturing). The transmission portion, comprising the modulation portion 12, then transmits the punctured systematic code 800 to the receiver 20 over the propagation path 30.
The demodulation portion 21 of the receiver 20 receives and demodulates the systematic code 800, and the punctured decoding portion 83 of the pre-decoding processing portion 22a of the decoding portion 22 inserts parity bits, the likelihood of which is 0 (likelihood value 0), at the deleted parity bit positions to restore the parity bits 300 to the original length (punctured decoding). Then, the dummy bit addition portion 84 adds dummy bits which are same as the dummy bits deleted on the transmitting side to the punctured decoding results at maximum likelihood, and the turbo decoder 22b then performs turbo decoding and outputs the information bits 100.
By means of the third modified example, the code rate can be reduced by not transmitting dummy bits, decoding errors can be reduced, and moreover puncturing can be performed so that data is transmitted at a desired code rate.

(d) Fourth modified example

In the second modified example, repetition processing was performed after turbo encoding to decrease decoding errors and to obtain the desired code rate; but similar advantageous results can be expected if repetition processing is performed before turbo decoding. Hence in the fourth modified example, repetition processing is performed before turbo decoding to transmit data.
Fig. 31 explains the encoding/decoding method of the fourth modified example, showing a case in which the total number of dummy bits and repetition bits is equal to the number K of information bits 100. Fig. 32 shows the configuration of the wireless communication system of the fourth modified example; portions which are the same as in Fig. 2 are assigned the same symbols.
When encoding is performed, the repetition processing portion 91 of the pre-encoding processing portion 11a comprised by the encoding portion 11 of the transmitter 10 adds repetition bits 150 to the information bits 100, and the dummy bit addition portion 92 adds dummy bits 200 to the information bits to which repetition bits have been added. Then, the turbo encoder 11b encodes the information bits to which repetition bits and dummy bits have been added, and generates turbo code 400 with a code rate of 1/3. Then the dummy bit deletion portion 93 of the post-encoding processing portion 11c deletes the dummy bits from the turbo code 400 to generate systematic code 500, and the transmission portion, comprising the modulation portion 12, transmits the systematic code 500 to the receiver 20 over the propagation path 30.
The demodulation portion 21 of the receiver 20 receives and demodulates the systematic code 500, the dummy bit addition portion 94 of the pre-decoding processing portion 22a comprised by the decoding portion 22 adds dummy bits 200 which are same as the dummy bits deleted on the transmitting side to the demodulated systematic code at maximum likelihood, and the turbo decoder 22b performs turbo decoding and outputs the information bits 100. Because the information bits 100, repetition bits 150, and dummy bits 200 are obtained by turbo decoding, the dummy bits are deleted after turbo decoding, and then repetition decoding processing is performed to output the information bits 100.

(e) Fifth modified example

The fifth modified example is another data transmission example in which repetition processing is performed before turbo decoding; Fig. 33 explains the encoding/decoding method of the fifth modified example, showing a case in which the sum of the dummy bits and the repetition bits is equal to the number K of information bits 100. Fig. 34 shows the configuration of the wireless communication system of the fifth modified example; portions which are the same as in Fig. 2 are assigned the same symbols.
When encoding is performed, the repetition processing portion 91 of the pre-encoding processing portion 11a comprised by the encoding portion 11 of the transmitter 10 adds repetition bits 150 to the information bits 100, and the dummy bit addition portion 92 adds dummy bits 200 to the information bits to which repetition bits have been added. Then, the turbo encoder 11b encodes the information bits with repetition bits and dummy bits added, and generates turbo code 400 with a code rate of 1/3. Then the dummy bit deletion portion 93, which is the post-encoding processing portion 11c, deletes the dummy bits 200 from the turbo code 400, and the repetition bit deletion portion 95 deletes repetition bits 150 and generates systematic code 500; the transmission portion, comprising the modulation portion 12, transmits the systematic code 500 to the receiver 20 over the propagation path 30.
The demodulation portion 21 of the receiver 20 receives and demodulates the systematic code 500, the 0-value likelihood repetition bit insertion portion 96 of the pre-decoding processing portion 22a of the decoding portion 22 inserts likelihood-0 repetition bits at the positions of the repetition bits 150 deleted on the transmitting side, and the dummy bit addition portion 94 adds, with maximum likelihood, the dummy bits 200 which are same as the dummy bits deleted on the transmitting side to the demodulated systematic code. Then, the turbo decoder 22b performs turbo decoding and outputs the information bits 100. Through turbo decoding, information bits 100, repetition bits 150, and dummy bits 200 are obtained; hence after turbo decoding the dummy bits are deleted, and then repetition decoding processing is performed to output the information bits 100.

(I) Advantageous Results of the Invention

By means of the invention described above, a code with a high code rate is used, and encoding at a low code rate is possible. Further, by means of this invention, merely by implementing a code with one code rate, encoding at a plurality of code rates is possible, so that the circuit scale can be reduced. Further, by utilizing the freedom provided by dummy bits, codes with different code rates can easily be realized.
Further, by means of this invention, dummy bits are deleted and modulation and transmission are performed, so that power consumption of the transmitter and receiver as well as the use of transmission path capacity can be reduced.
Further, by means of this invention, dummy bits are not transmitted to the receiving side, and on the receiving side dummy bits are added to the received data with likelihood as maximum, so that decoding errors can be reduced.

## Claims

**1.** An encoding method, in a system in which a systematic code, comprising information alphabet elements to which parity alphabet elements are added, is transmitted and received, comprising the steps of:

adding K0 dummy alphabet elements in a prescribed pattern to K information alphabet elements, to generate a first code of K1 (= K+K0) information alphabet elements;
adding M parity alphabet elements, created from the first code of K1 information alphabet elements, to this first code of K1 information alphabet elements; and
deleting said K0 dummy alphabet elements in the prescribed pattern to generate systematic code of N (=K+M) alphabet elements.

**2.** The encoding method according to Claim 1, further comprising steps of:

assigning different patterns to mobile terminals as prescribed patterns for said dummy alphabet elements;
encoding the K information alphabet elements using said prescribed pattern for each of the mobile terminals; and transmitting the encoded data to the mobile terminals.

**3.** The encoding method according to Claim 1, further comprising the steps of creating M parity alphabet elements from said first code of K1 information alphabet elements, by:

executing computations in conformity with said dummy alphabet elements in the prescribed pattern necessary for the creation of said M parity alphabet elements in advance and storing the results in a memory; and
upon computing said parity alphabet elements, employing the stored computation results.

**4.** A decoding method for decoding code data encoded by the encoding method of any of Claims 1 to 3, further comprising the steps of:

receiving the systematic code comprising N alphabet elements obtained by said encoding method transmitted from the encoding side;
adding said K0 dummy alphabet elements in the prescribed pattern to the received systematic code; and
executing decode processing of the code of N1 (=K1+M) information alphabet elements, which is obtained by adding the dummy alphabet elements;
executing computation in conformity with said dummy alphabet elements in the prescribed pattern necessary for decoding in advance and storing the results in memory; and

upon decoding, employing the stored computation.

5. An encoding device, in a system in which a systematic code, comprising information alphabet elements to which parity alphabet elements are added, is transmitted and received, comprising:

a prescribed pattern addition portion, which adds K0 dummy alphabet elements in a prescribed pattern to K information alphabet elements to generate a first code of K1 (=K+K0) information alphabet elements;
an encoding portion, which adds M parity alphabet elements, created from the first code of K1 information alphabet elements, to this first code of K1 information alphabet elements to generate a second code of N1 (=K+M) information alphabet elements; and
a systematic code generation portion, which deletes said K0 dummy alphabet elements in the prescribed pattern, included in the second code of N1 information alphabet elements, to generate a systematic code of N(=K+M) alphabet elements.

6. The encoding device according to Claim 5, wherein said encoding portion comprises a parity generator for creating the M parity alphabet elements from said first code of K1 information alphabet elements, and a combination portion for adding the M parity alphabet elements to said first code of K1 information alphabet elements to generate the second code of N1 (=M+K1) information alphabet elements.

7. The encoding device according to Claim 5 or Claim 6, wherein said encoding portion comprises a computing portion for executing computations in conformity with said dummy alphabet elements necessary for the creation of said M parity alphabet elements in advance and a memory for storing the results, and upon computing said parity alphabet elements, the encoding portion employs the computation results stored in the memory.

8. A receiver for receiving code data encoded by the encoding device of Claim 5, comprising:

a reception portion, which receives the systematic code of N alphabet elements from an encoding side;
a dummy alphabet element addition portion, which adds said K0 dummy alphabet elements in the prescribed pattern to the received systematic code; and
a decoder, which performs decoding processing of the code of N1 information alphabet elements which is obtained by adding the dummy alphabet elements,
wherein said decoder comprises a computation portion for executing in advance computation in conformity with said the dummy alphabet elements necessary for decode processing and a memory for storing the computation results, and the decoder employs the stored computation results upon decoding.

9. An encoding device, in a system in which systematic code, comprising information bits to which parity bits are added, is transmitted and received, comprising:

a dummy bit addition portion for adding dummy bits to information bits;
a turbo encoding portion for performing turbo encoding by adding parity bits created from the information bits to these information bits;
a dummy bit deletion portion for deleting said dummy bits from the turbo code; and
a transmission portion for transmitting the systematic code from which the dummy bits have been deleted,
wherein a receiving side receives the systematic code and adds the dummy bits which are the same as the dummy bits deleted on a transmitting side at maximum likelihood to the received systematic code, then performs turbo decoding.

10. The encoding device according to Claim 9, wherein said dummy bit deletion portion generates a systematic code by deleting a portion of said dummy bits from said turbo code, a transmission portion transmits the systematic code, and the receiving side deletes the rest of the dummy bits from the received systematic code and adds the dummy bits which are the same as the dummy bits added on the transmitting side to the systematic code at maximum likelihood, then performs turbo decoding.

11. The encoding device according to Claim 9, further comprising a repetition processing portion for adding repetition bits by performing repetition processing of systematic code output by said dummy bit deletion portion, wherein said transmission portion transmits the systematic code with repetition bits added, and on the receiving side, after repetition decoding processing, the dummy bits deleted on the transmitting side are added to the results of the repetition decoding processing at maximum likelihood, and turbo decoding is performed.

**12.** The encoding device according to Claim 9, further comprising a puncturing processing portion for performing puncturing processing of the systematic code output by said dummy bit deletion portion, wherein said transmission portion transmits the systematic code subjected to the puncturing processing, and on the receiving side, after puncturing decoding processing, the dummy bits deleted on the transmitting side are added to the results of the puncturing decoding processing at maximum likelihood, and turbo decoding is performed.

**13.** The encoding device according to claim 9, further comprising a repetition processing portion for adding repetition bits to the information bits, wherein said dummy bit addition portion adds dummy bits to the information bits to which the repetition bits have been added, the turbo encoding portion performs turbo encoding of the information bits to which the repetition bits and dummy bits have been added, said dummy bit deletion portion deletes said dummy bits from the turbo code to generate systematic code, said transmission portion transmits the systematic code, and said dummy bits deleted on the transmitting side are added with maximum likelihood to the systematic code received on the receiving side and turbo decoding is performed.

**14.** The encoding device according to claim 9, further comprising a repetition processing portion for adding repetition bits to the information bits, wherein said dummy bit addition portion adds the dummy bits to the information bits to which the repetition bits have been added, the turbo encoding portion performs turbo encoding of the information bits to which the repetition bits and dummy bits have been added, said dummy bit deletion portion deletes said repetition bits and dummy bits from the turbo code to generate systematic code, said transmission portion transmits the systematic code, and said repetition bits deleted on the transmitting side are added with likelihood 0, and said dummy bits deleted on the transmitting side are added with maximum likelihood, to the systematic code received on the receiving side, and turbo decoding is performed.

**15.** An encoding method, in a system in which systematic code, comprising information bits to which parity bits are added, is transmitted and received, comprising:

a first step of adding dummy bits to information bits;
a second step of performing turbo encoding by creating parity bits from the information bits to which said dummy bits have been added, and adding the parity bits to these information bits;
a third step of deleting said dummy bits from the turbo code and generating systematic code; and
a fourth step of transmitting the systematic code;
wherein the systematic code is received on a receiving side, and the dummy bits deleted on a transmitting side are added with maximum likelihood to the received systematic code, and turbo decoding is performed.

**16.** A transmission device, which transmits systematic code in which parity bits are added to information bits, comprising:

a dummy bit addition portion for adding dummy bits to information bits;
a turbo encoding portion for performing turbo encoding by creating parity bits from the information bits to which said dummy bits have been added and adding the parity bits to these information bits;
a dummy bit deletion portion for deleting said dummy bits from the turbo code; and
a transmission portion for transmitting the systematic code from which the dummy bits have been deleted.

**17.** A method for transmitting systematic code in which parity bits are added to information bits, comprising:

a first step of adding dummy bits to information bits;
a second step of performing turbo encoding by creating parity bits from the information bits, to which said dummy bits have been added, and adding the parity bits to these information bits;
a third step of deleting said dummy bits from the turbo code and generating systematic code; and
a fourth step of transmitting the systematic code.

FIG. 1

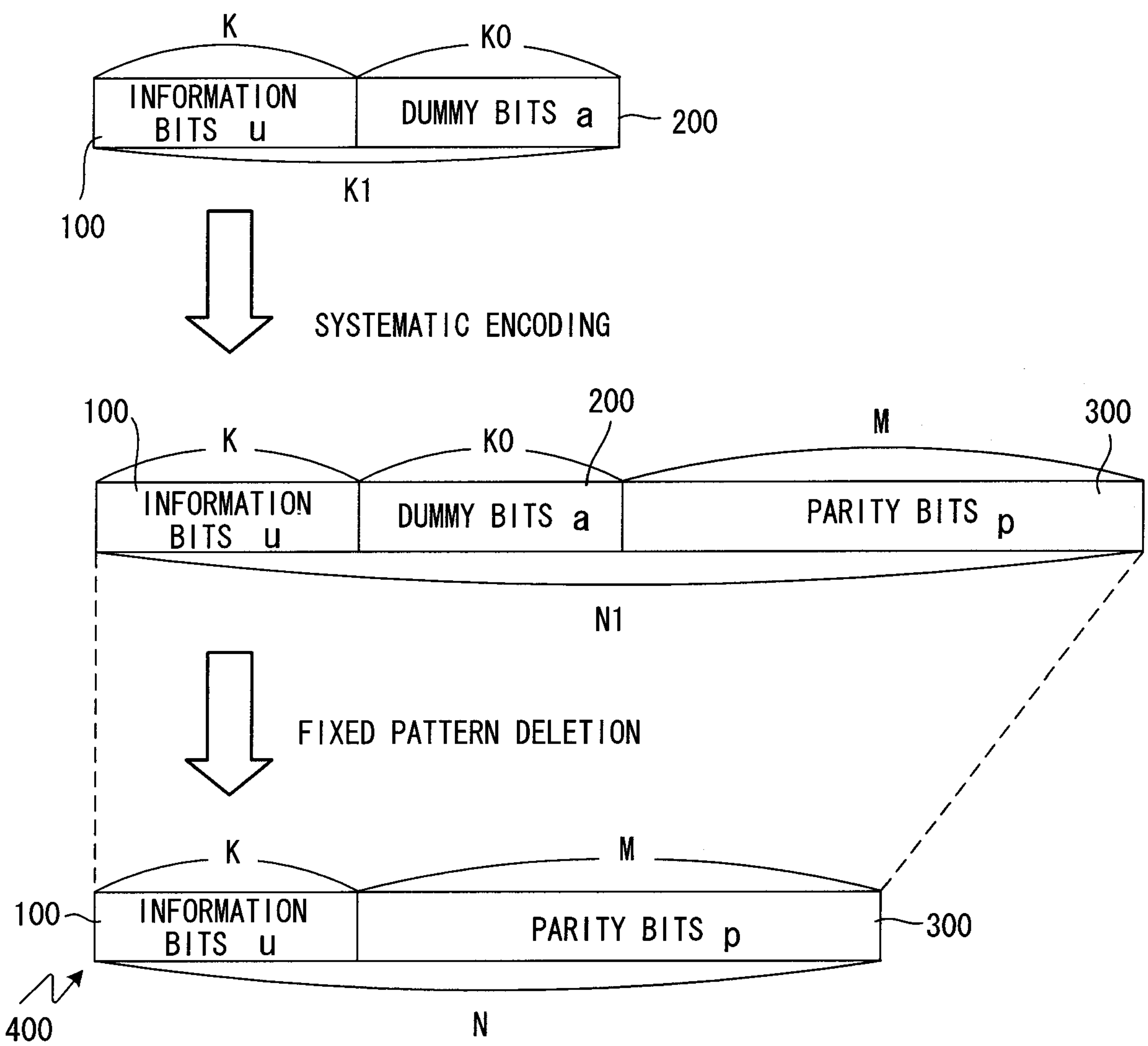
K
K0
INFORMATION BITS u
DUMMY BITS a
200
K1
100
SYSTEMATIC ENCODING
100
K
K0
200
M
300
INFORMATION BITS u
DUMMY BITS a
PARITY BITS p
N1
FIXED PATTERN DELETION
K
M
100
INFORMATION BITS u
PARITY BITS p
300
400
N

# FIG. 2

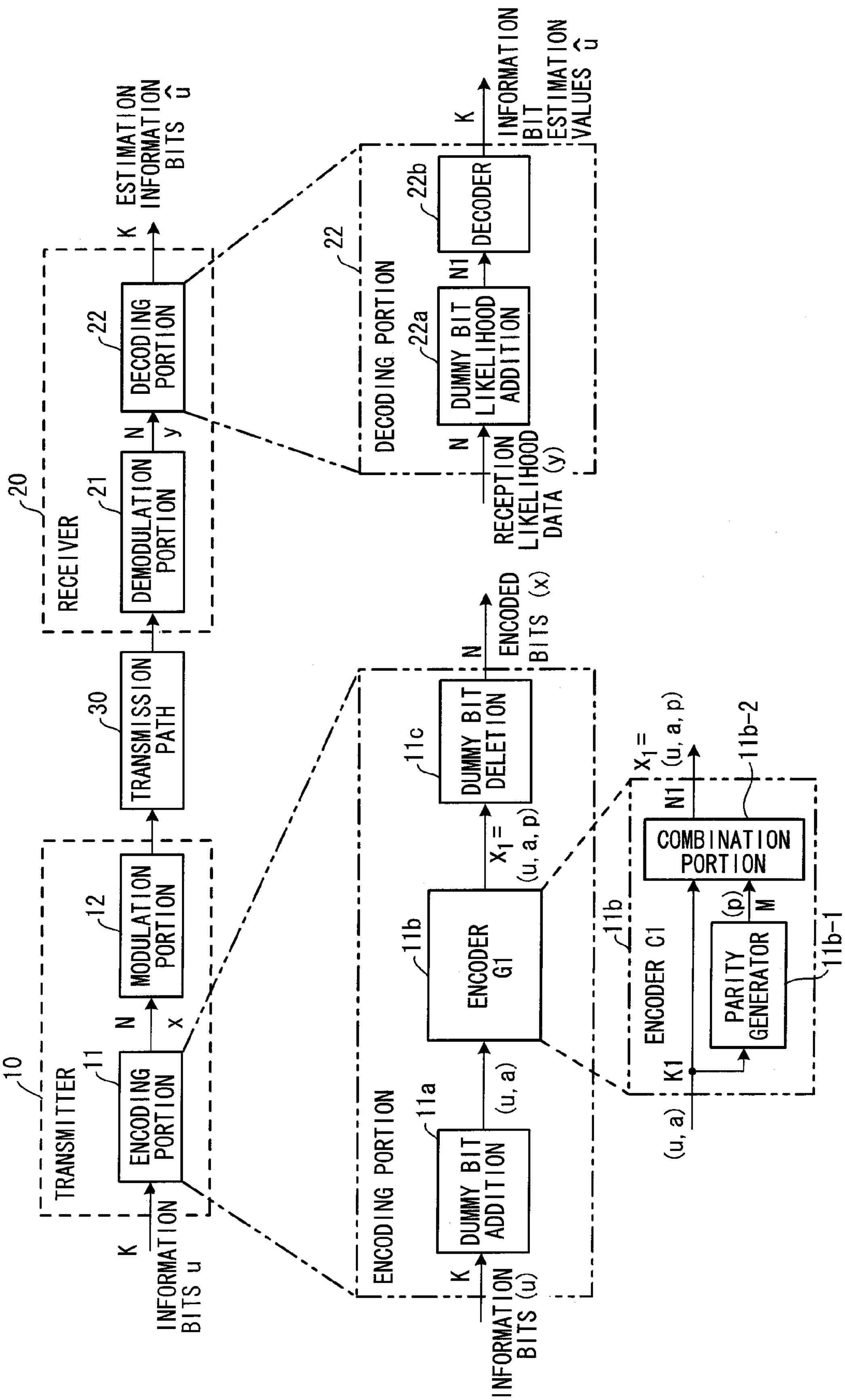

10
TRANSMITTER
11
ENCODING PORTION
12
MODULATION PORTION
INFORMATION BITS u
K
N
x
30
TRANSMISSION PATH
20
RECEIVER
21
DEMODULATION PORTION
22
DECODING PORTION
N
y
K
ESTIMATION INFORMATION BITS û
ENCODING PORTION
11a
DUMMY BIT ADDITION
INFORMATION BITS (u)
K
(u, a)
11b
ENCODER G1
x1= (u, a, p)
11c
DUMMY BIT DELETION
N
ENCODED BITS (x)
11b
ENCODER C1
(u, a)
K1
11b-1
PARITY GENERATOR
(p)
M
11b-2
COMBINATION PORTION
N1
x1= (u, a, p)
DECODING PORTION
22a
DUMMY BIT LIKELIHOOD ADDITION
RECEPTION LIKELIHOOD DATA (y)
N
N1
22b
DECODER
K
INFORMATION BIT ESTIMATION VALUES û

# FIG. 3

(A)

$$G=[I_kP]=\overbrace{\left[\begin{array}{cccc|ccc}1&0&\cdots&0&P_{1,1}&\cdots&P_{1,N-K}\\0&1&&0&P_{2,1}&\cdots&P_{2,N-K}\\\vdots&&\ddots&\vdots&\vdots&&\vdots\\\vdots&&1&0&\vdots&&\vdots\\0&&0&1&P_{K,1}&\cdots&P_{K,N-K}\end{array}\right]}^{N:\ K\ |\ N-K(=M)}\left.\vphantom{\begin{array}{c}1\\1\\1\\1\\1\end{array}}\right\}K$$

(B)

$$G_1=\begin{pmatrix}I_{K1}&\begin{matrix}P\\Q\end{matrix}\end{pmatrix}=\underbrace{\left(\begin{array}{ccccc|ccc}1&\cdots&\cdots&\cdots&0&P_{1,1}&\cdots&P_{1,N-K}\\\vdots&\ddots&&&\vdots&P_{2,1}&\cdots&P_{2,N-K}\\\vdots&&&&\vdots&\vdots&&\vdots\\\vdots&&1&\cdots&0&P_{K,1}&\cdots&P_{K,N-K}\\\vdots&&\vdots&1\ \cdots&0&Q_{1,1}&\cdots&Q_{1,N-K}\\\vdots&&\vdots&\vdots\ \ddots&\vdots&\vdots&&\vdots\\0&\cdots&0&0\ \cdots&1&Q_{K0,1}&&Q_{K0,N-K}\end{array}\right)}_{N1:\ K\ |\ K0\ |\ N-K(=M)}\begin{array}{l}\left.\vphantom{\begin{array}{c}1\\1\\1\\1\end{array}}\right\}K\\\left.\vphantom{\begin{array}{c}1\\1\\1\end{array}}\right\}K0\end{array}\Bigg\}K1$$

(C)

$$H_1=\left[\begin{array}{ccc|ccc|ccc}\multicolumn{3}{c|}{K}&\multicolumn{3}{c|}{K0}&\multicolumn{3}{c}{N-K}\\P_{1,1}&P_{2,1}\cdots&P_{K,1}&Q_{1,1}&\cdots&Q_{K0,1}&1&\cdots&0\\\vdots&&\vdots&\vdots&&\vdots&\vdots&\ddots&\vdots\\P_{1,N-K}&P_{2,N-K}&P_{K,N-K}&Q_{1,N-K}&&Q_{K0,N-K}&0&\cdots&1\end{array}\right]N-K(=M)$$

$$=\ (P^T,\ Q^T,\ I_M)$$

# FIG. 4

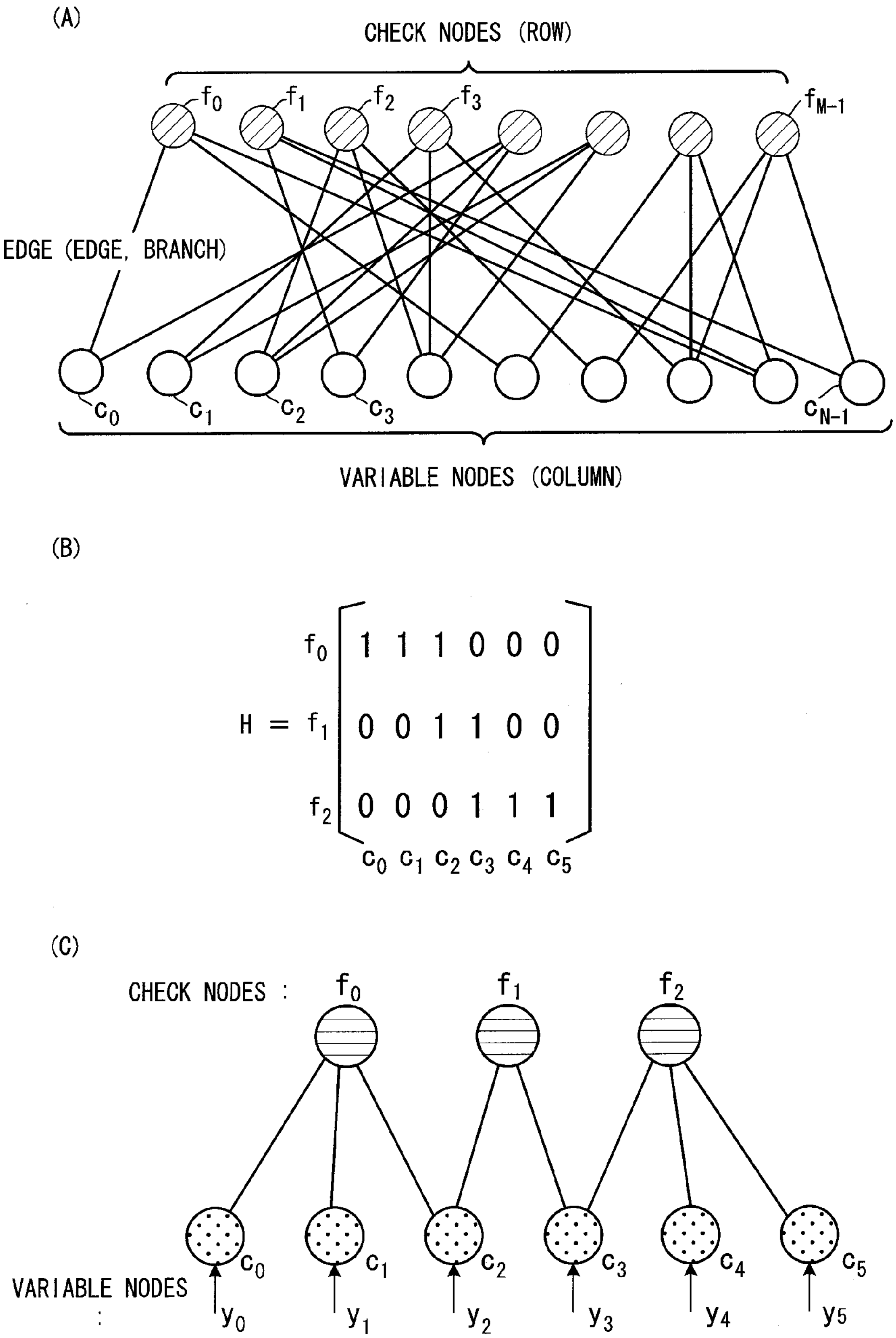
(A)
CHECK NODES (ROW)
$f_0$ $f_1$ $f_2$ $f_3$ $f_{M-1}$
EDGE (EDGE, BRANCH)
$c_0$ $c_1$ $c_2$ $c_3$ $c_{N-1}$
VARIABLE NODES (COLUMN)
(B)
$$H = \begin{array}{c} f_0 \\ f_1 \\ f_2 \end{array} \begin{bmatrix} 1 & 1 & 1 & 0 & 0 & 0 \\ 0 & 0 & 1 & 1 & 0 & 0 \\ 0 & 0 & 0 & 1 & 1 & 1 \end{bmatrix}$$
$c_0$ $c_1$ $c_2$ $c_3$ $c_4$ $c_5$
(C)
CHECK NODES : $f_0$ $f_1$ $f_2$
VARIABLE NODES : $c_0$ $c_1$ $c_2$ $c_3$ $c_4$ $c_5$
$y_0$ $y_1$ $y_2$ $y_3$ $y_4$ $y_5$

FIG. 5

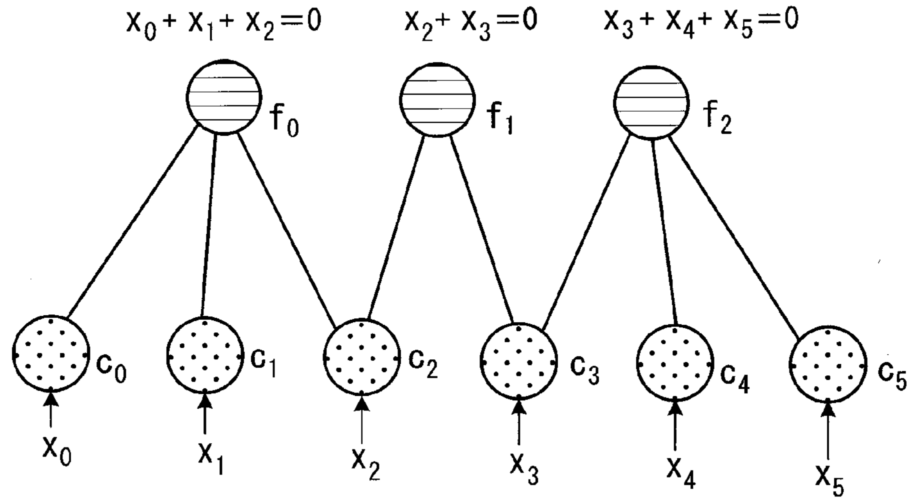


FIG. 6

(A)

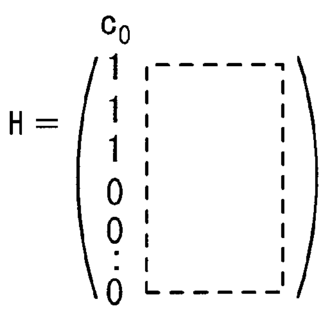


(B)

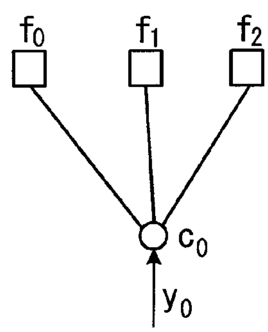


(C)

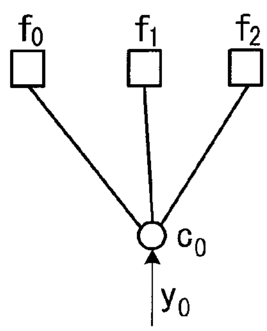

# FIG. 7

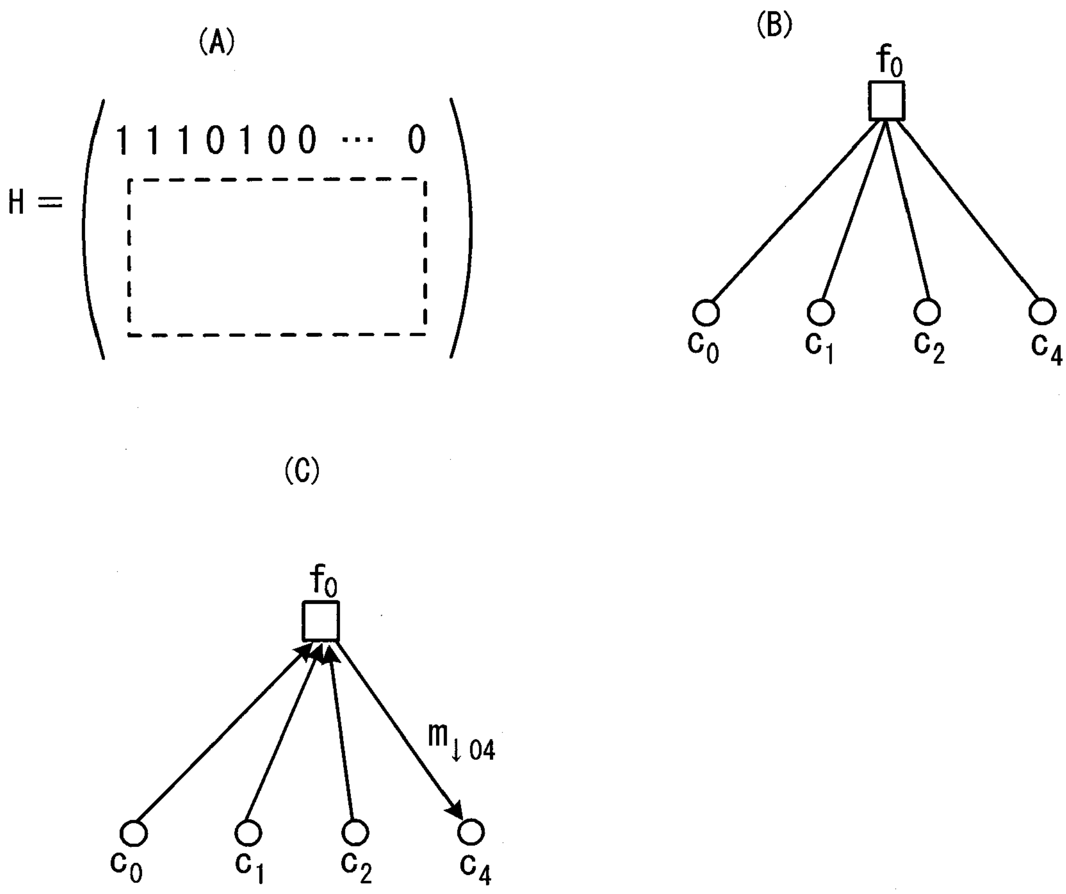

# FIG. 8

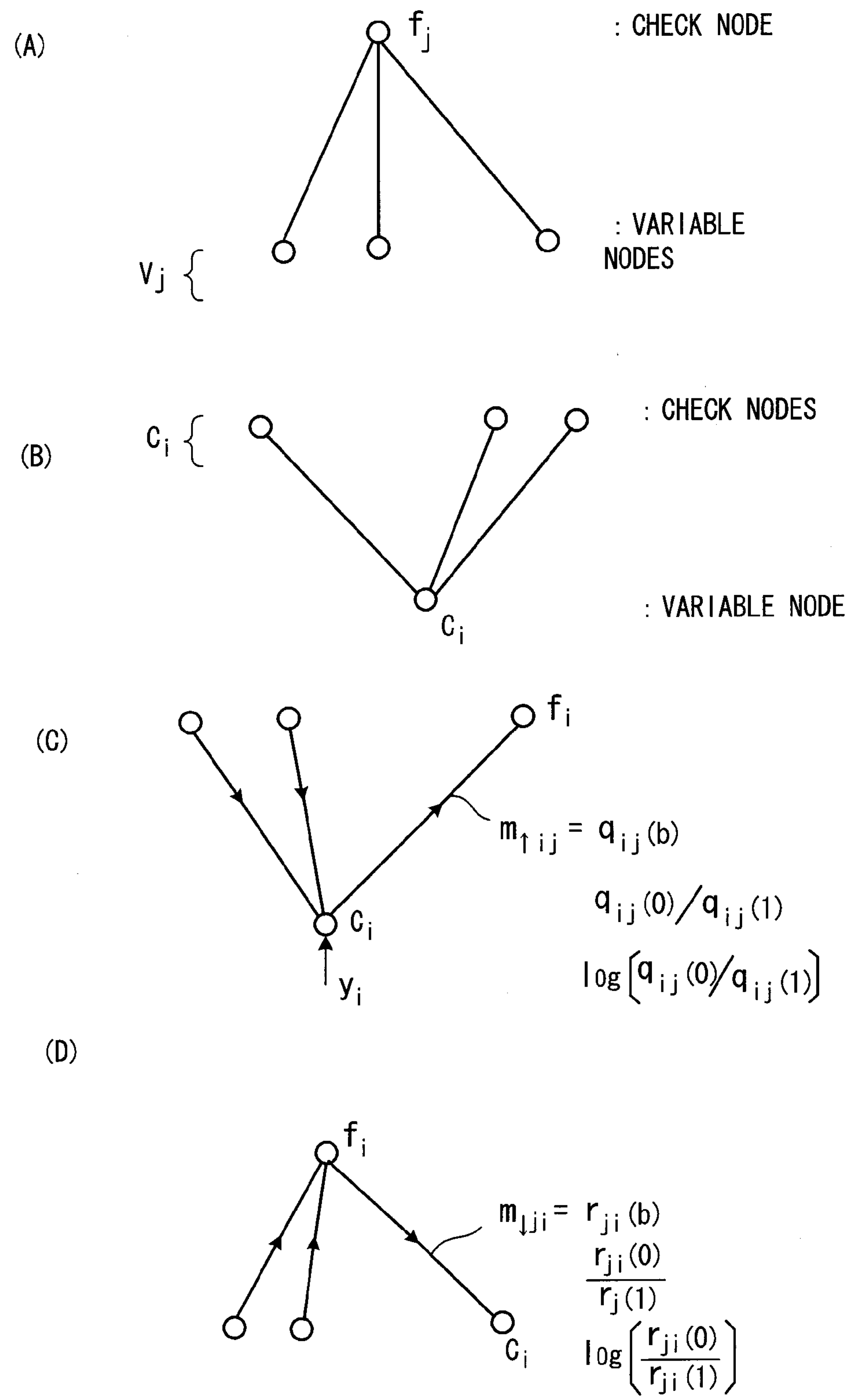
(A)
f_j
: CHECK NODE
: VARIABLE NODES
V_j
(B)
C_i
: CHECK NODES
: VARIABLE NODE
c_i
(C)
f_i
m↑ij = q_ij(b)
q_ij(0)/q_ij(1)
log[q_ij(0)/q_ij(1)]
c_i
y_i
(D)
f_i
m↓ji = r_ji(b)
r_ji(0)/r_j(1)
log(r_ji(0)/r_ji(1))
c_i

FIG. 9

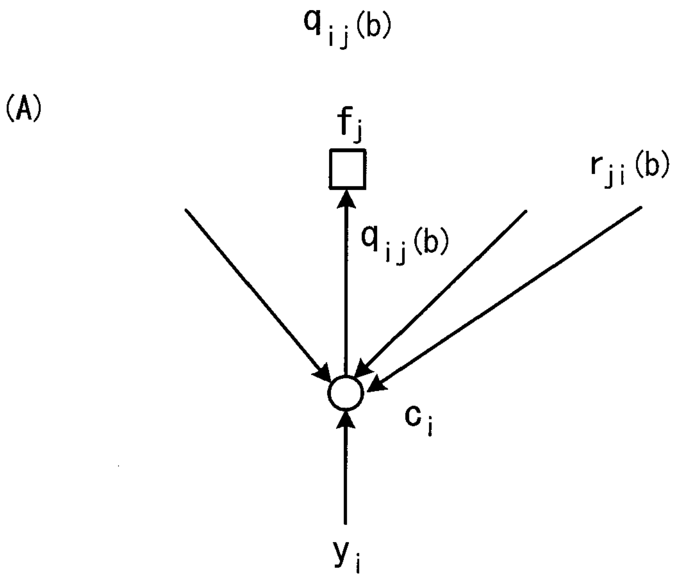


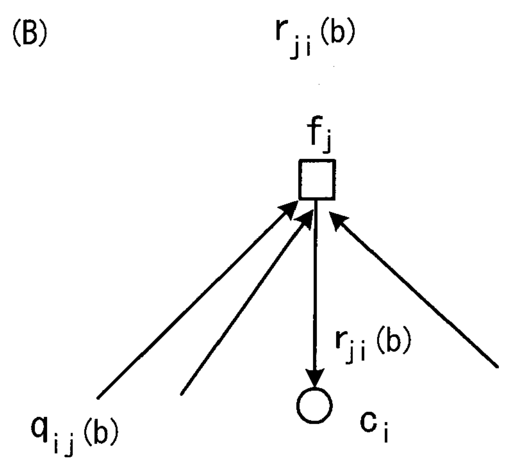

FIG. 10

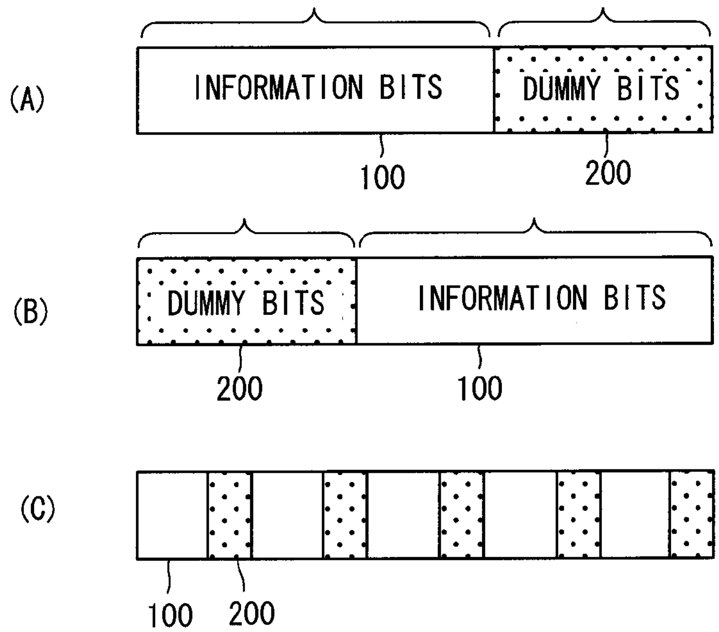
(A)
INFORMATION BITS
DUMMY BITS
100
200
(B)
DUMMY BITS
INFORMATION BITS
200
100
(C)
100
200

FIG. 11

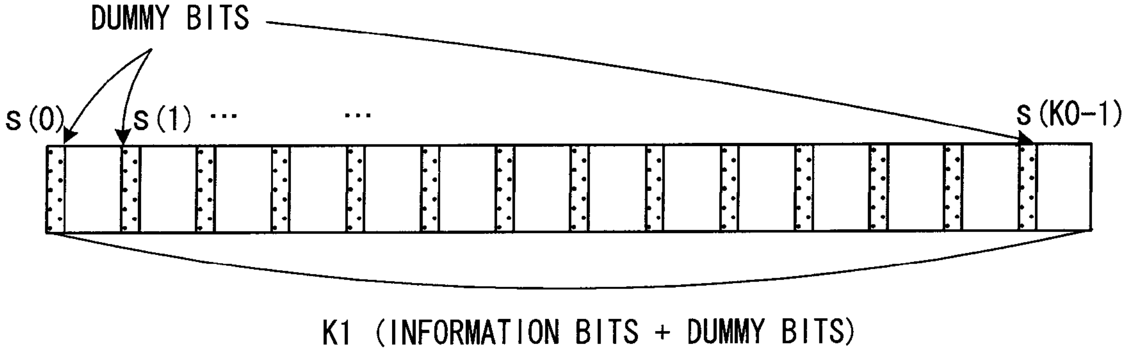
DUMMY BITS
s(0)
s(1) …
…
s(K0-1)
K1 (INFORMATION BITS + DUMMY BITS)

FIG. 12

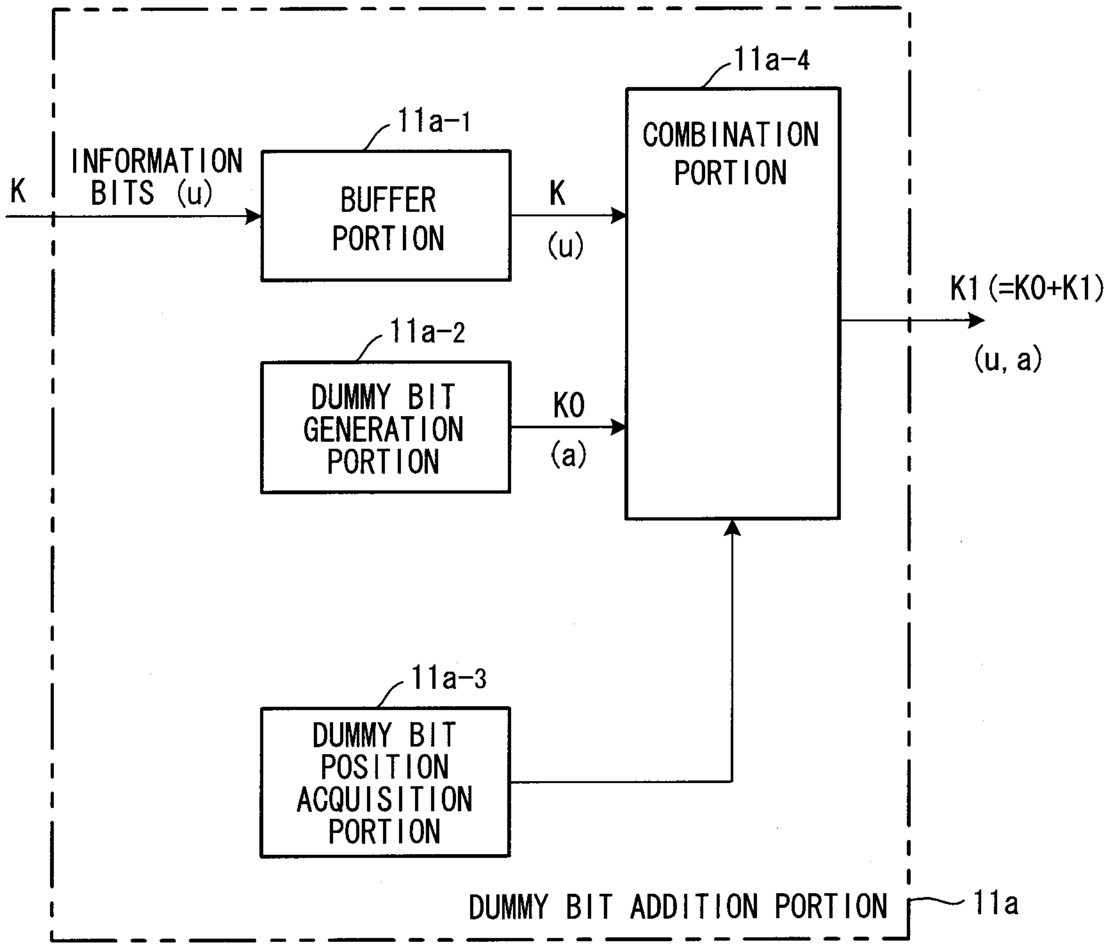
K
INFORMATION BITS (u)
11a-1
BUFFER PORTION
K
(u)
11a-2
DUMMY BIT GENERATION PORTION
K0
(a)
11a-4
COMBINATION PORTION
K1 (=K0+K1)
(u, a)
11a-3
DUMMY BIT POSITION ACQUISITION PORTION
DUMMY BIT ADDITION PORTION
11a

FIG. 13

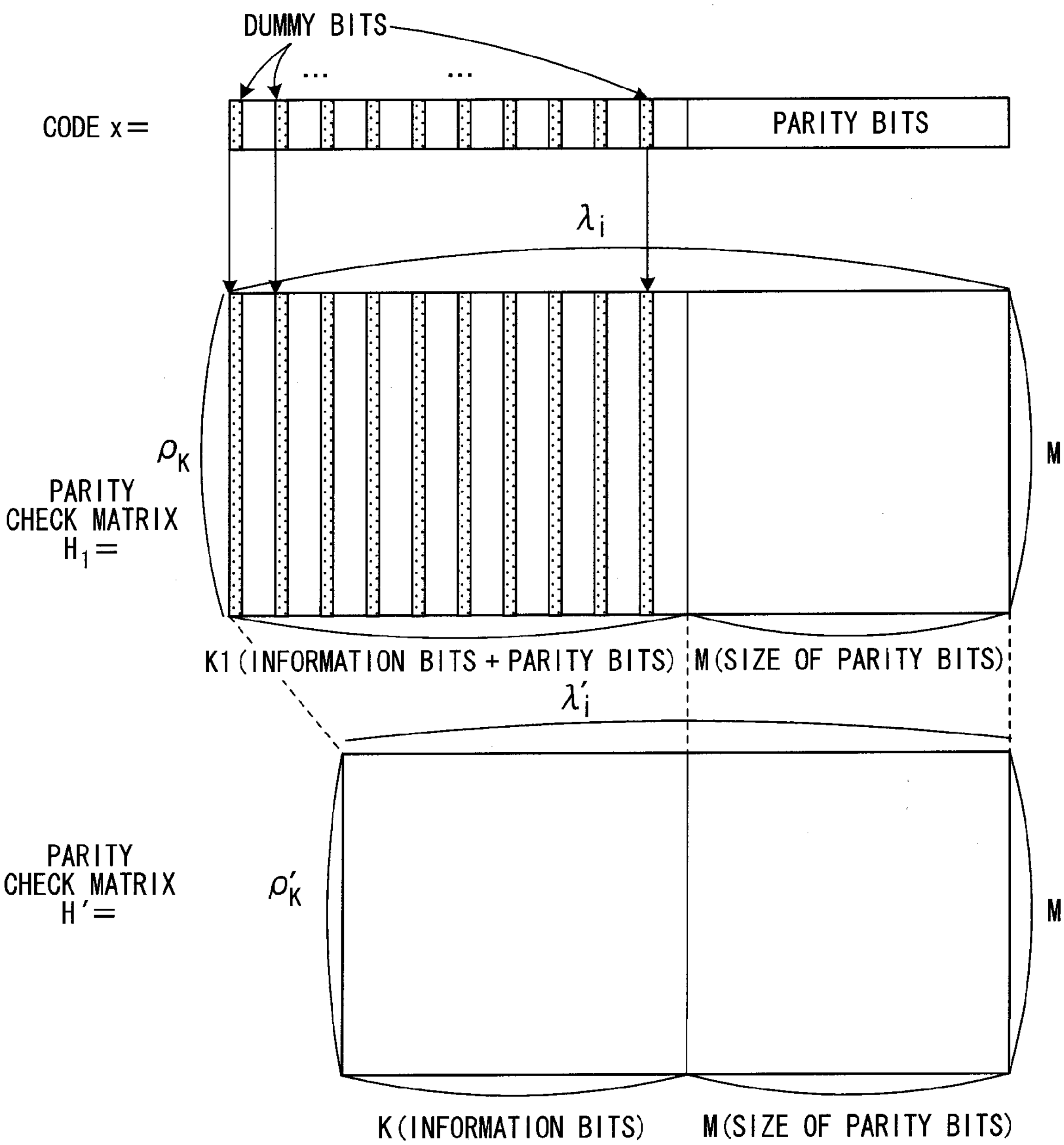
DUMMY BITS
CODE x=
PARITY BITS
λi
ρK
PARITY CHECK MATRIX H1=
M
K1(INFORMATION BITS + PARITY BITS)
M(SIZE OF PARITY BITS)
λ'i
PARITY CHECK MATRIX H'=
ρ'K
M
K(INFORMATION BITS)
M(SIZE OF PARITY BITS)

FIG. 14

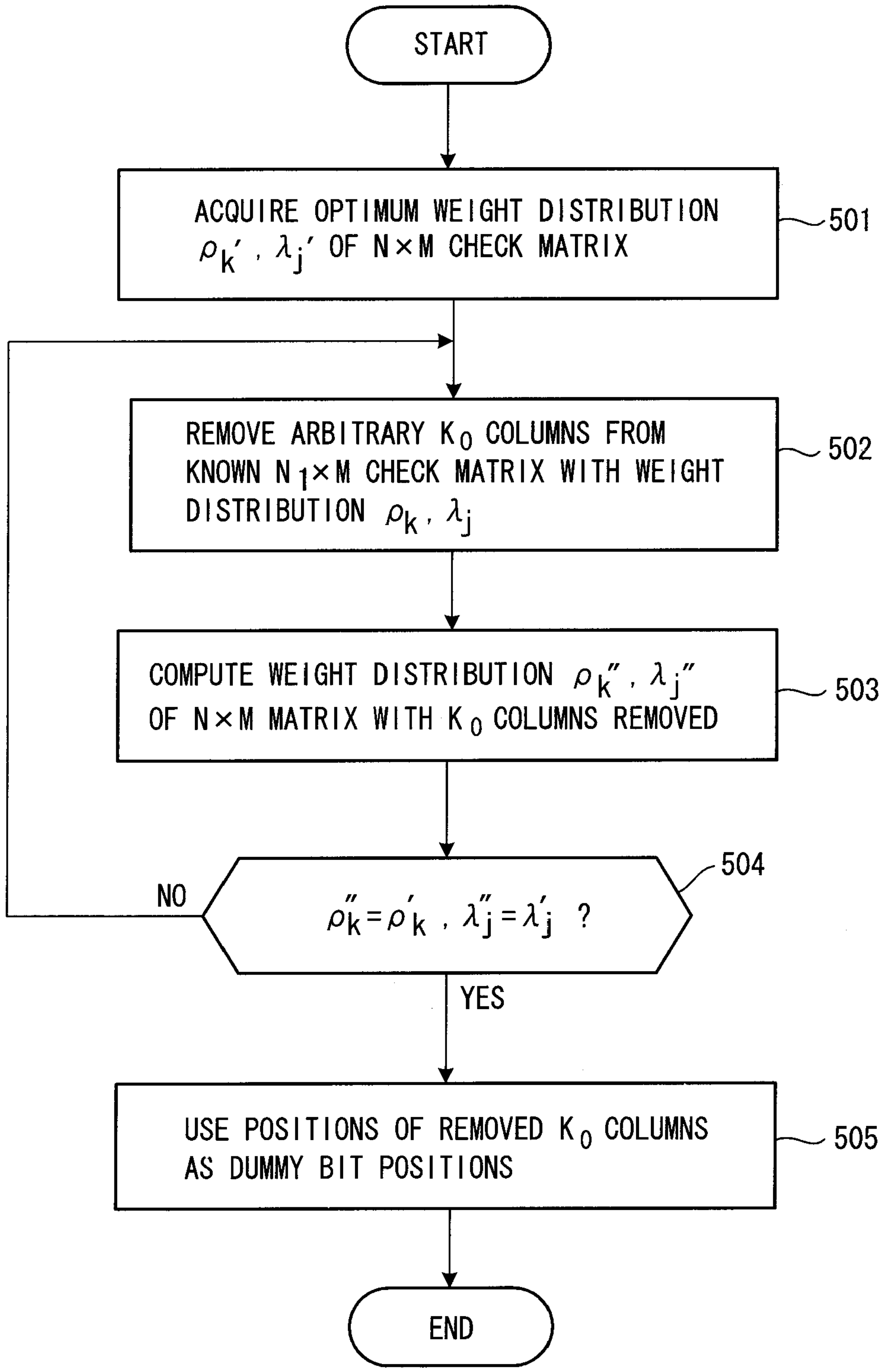
START
ACQUIRE OPTIMUM WEIGHT DISTRIBUTION $\rho_k'$, $\lambda_j'$ OF N×M CHECK MATRIX
501
REMOVE ARBITRARY $K_0$ COLUMNS FROM KNOWN $N_1$×M CHECK MATRIX WITH WEIGHT DISTRIBUTION $\rho_k$, $\lambda_j$
502
COMPUTE WEIGHT DISTRIBUTION $\rho_k''$, $\lambda_j''$ OF N×M MATRIX WITH $K_0$ COLUMNS REMOVED
503
$\rho_k''=\rho_k'$, $\lambda_j''=\lambda_j'$ ?
504
NO
YES
USE POSITIONS OF REMOVED $K_0$ COLUMNS AS DUMMY BIT POSITIONS
505
END

FIG. 15

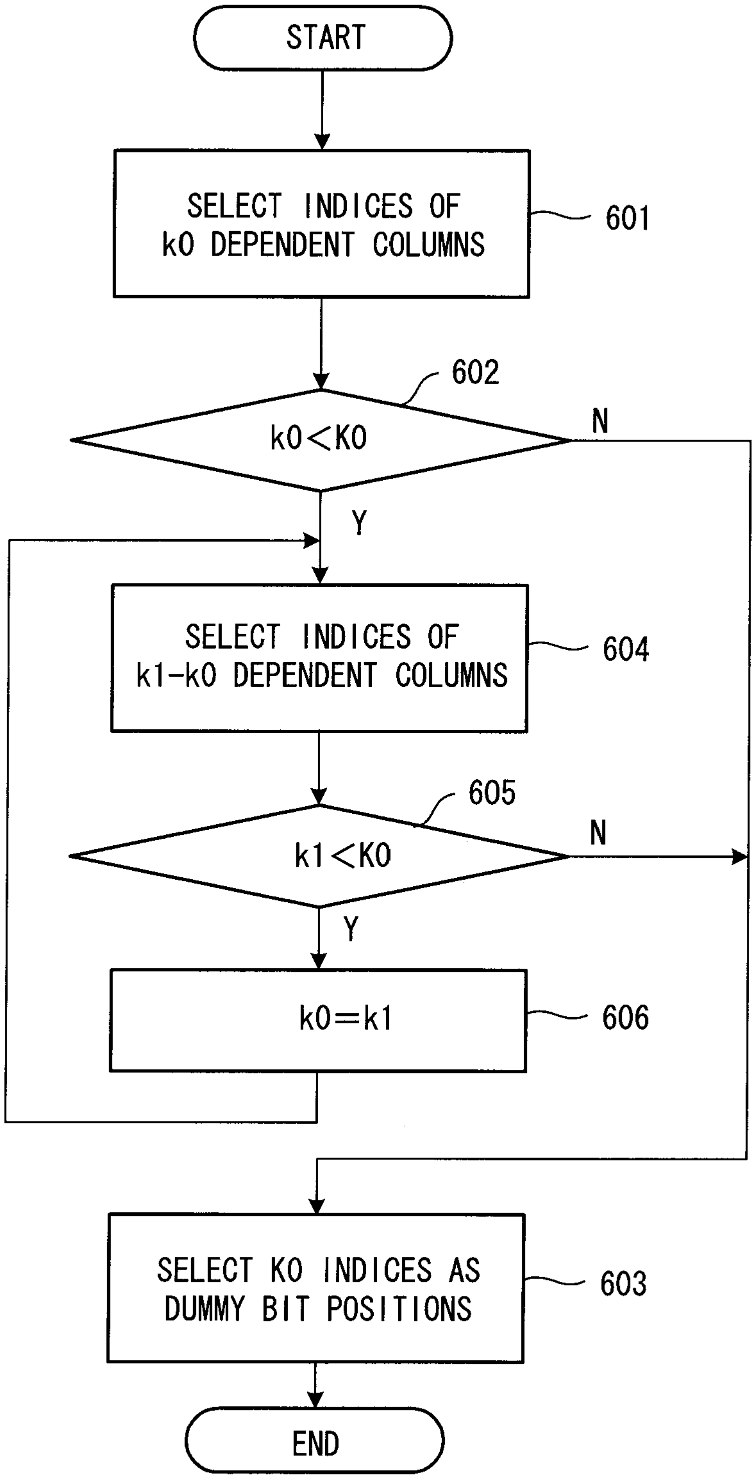
START
SELECT INDICES OF
k0 DEPENDENT COLUMNS
601
602
k0<K0
N
Y
SELECT INDICES OF
k1-k0 DEPENDENT COLUMNS
604
605
k1<K0
N
Y
k0=k1
606
SELECT K0 INDICES AS
DUMMY BIT POSITIONS
603
END

FIG. 16

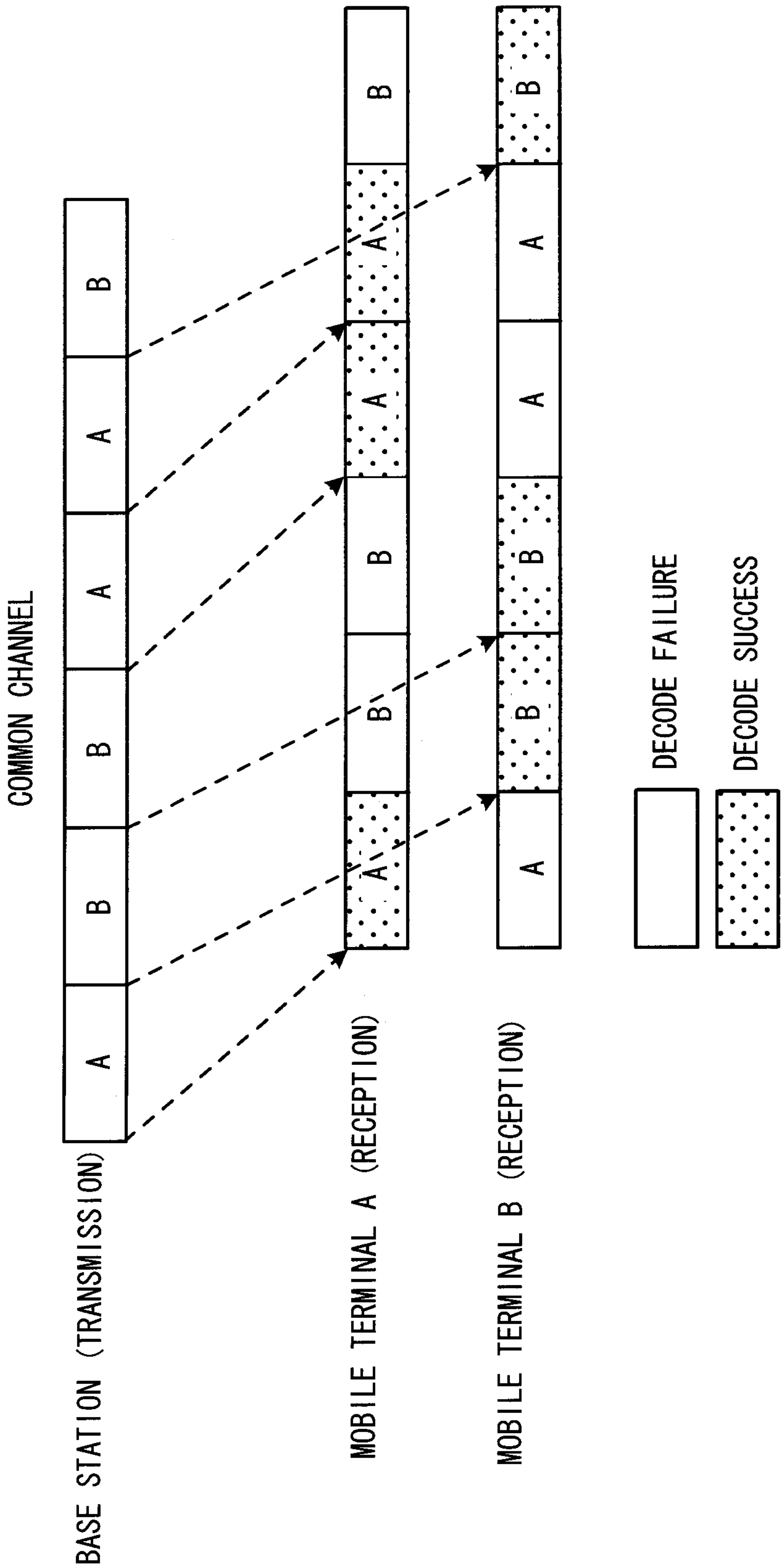
COMMON CHANNEL
BASE STATION (TRANSMISSION)
A
B
B
A
A
B
MOBILE TERMINAL A (RECEPTION)
A
B
B
A
A
B
MOBILE TERMINAL B (RECEPTION)
A
B
B
A
A
B
DECODE FAILURE
DECODE SUCCESS

FIG. 17

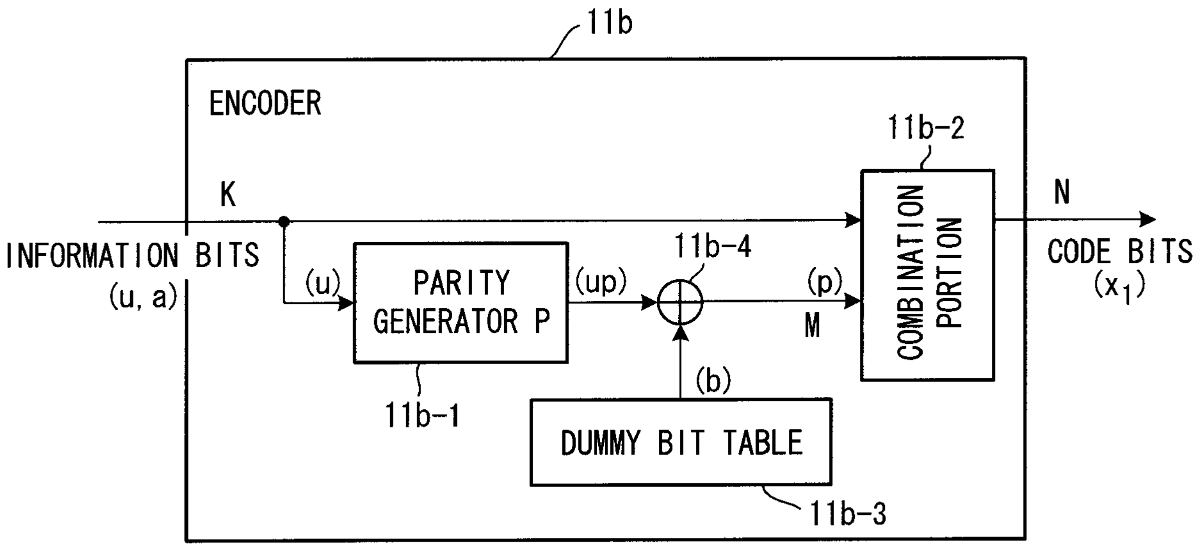
11b
ENCODER
11b-2
K
N
INFORMATION BITS
(u, a)
(u)
PARITY
GENERATOR P
(up)
11b-4
(p)
M
COMBINATION
PORTION
CODE BITS
$(x_1)$
(b)
11b-1
DUMMY BIT TABLE
11b-3

FIG. 18

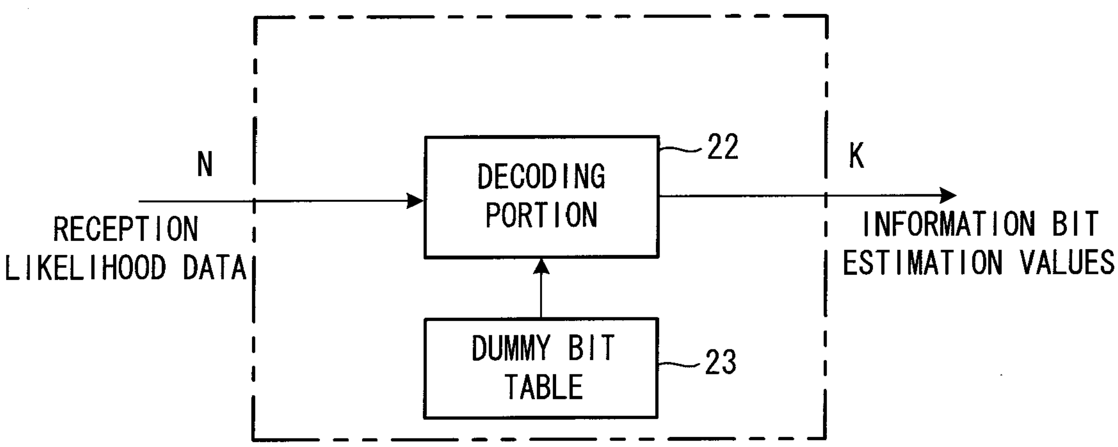
N
RECEPTION
LIKELIHOOD DATA
DECODING
PORTION
22
K
INFORMATION BIT
ESTIMATION VALUES
DUMMY BIT
TABLE
23

FIG. 19

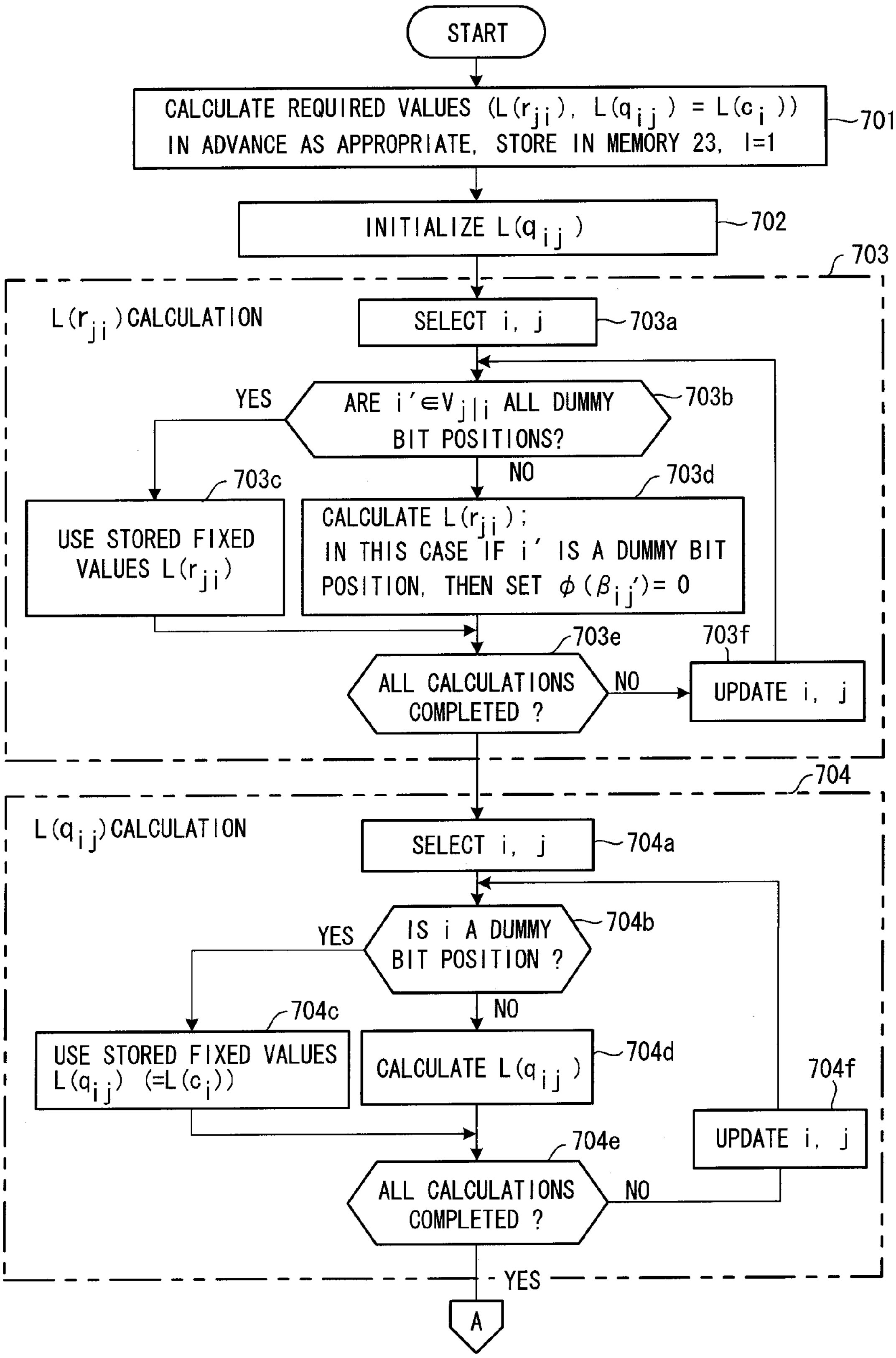
START
CALCULATE REQUIRED VALUES (L(r_ji), L(q_ij) = L(c_i)) IN ADVANCE AS APPROPRIATE, STORE IN MEMORY 23, l=1
701
INITIALIZE L(q_ij)
702
703
L(r_ji) CALCULATION
SELECT i, j
703a
ARE i'∈V_j|i ALL DUMMY BIT POSITIONS?
703b
YES
NO
703c
USE STORED FIXED VALUES L(r_ji)
703d
CALCULATE L(r_ji); IN THIS CASE IF i' IS A DUMMY BIT POSITION, THEN SET φ(β_ij')= 0
703e
ALL CALCULATIONS COMPLETED ?
NO
703f
UPDATE i, j
704
L(q_ij) CALCULATION
SELECT i, j
704a
IS i A DUMMY BIT POSITION ?
704b
YES
NO
704c
USE STORED FIXED VALUES L(q_ij) (=L(c_i))
CALCULATE L(q_ij)
704d
704f
UPDATE i, j
704e
ALL CALCULATIONS COMPLETED ?
NO
YES
A

FIG. 20

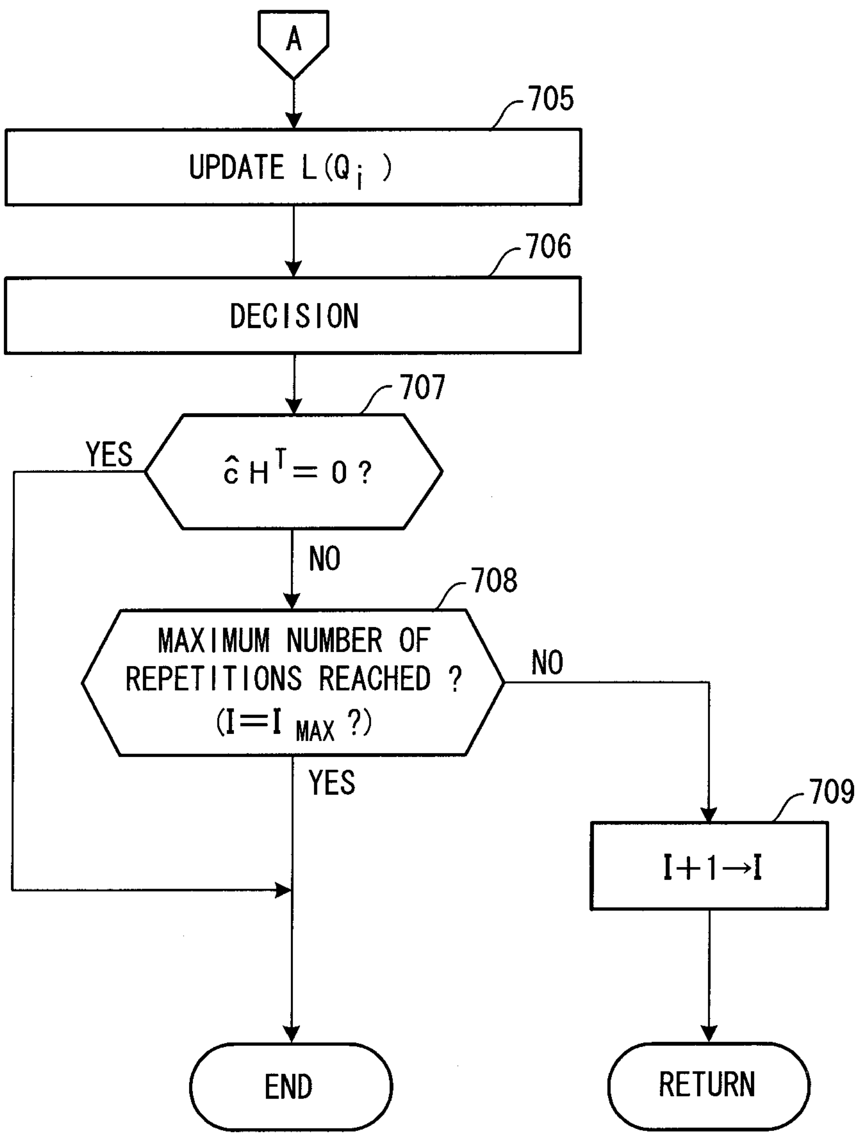
A
705
UPDATE L(Q_i )
706
DECISION
707
YES
ĉ H^T = 0 ?
NO
708
MAXIMUM NUMBER OF REPETITIONS REACHED ? (I=I MAX ?)
NO
YES
709
I+1→I
END
RETURN

FIG. 21

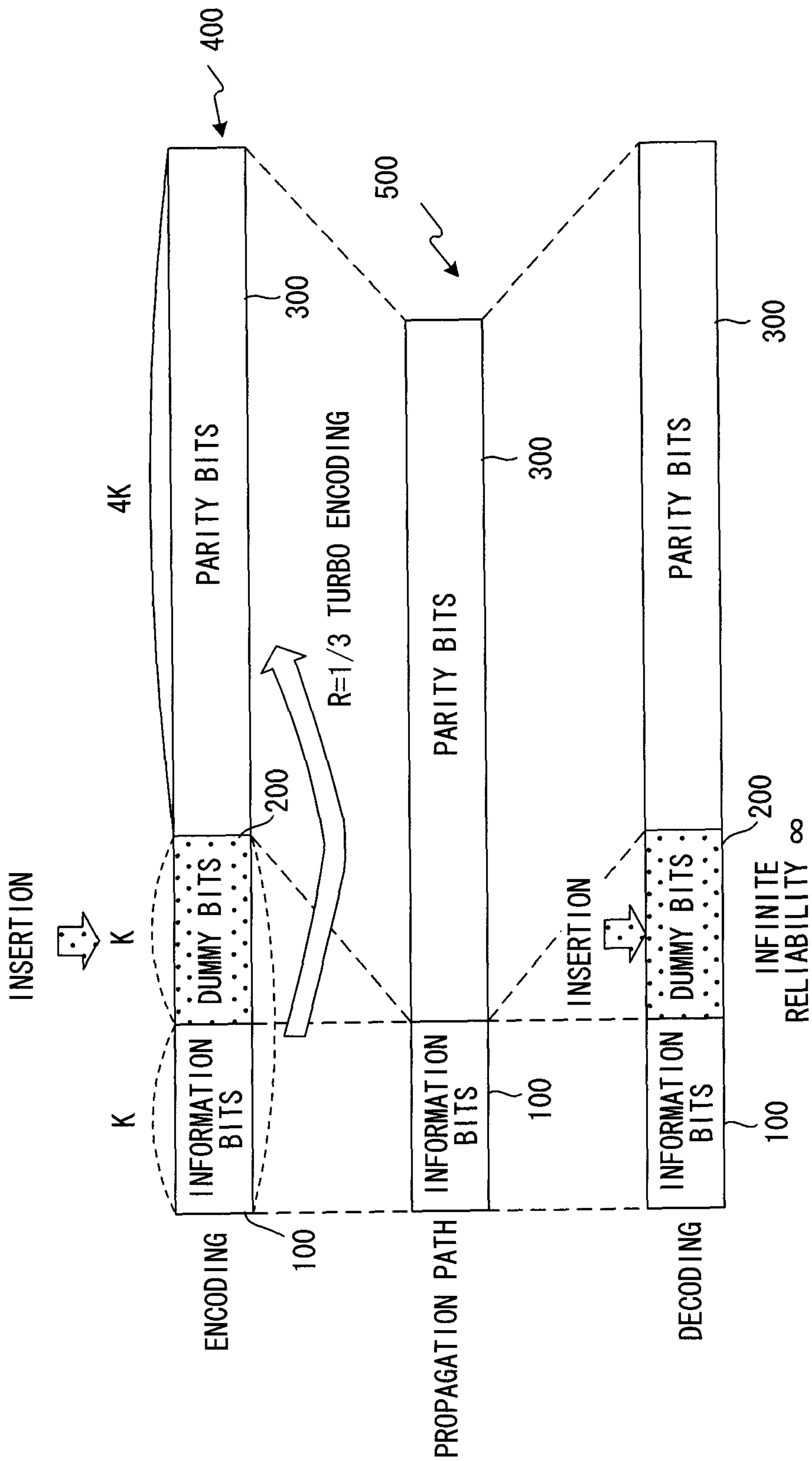
INSERTION
K
K
4K
400
INFORMATION BITS
DUMMY BITS
PARITY BITS
ENCODING
100
200
300
R=1/3 TURBO ENCODING
500
PROPAGATION PATH
INFORMATION BITS
PARITY BITS
100
300
INSERTION
DECODING
INFORMATION BITS
DUMMY BITS
PARITY BITS
100
200
300
INFINITE RELIABILITY ∞

FIG. 22

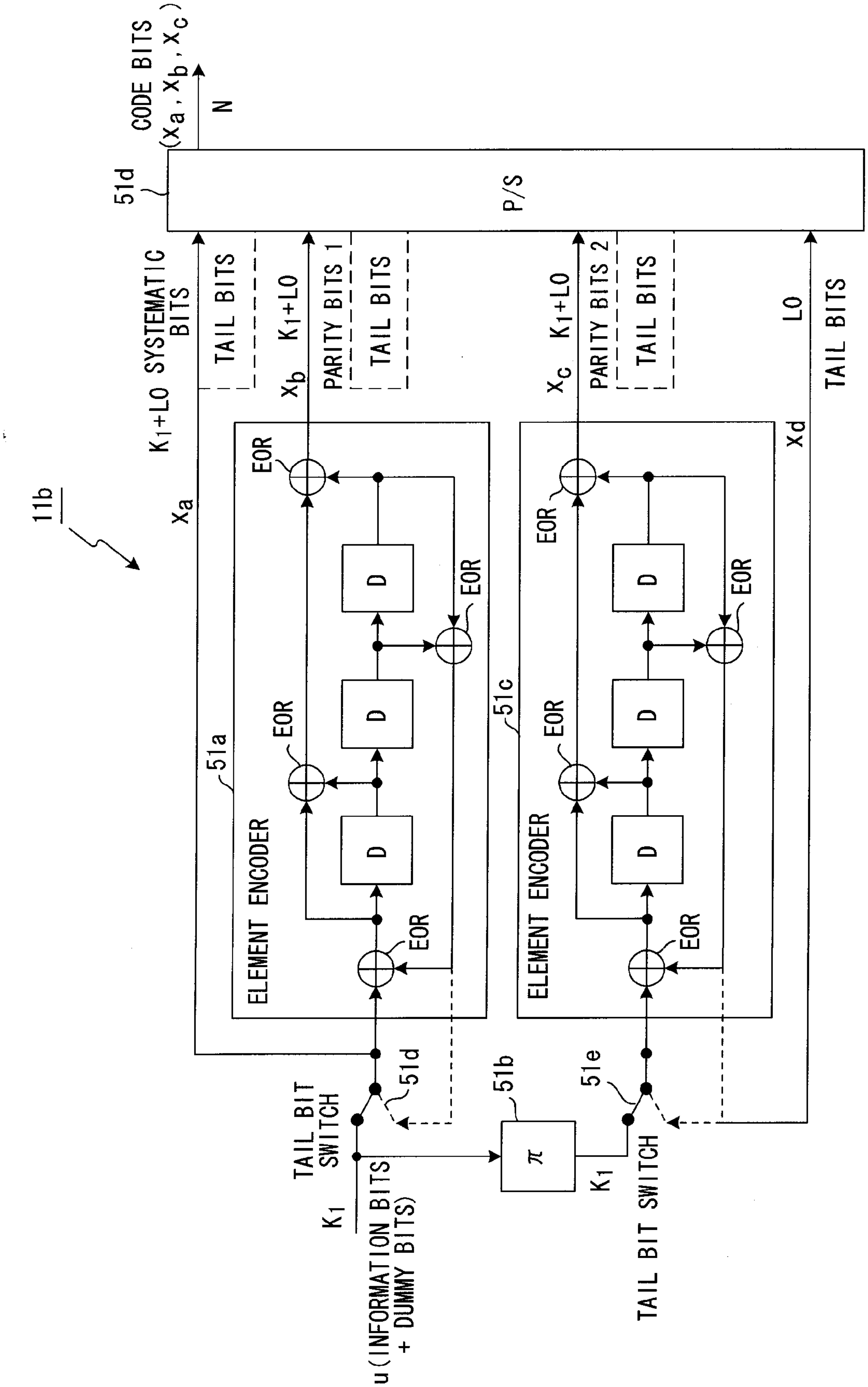
11b
CODE BITS
($X_a$, $X_b$, $X_c$)
N
51d
P/S
$K_1$+LO SYSTEMATIC BITS
TAIL BITS
$X_a$
$X_b$
$K_1$+LO
PARITY BITS 1
TAIL BITS
$X_c$
$K_1$+LO
PARITY BITS 2
TAIL BITS
LO
TAIL BITS
$X_d$
EOR
D
51a
51c
ELEMENT ENCODER
ELEMENT ENCODER
TAIL BIT SWITCH
51d
51b
π
51e
$K_1$
$K_1$
TAIL BIT SWITCH
u (INFORMATION BITS + DUMMY BITS)

FIG. 23

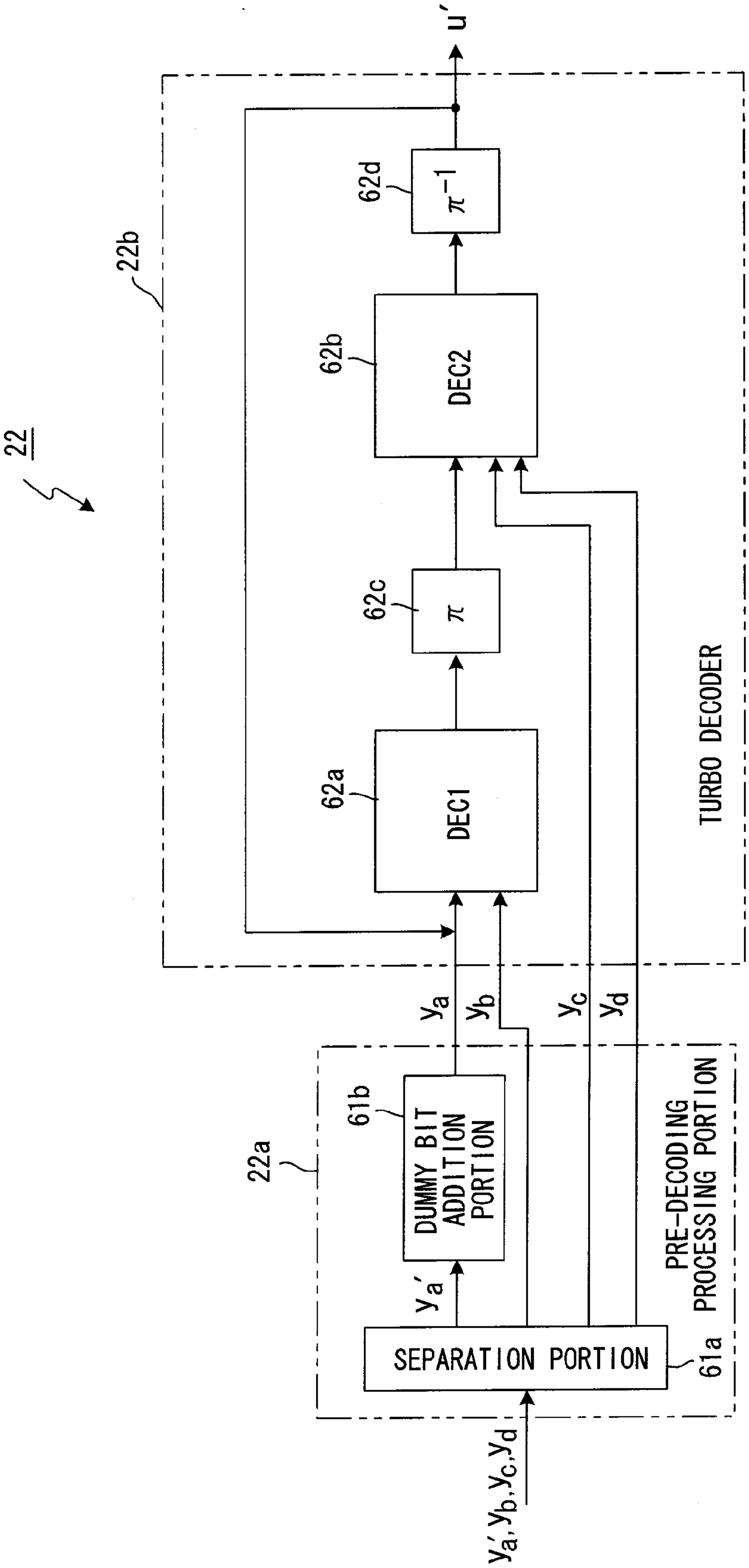
22
22a
22b
SEPARATION PORTION
61a
DUMMY BIT ADDITION PORTION
61b
PRE-DECODING PROCESSING PORTION
DEC1
62a
$\pi$
62c
DEC2
62b
$\pi^{-1}$
62d
TURBO DECODER
$y_a'$, $y_b$, $y_c$, $y_d$
$y_a'$
$y_a$
$y_b$
$y_c$
$y_d$
u'

# FIG. 24

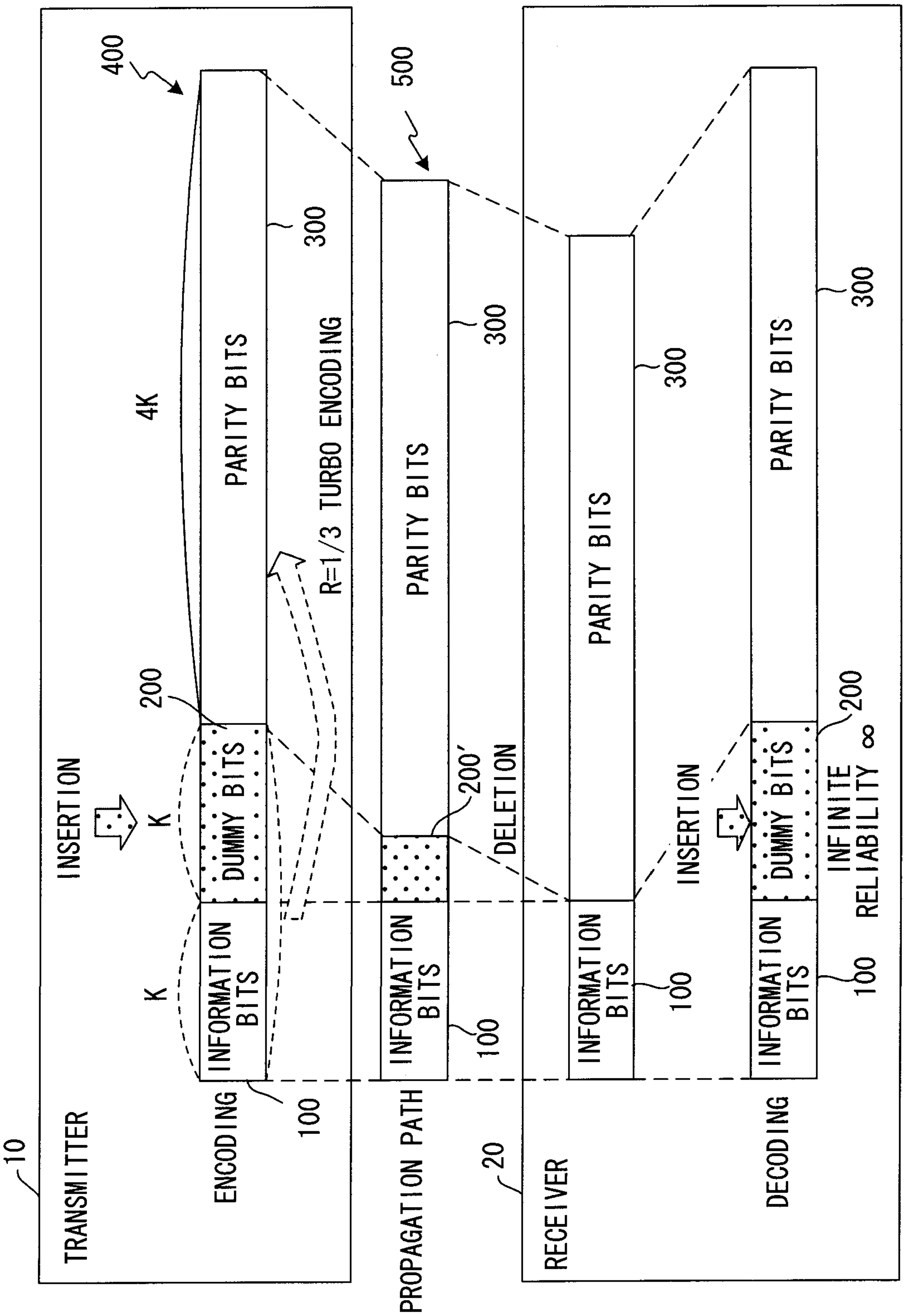
10
TRANSMITTER
ENCODING
100
K
INFORMATION BITS
INSERTION
K
DUMMY BITS
200
4K
PARITY BITS
400
300
R=1/3 TURBO ENCODING
PROPAGATION PATH
INFORMATION BITS
100
200'
DELETION
PARITY BITS
300
500
20
RECEIVER
INFORMATION BITS
100
INSERTION
PARITY BITS
300
DECODING
INFORMATION BITS
100
DUMMY BITS
INFINITE RELIABILITY ∞
200
PARITY BITS
300

FIG. 25

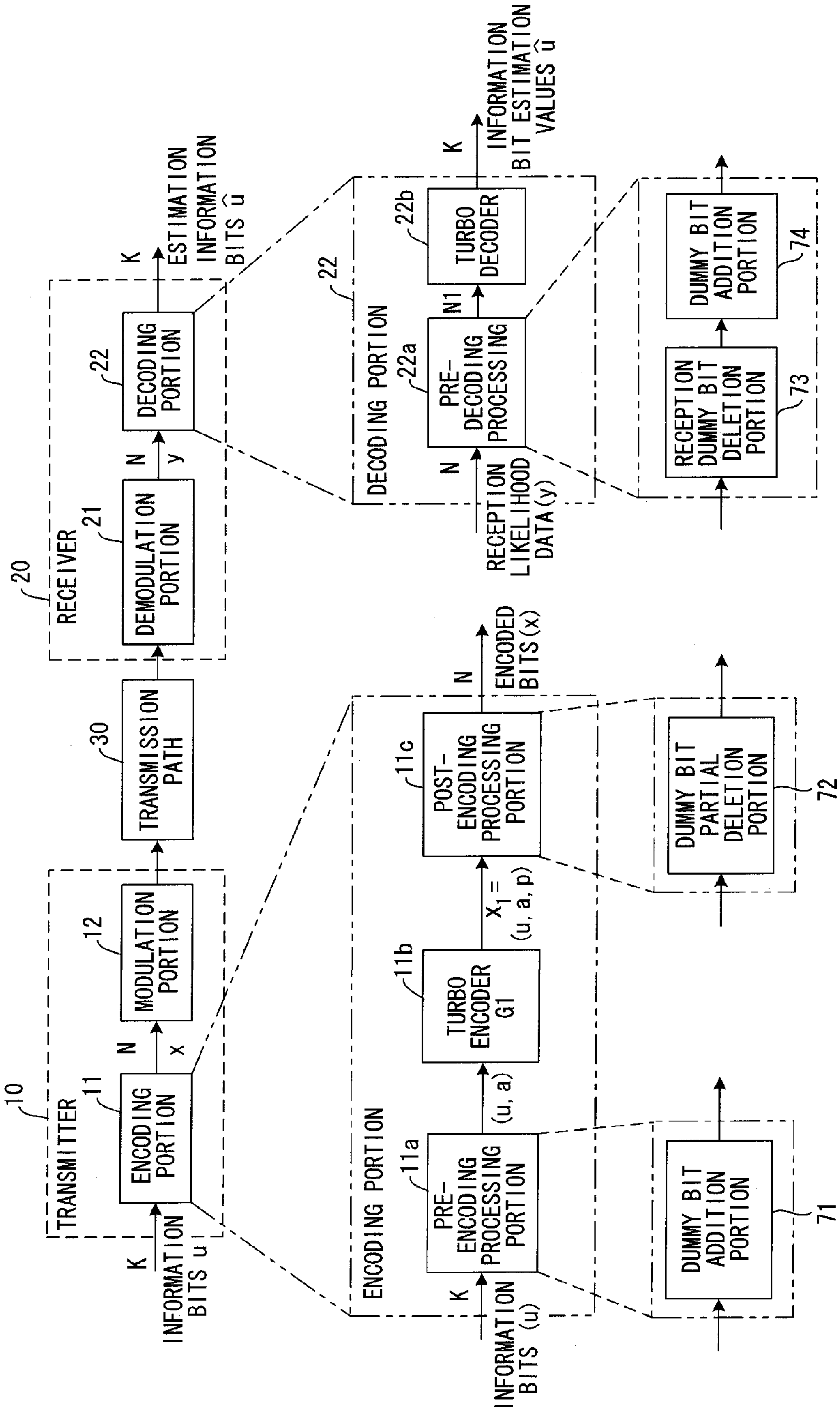
10
TRANSMITTER
11
ENCODING PORTION
K
INFORMATION BITS u
N
x
12
MODULATION PORTION
30
TRANSMISSION PATH
20
RECEIVER
21
DEMODULATION PORTION
N
y
22
DECODING PORTION
K
ESTIMATION INFORMATION BITS û
ENCODING PORTION
11a
PRE-ENCODING PROCESSING PORTION
K
INFORMATION BITS (u)
(u, a)
11b
TURBO ENCODER G1
$x_1$ = (u, a, p)
11c
POST-ENCODING PROCESSING PORTION
N
ENCODED BITS (x)
DUMMY BIT ADDITION PORTION
71
DUMMY BIT PARTIAL DELETION PORTION
72
22
DECODING PORTION
22a
PRE-DECODING PROCESSING
N
RECEPTION LIKELIHOOD DATA (y)
N1
22b
TURBO DECODER
K
INFORMATION BIT ESTIMATION VALUES û
RECEPTION DUMMY BIT DELETION PORTION
73
DUMMY BIT ADDITION PORTION
74

FIG. 26

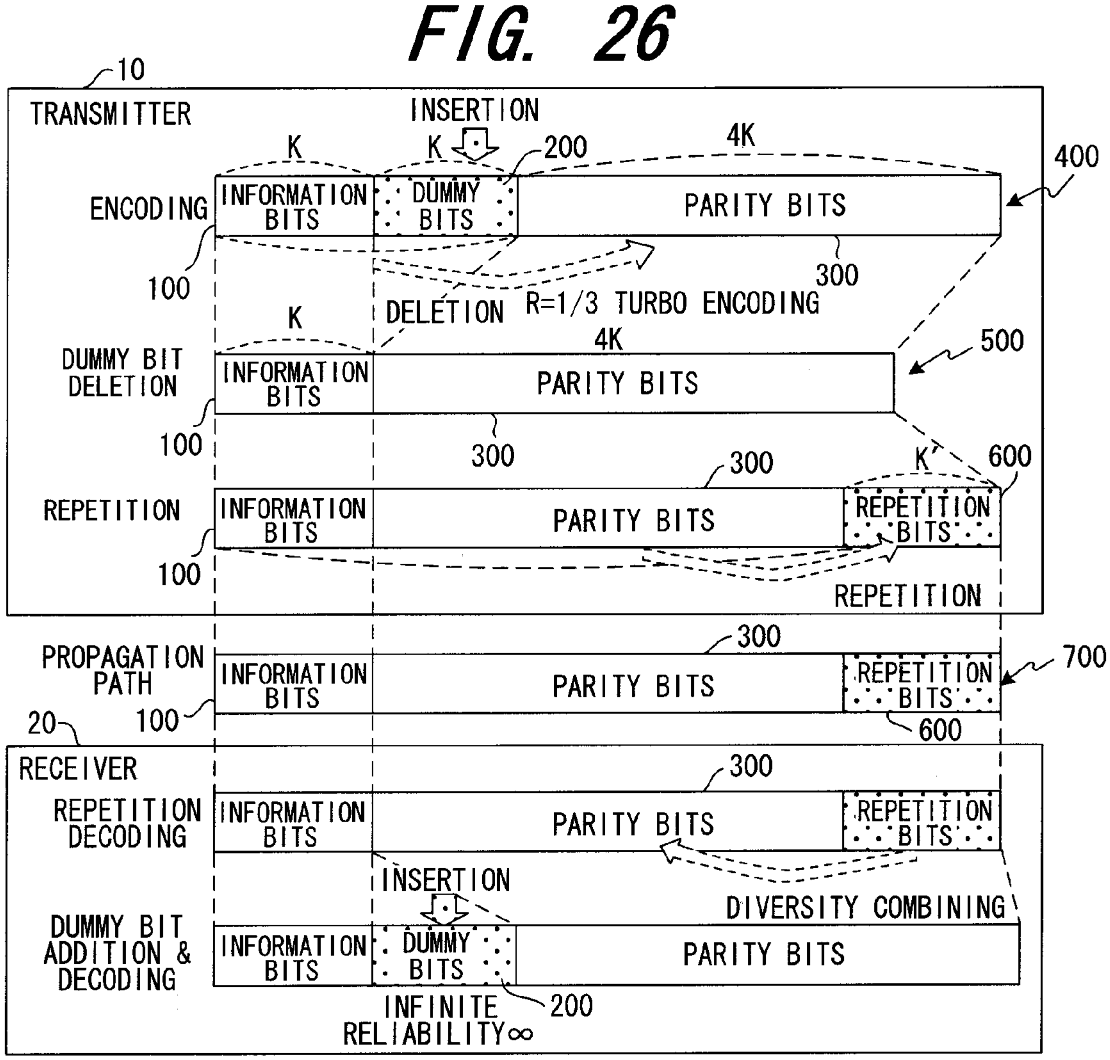
10
TRANSMITTER
INSERTION
K
K
200
4K
400
ENCODING
INFORMATION BITS
DUMMY BITS
PARITY BITS
100
300
DELETION
R=1/3 TURBO ENCODING
K
4K
500
DUMMY BIT DELETION
INFORMATION BITS
PARITY BITS
100
300
300
K'
600
REPETITION
INFORMATION BITS
PARITY BITS
REPETITION BITS
100
REPETITION
300
700
PROPAGATION PATH
INFORMATION BITS
PARITY BITS
REPETITION BITS
20
100
600
RECEIVER
300
REPETITION DECODING
INFORMATION BITS
PARITY BITS
REPETITION BITS
INSERTION
DIVERSITY COMBINING
DUMMY BIT ADDITION & DECODING
INFORMATION BITS
DUMMY BITS
PARITY BITS
INFINITE RELIABILITY∞
200

FIG. 27

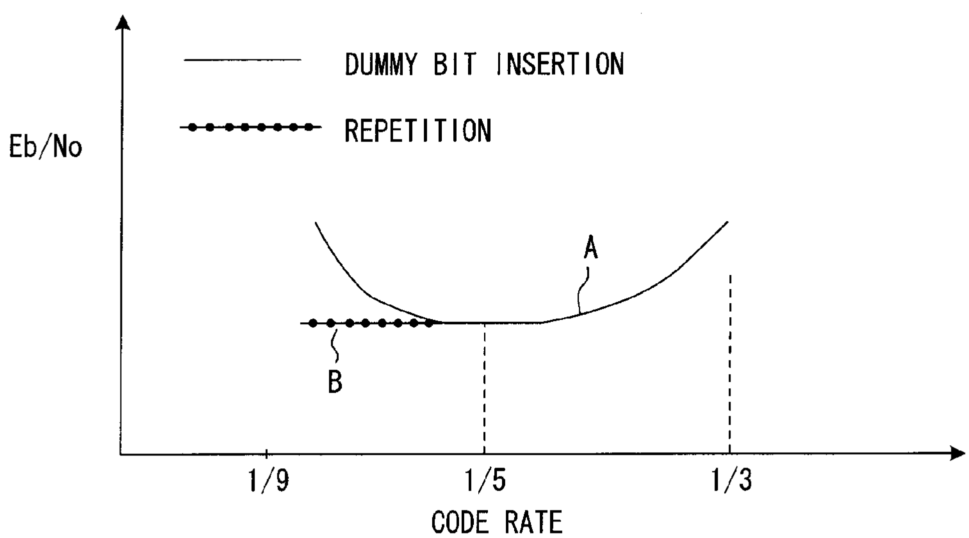
DUMMY BIT INSERTION
REPETITION
Eb/No
A
B
1/9
1/5
1/3
CODE RATE

FIG. 28

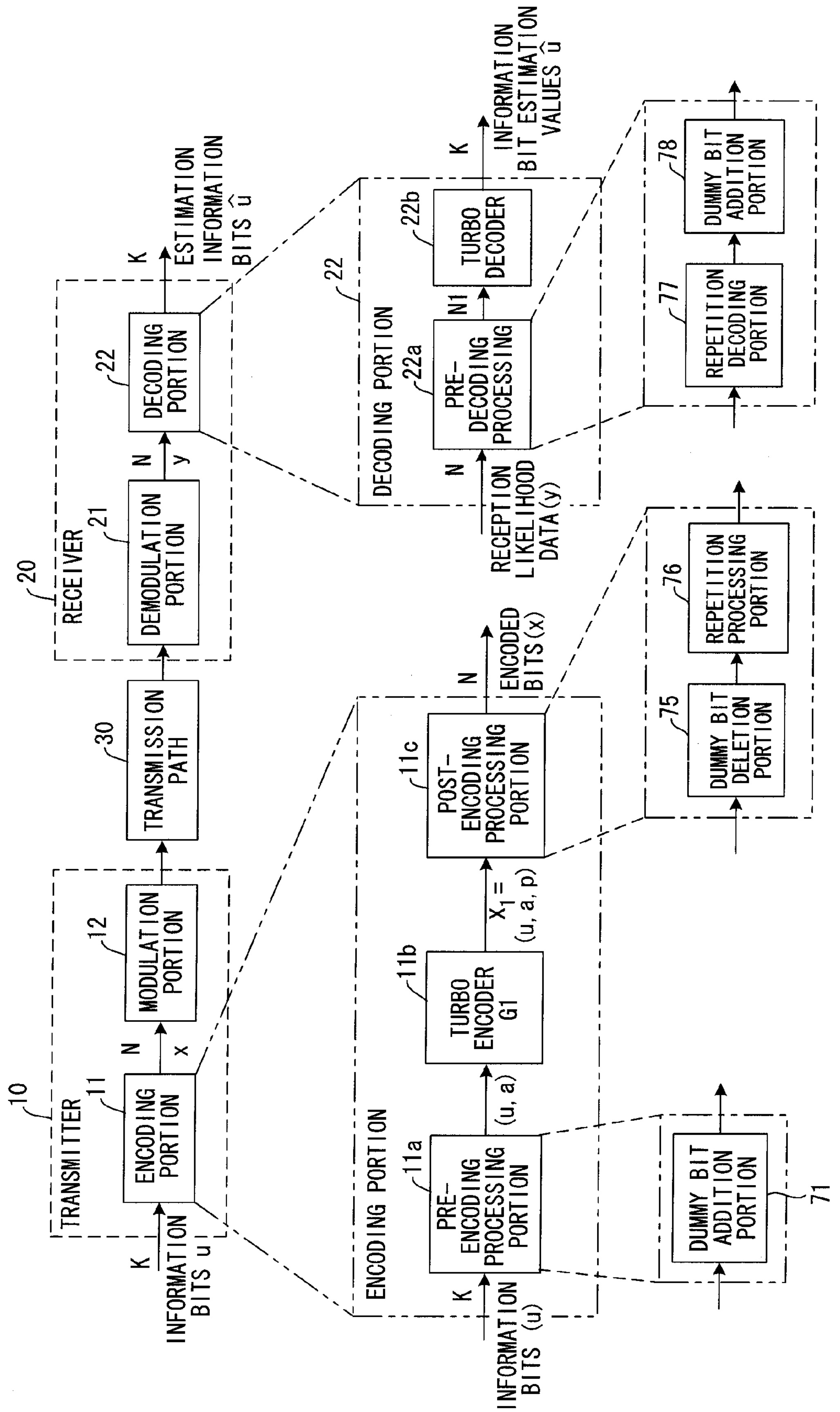
10
TRANSMITTER
11
ENCODING PORTION
12
MODULATION PORTION
INFORMATION BITS u
K
N
x
30
TRANSMISSION PATH
20
RECEIVER
21
DEMODULATION PORTION
22
DECODING PORTION
N
y
K
ESTIMATION INFORMATION BITS û
ENCODING PORTION
11a
PRE-ENCODING PROCESSING PORTION
(u, a)
11b
TURBO ENCODER G1
X1 = (u, a, p)
11c
POST-ENCODING PROCESSING PORTION
N
ENCODED BITS (x)
INFORMATION BITS (u)
DECODING PORTION
22a
PRE-DECODING PROCESSING
N1
22b
TURBO DECODER
RECEPTION LIKELIHOOD DATA (y)
INFORMATION BIT ESTIMATION VALUES û
DUMMY BIT ADDITION PORTION
71
75
DUMMY BIT DELETION PORTION
76
REPETITION PROCESSING PORTION
77
REPETITION DECODING PORTION
78
DUMMY BIT ADDITION PORTION

FIG. 29

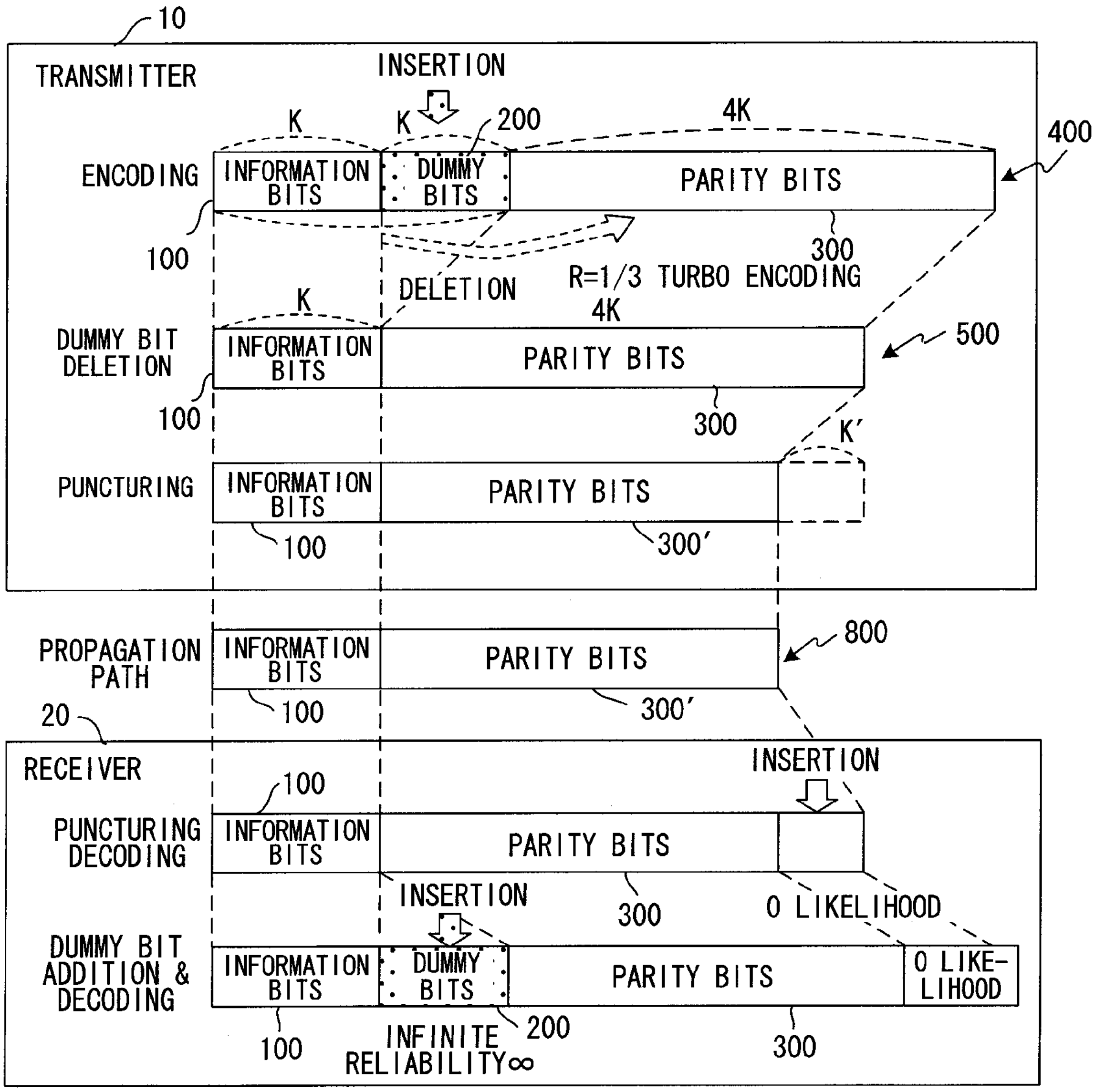
10
TRANSMITTER
INSERTION
K
K
200
4K
400
ENCODING
INFORMATION BITS
DUMMY BITS
PARITY BITS
100
300
DELETION
R=1/3 TURBO ENCODING
K
4K
500
DUMMY BIT DELETION
INFORMATION BITS
PARITY BITS
100
300
K′
PUNCTURING
INFORMATION BITS
PARITY BITS
100
300′
800
PROPAGATION PATH
INFORMATION BITS
PARITY BITS
100
300′
20
RECEIVER
INSERTION
100
PUNCTURING DECODING
INFORMATION BITS
PARITY BITS
INSERTION
300
0 LIKELIHOOD
DUMMY BIT ADDITION & DECODING
INFORMATION BITS
DUMMY BITS
PARITY BITS
0 LIKE-LIHOOD
100
INFINITE RELIABILITY∞
200
300

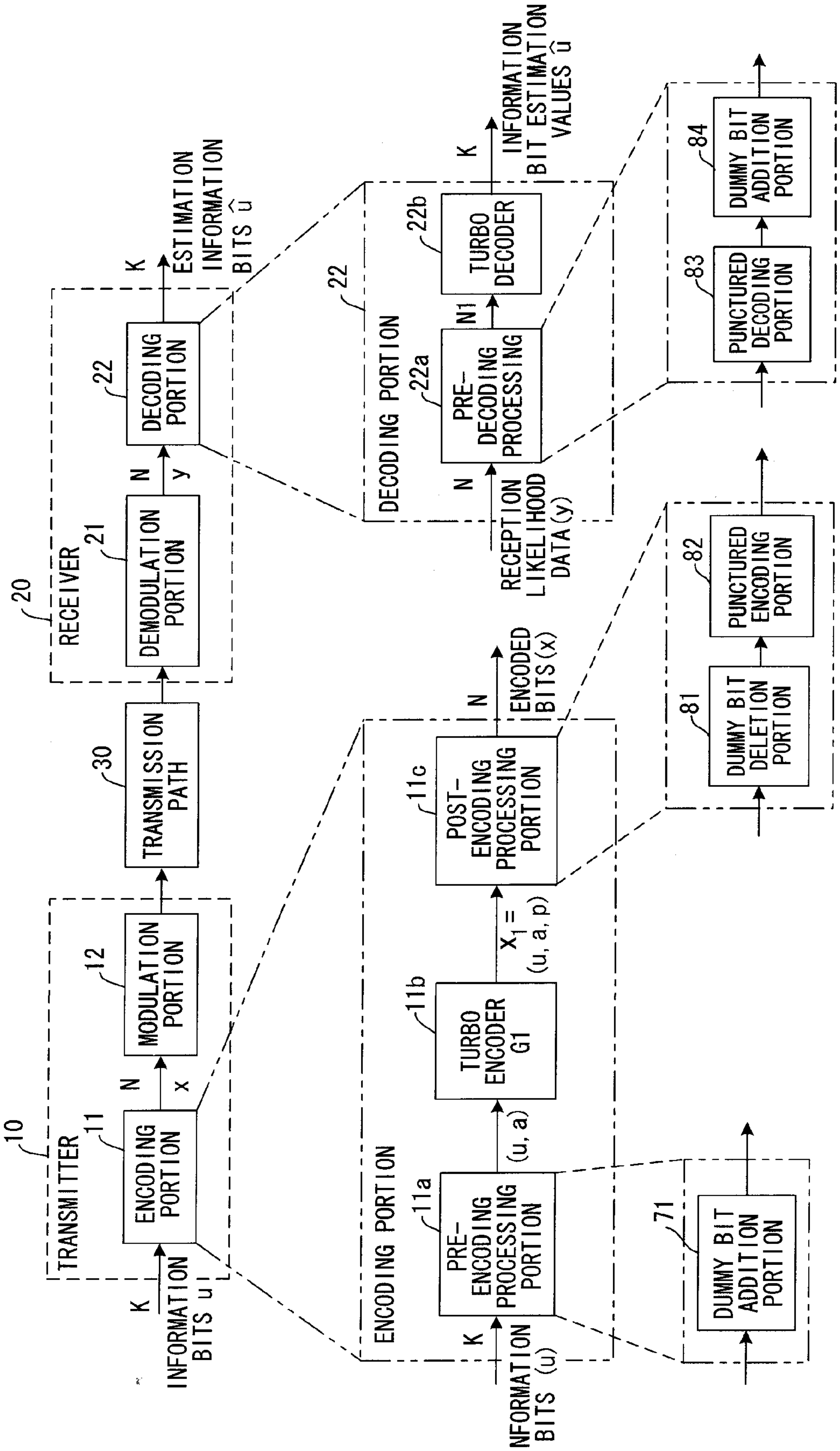
10
TRANSMITTER
11
ENCODING PORTION
12
MODULATION PORTION
K
INFORMATION BITS u
N
x
30
TRANSMISSION PATH
20
RECEIVER
21
DEMODULATION PORTION
22
DECODING PORTION
N
y
K
ESTIMATION INFORMATION BITS û
ENCODING PORTION
11a
PRE-ENCODING PROCESSING PORTION
11b
TURBO ENCODER G1
11c
POST-ENCODING PROCESSING PORTION
INFORMATION BITS (u)
(u, a)
x1 = (u, a, p)
N
ENCODED BITS (x)
22
DECODING PORTION
22a
PRE-DECODING PROCESSING
22b
TURBO DECODER
N
RECEPTION LIKELIHOOD DATA (y)
N1
K
INFORMATION BIT ESTIMATION VALUES û
71
DUMMY BIT ADDITION PORTION
81
DUMMY BIT DELETION PORTION
82
PUNCTURED ENCODING PORTION
83
PUNCTURED DECODING PORTION
84
DUMMY BIT ADDITION PORTION

FIG. 30

FIG. 31

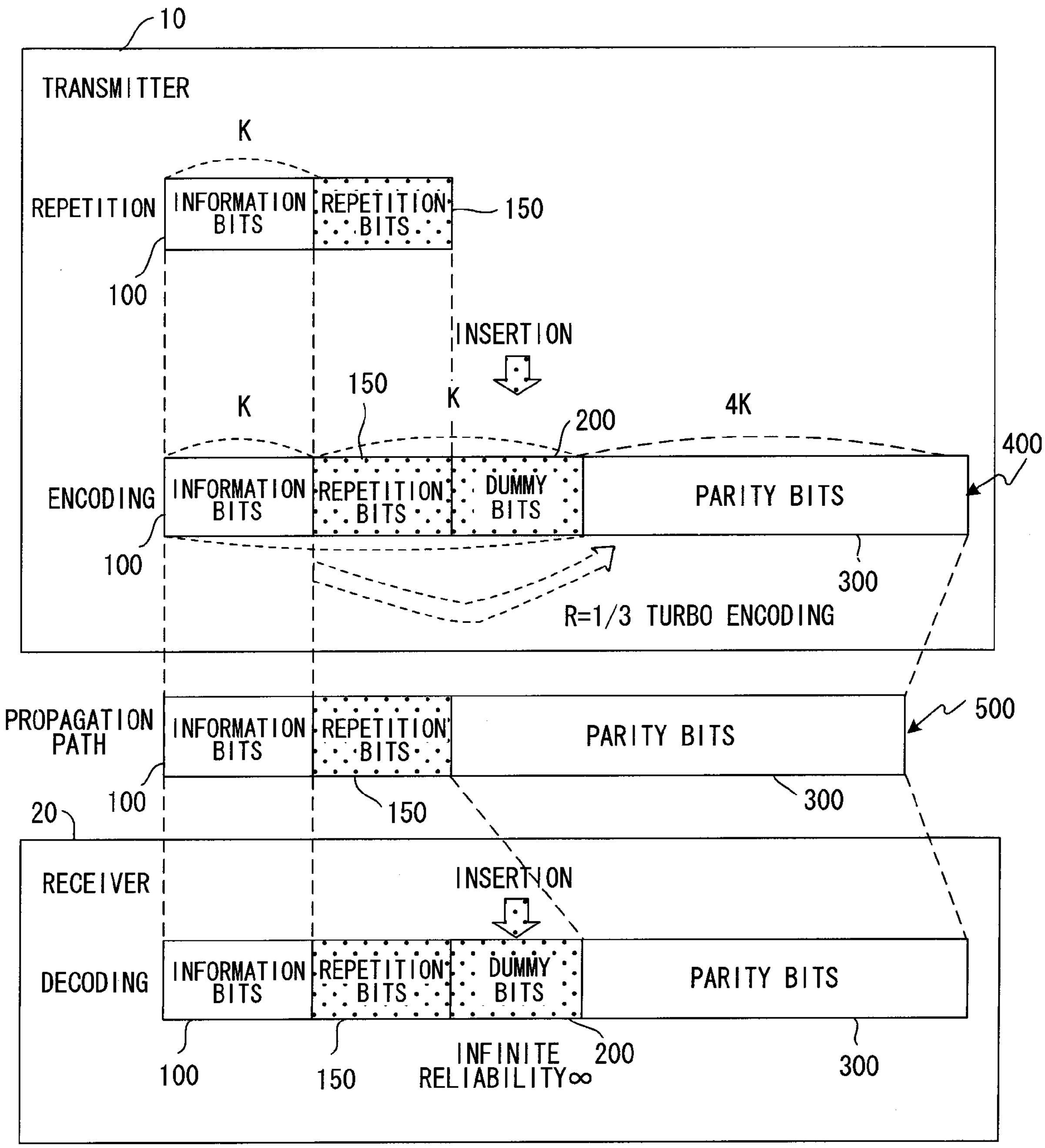
10
TRANSMITTER
K
REPETITION
INFORMATION BITS
REPETITION BITS
150
100
INSERTION
150
K
K
200
4K
400
ENCODING
INFORMATION BITS
REPETITION BITS
DUMMY BITS
PARITY BITS
100
300
R=1/3 TURBO ENCODING
PROPAGATION PATH
INFORMATION BITS
REPETITION BITS
PARITY BITS
500
100
150
300
20
RECEIVER
INSERTION
DECODING
INFORMATION BITS
REPETITION BITS
DUMMY BITS
PARITY BITS
100
150
INFINITE RELIABILITY∞
200
300

FIG. 32

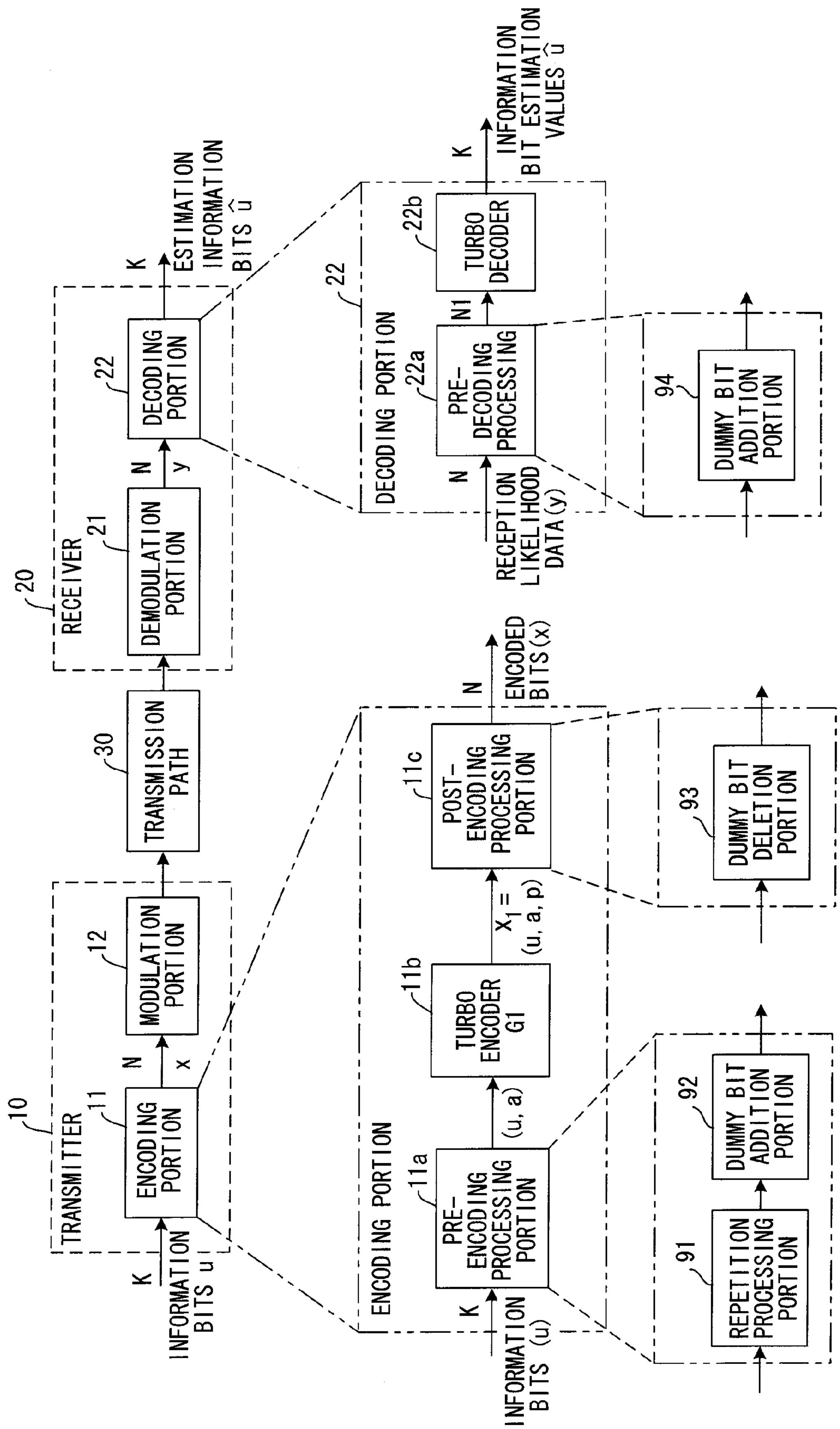
10
TRANSMITTER
11
ENCODING PORTION
12
MODULATION PORTION
30
TRANSMISSION PATH
20
RECEIVER
21
DEMODULATION PORTION
22
DECODING PORTION
K
INFORMATION BITS u
N
x
N
y
K
ESTIMATION INFORMATION BITS û
ENCODING PORTION
11a
PRE-ENCODING PROCESSING PORTION
11b
TURBO ENCODER G1
11c
POST-ENCODING PROCESSING PORTION
K
INFORMATION BITS (u)
(u, a)
x1 = (u, a, p)
N
ENCODED BITS (x)
91
REPETITION PROCESSING PORTION
92
DUMMY BIT ADDITION PORTION
93
DUMMY BIT DELETION PORTION
22
DECODING PORTION
22a
PRE-DECODING PROCESSING
22b
TURBO DECODER
N
RECEPTION LIKELIHOOD DATA (y)
N1
K
INFORMATION BIT ESTIMATION VALUES û
94
DUMMY BIT ADDITION PORTION

FIG. 33

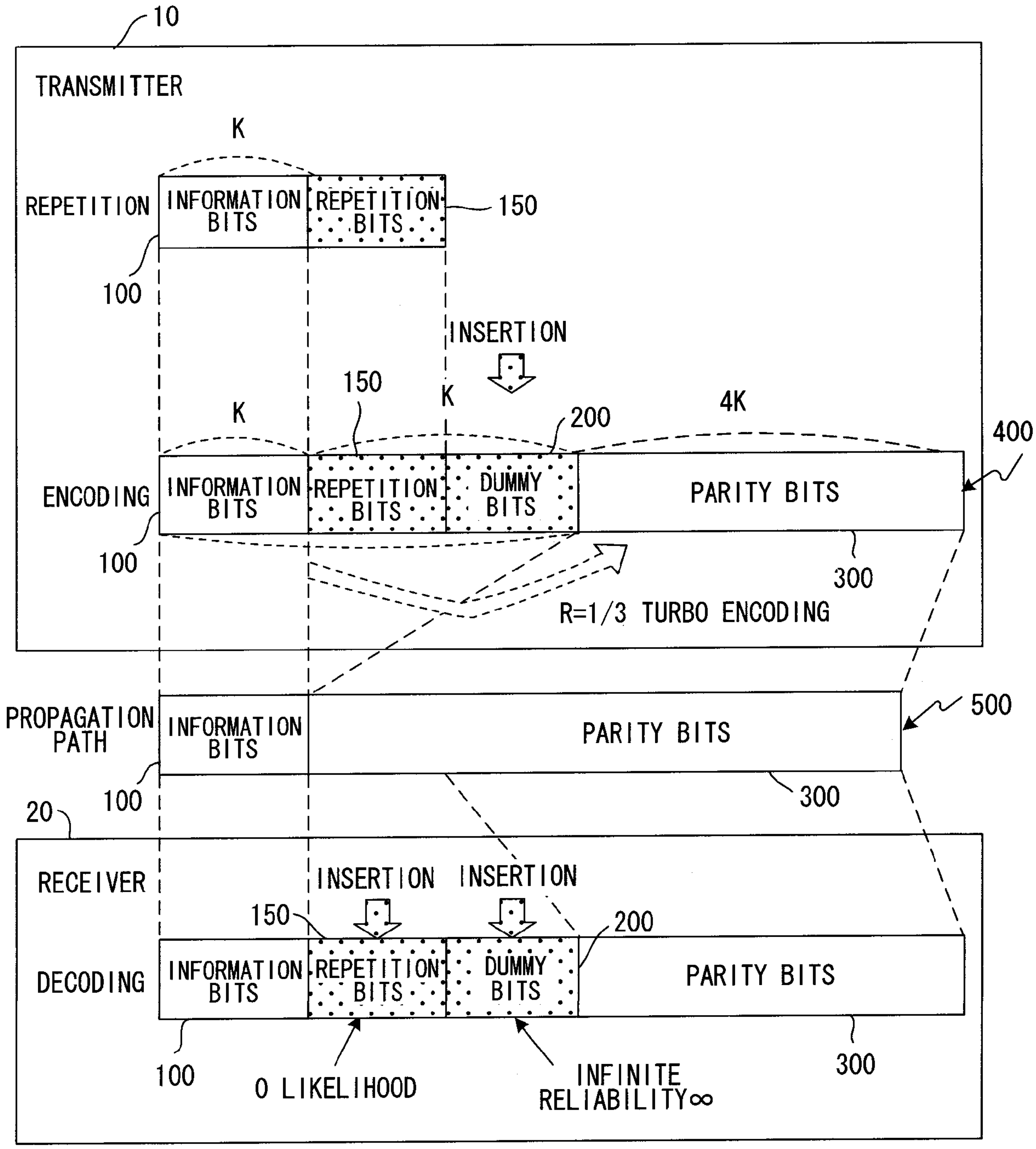
10
TRANSMITTER
K
REPETITION
INFORMATION BITS
REPETITION BITS
150
100
INSERTION
150
K
K
200
4K
400
ENCODING
INFORMATION BITS
REPETITION BITS
DUMMY BITS
PARITY BITS
100
300
R=1/3 TURBO ENCODING
PROPAGATION PATH
INFORMATION BITS
PARITY BITS
500
100
300
20
RECEIVER
INSERTION
INSERTION
150
200
DECODING
INFORMATION BITS
REPETITION BITS
DUMMY BITS
PARITY BITS
100
0 LIKELIHOOD
INFINITE RELIABILITY∞
300

FIG. 34

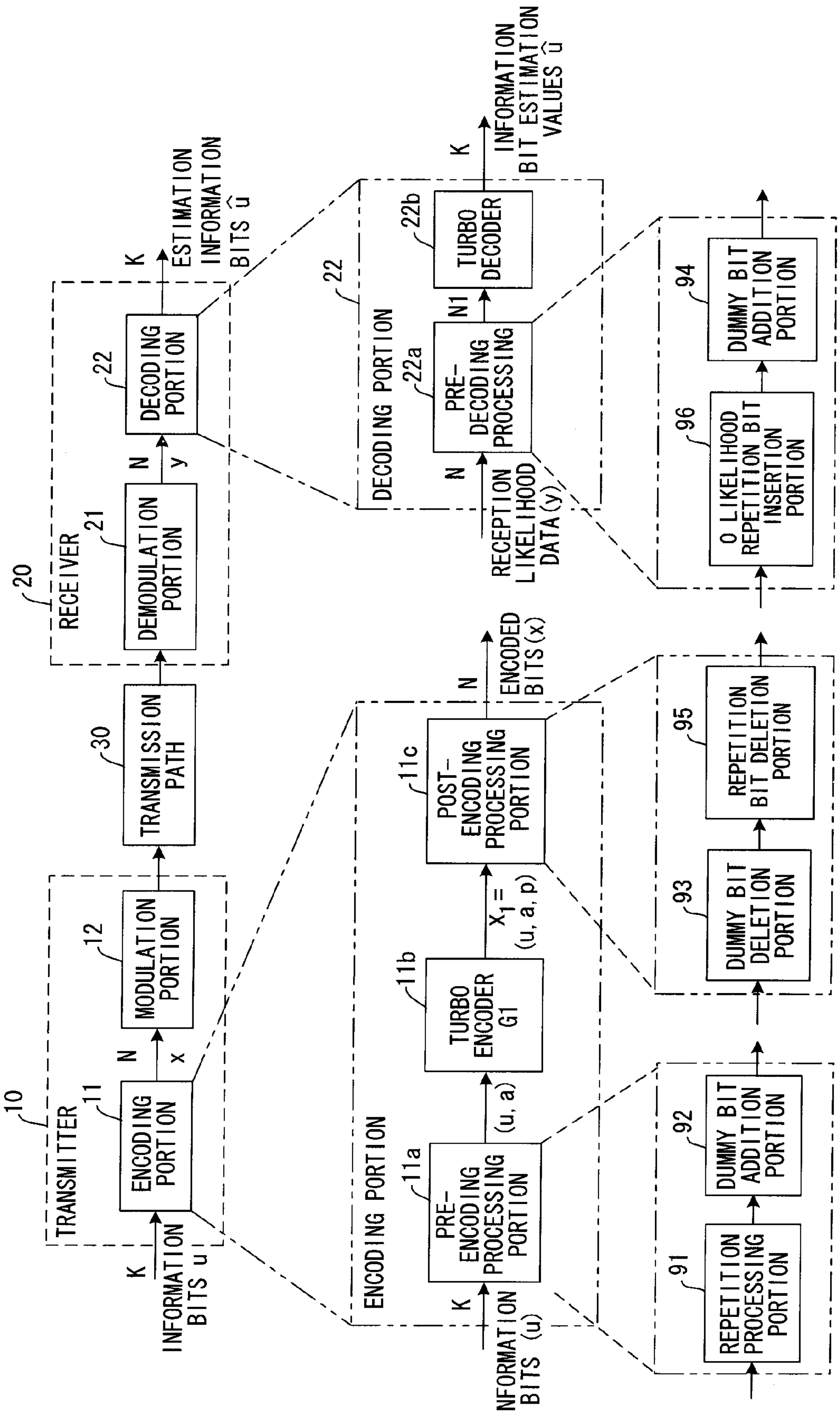
10
TRANSMITTER
11
ENCODING PORTION
12
MODULATION PORTION
K
INFORMATION BITS u
N
x
30
TRANSMISSION PATH
20
RECEIVER
21
DEMODULATION PORTION
22
DECODING PORTION
N
y
K
ESTIMATION INFORMATION BITS û
ENCODING PORTION
11a
PRE-ENCODING PROCESSING PORTION
11b
TURBO ENCODER G1
11c
POST-ENCODING PROCESSING PORTION
INFORMATION BITS (u)
K
(u, a)
x1 = (u, a, p)
N
ENCODED BITS(x)
DECODING PORTION
22
22a
PRE-DECODING PROCESSING
22b
TURBO DECODER
N
RECEPTION LIKELIHOOD DATA(y)
N1
K
INFORMATION BIT ESTIMATION VALUES û
91
REPETITION PROCESSING PORTION
92
DUMMY BIT ADDITION PORTION
93
DUMMY BIT DELETION PORTION
95
REPETITION BIT DELETION PORTION
96
0 LIKELIHOOD REPETITION BIT INSERTION PORTION
94
DUMMY BIT ADDITION PORTION

FIG. 35

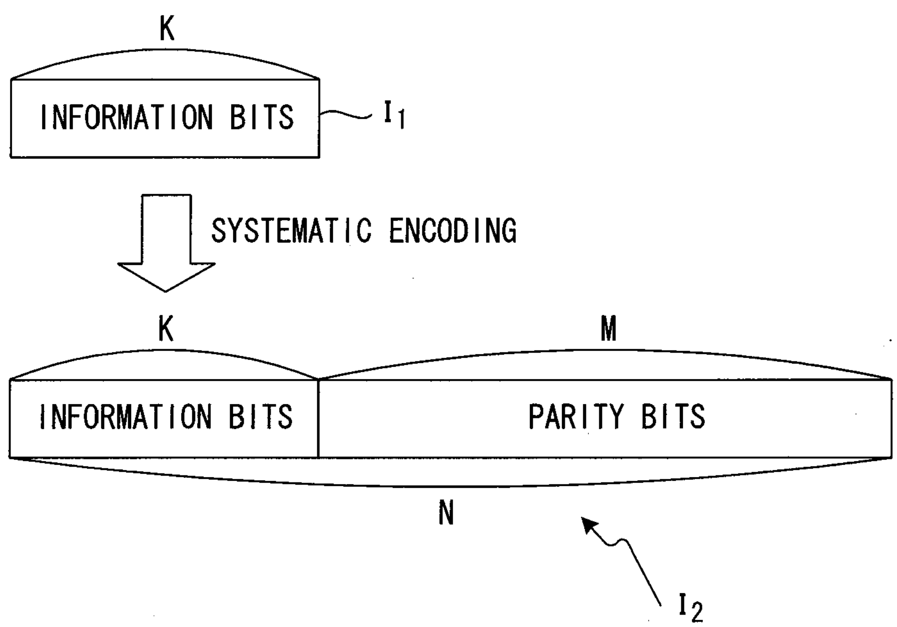
K
INFORMATION BITS
$I_1$
SYSTEMATIC ENCODING
K
M
INFORMATION BITS
PARITY BITS
N
$I_2$

FIG. 36

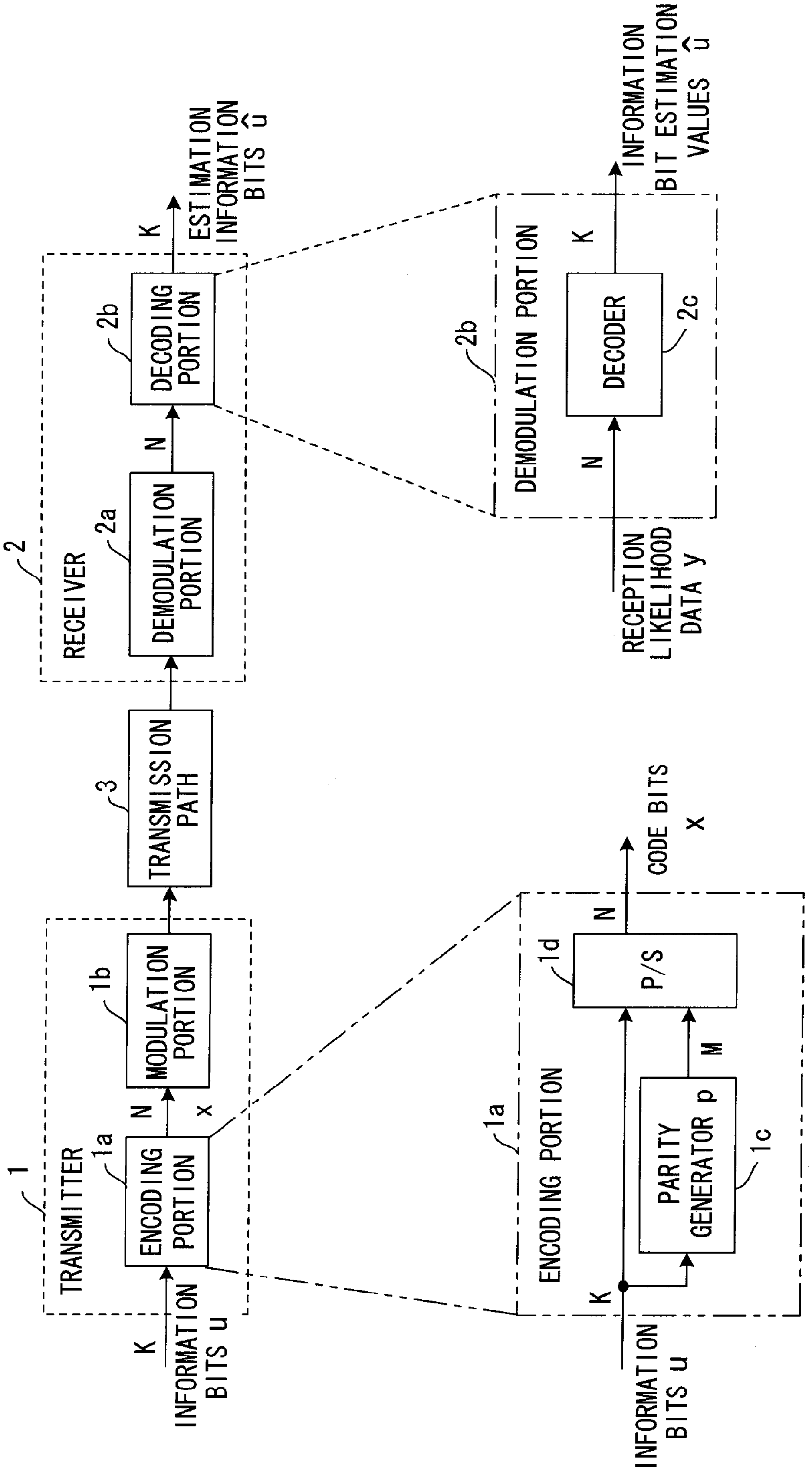

1
TRANSMITTER
1a
ENCODING PORTION
1b
MODULATION PORTION
K
INFORMATION BITS u
N
x
3
TRANSMISSION PATH
2
RECEIVER
2a
DEMODULATION PORTION
2b
DECODING PORTION
N
K
ESTIMATION INFORMATION BITS û
1a
ENCODING PORTION
1c
PARITY GENERATOR p
1d
P/S
K
M
N
INFORMATION BITS u
CODE BITS x
2b
DEMODULATION PORTION
2c
DECODER
N
K
RECEPTION LIKELIHOOD DATA y
INFORMATION BIT ESTIMATION VALUES û

FIG. 37

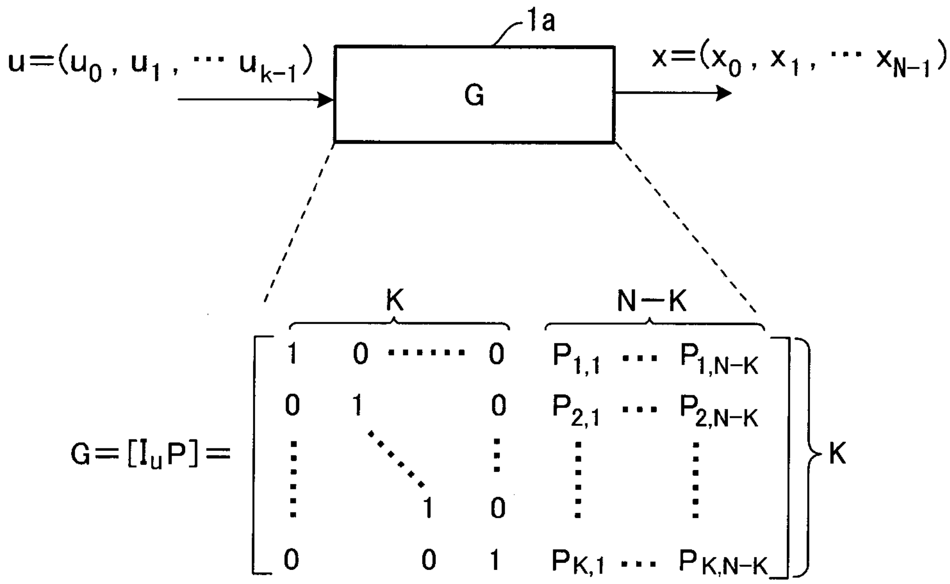
1a
u=(u0 , u1 , ··· uk−1)
G
x=(x0 , x1 , ··· xN−1)
K
N−K
G=[IuP]=
1 0 ······ 0 P1,1 ··· P1,N−K
0 1 0 P2,1 ··· P2,N−K
1 0
0 0 1 PK,1 ··· PK,N−K
K

FIG. 38

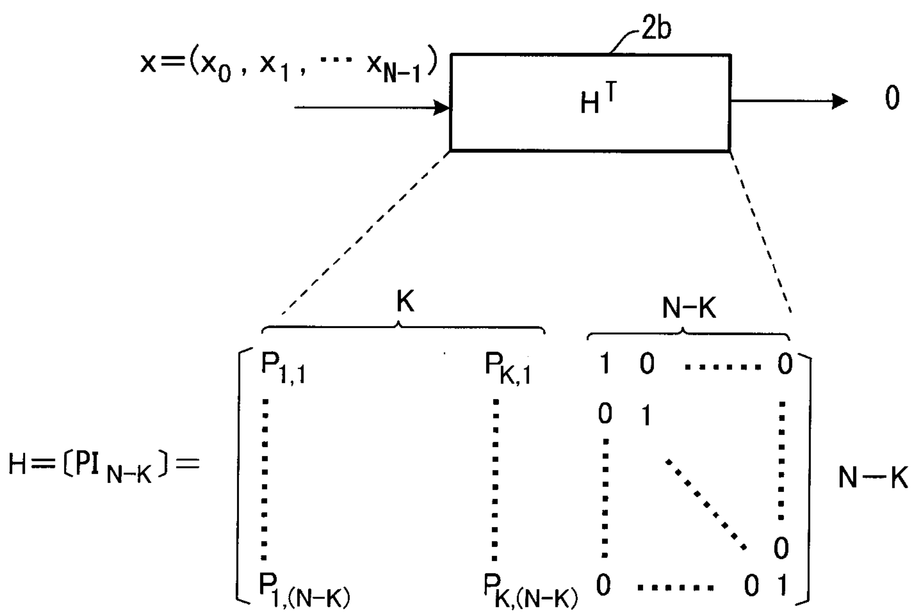
2b
x=(x0 , x1 , ··· xN−1)
HT
0
K
N−K
H=〔PI N−K〕=
P1,1 PK,1 1 0 ······ 0
0 1
0
P1,(N−K) PK,(N−K) 0 ······ 0 1
N−K

FIG. 39

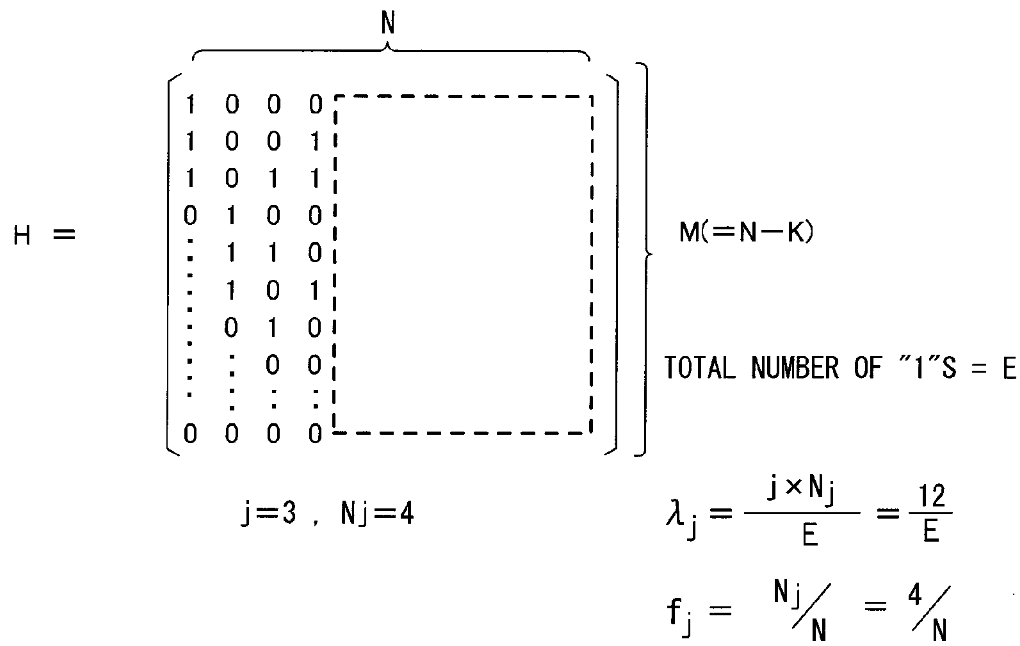
N
H =
1 0 0 0
1 0 0 1
1 0 1 1
0 1 0 0
1 1 0
1 0 1
0 1 0
0 0
0 0 0 0
M(=N−K)
TOTAL NUMBER OF "1"S = E
j=3 , Nj=4
$\lambda_j = \frac{j \times N_j}{E} = \frac{12}{E}$
$f_j = N_j/N = 4/N$

FIG. 40

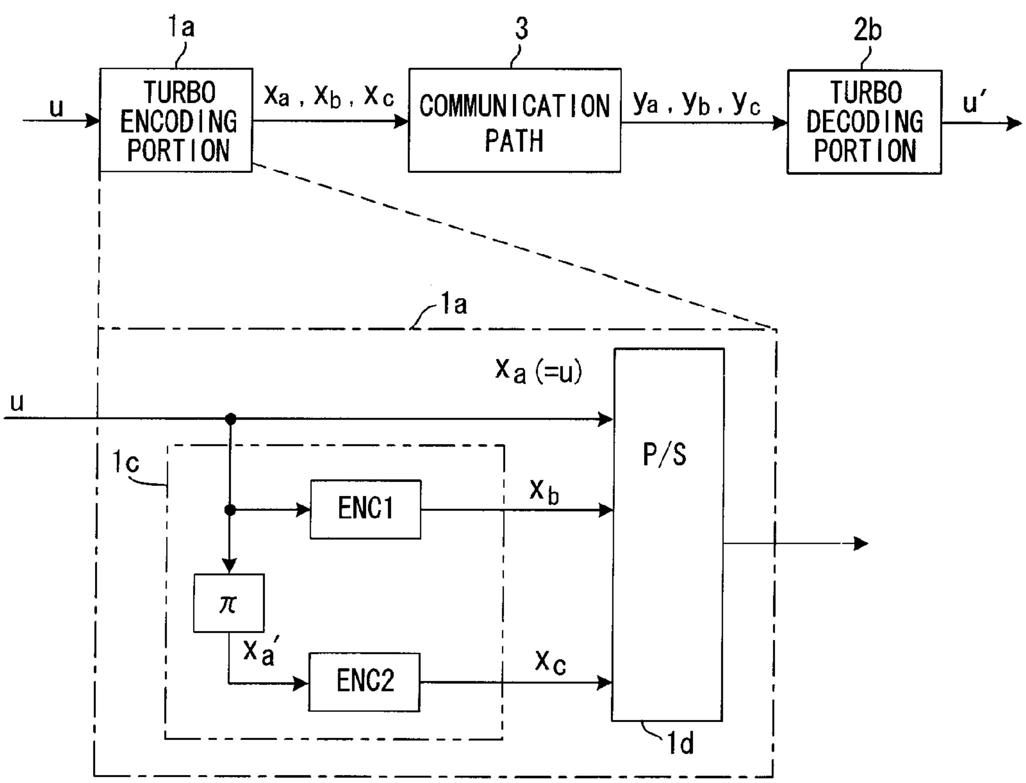
1a
3
2b
u
TURBO ENCODING PORTION
Xa , Xb , Xc
COMMUNICATION PATH
Ya , Yb , Yc
TURBO DECODING PORTION
u'
1a
Xa (=u)
u
P/S
1c
ENC1
Xb
π
Xa'
ENC2
Xc
1d

FIG. 41

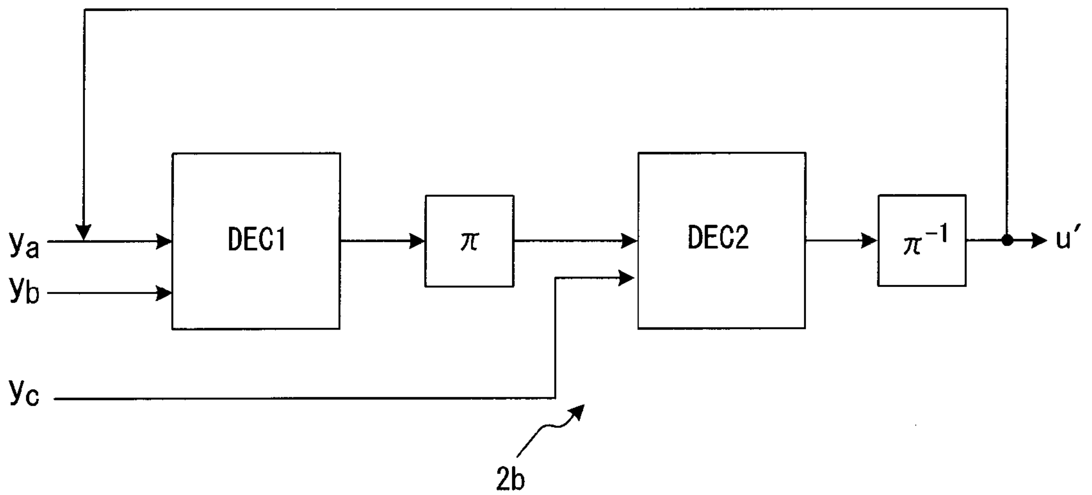
DEC1
π
DEC2
π⁻¹
u′
2b

FIG. 42

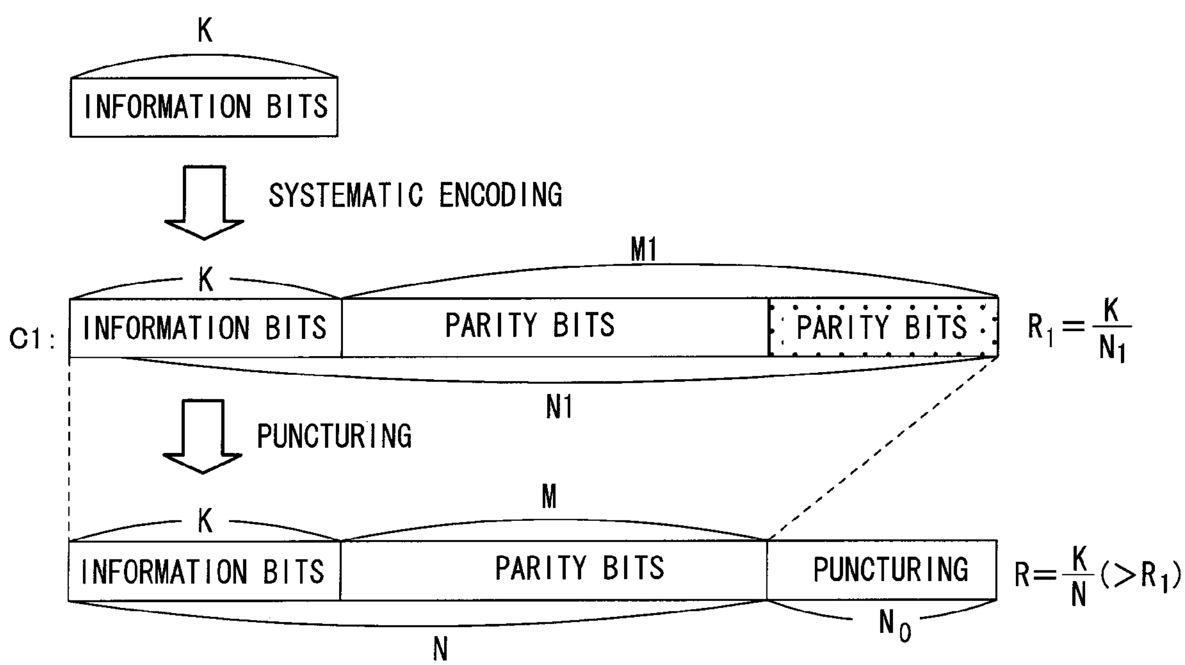
K
INFORMATION BITS
SYSTEMATIC ENCODING
M1
K
C1:
INFORMATION BITS
PARITY BITS
PARITY BITS
$R_1 = \frac{K}{N_1}$
N1
PUNCTURING
M
K
INFORMATION BITS
PARITY BITS
PUNCTURING
$R = \frac{K}{N} (>R_1)$
N
$N_0$

FIG. 43

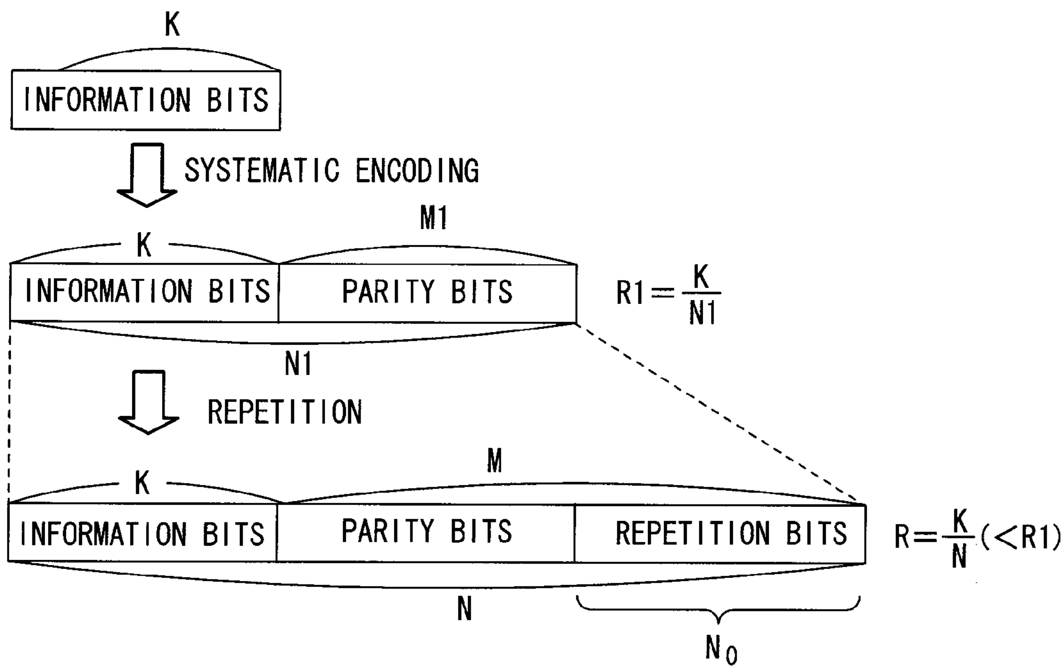
K
INFORMATION BITS
SYSTEMATIC ENCODING
K
M1
INFORMATION BITS
PARITY BITS
R1=K/N1
N1
REPETITION
K
M
INFORMATION BITS
PARITY BITS
REPETITION BITS
R=K/N(<R1)
N
N0

FIG. 44

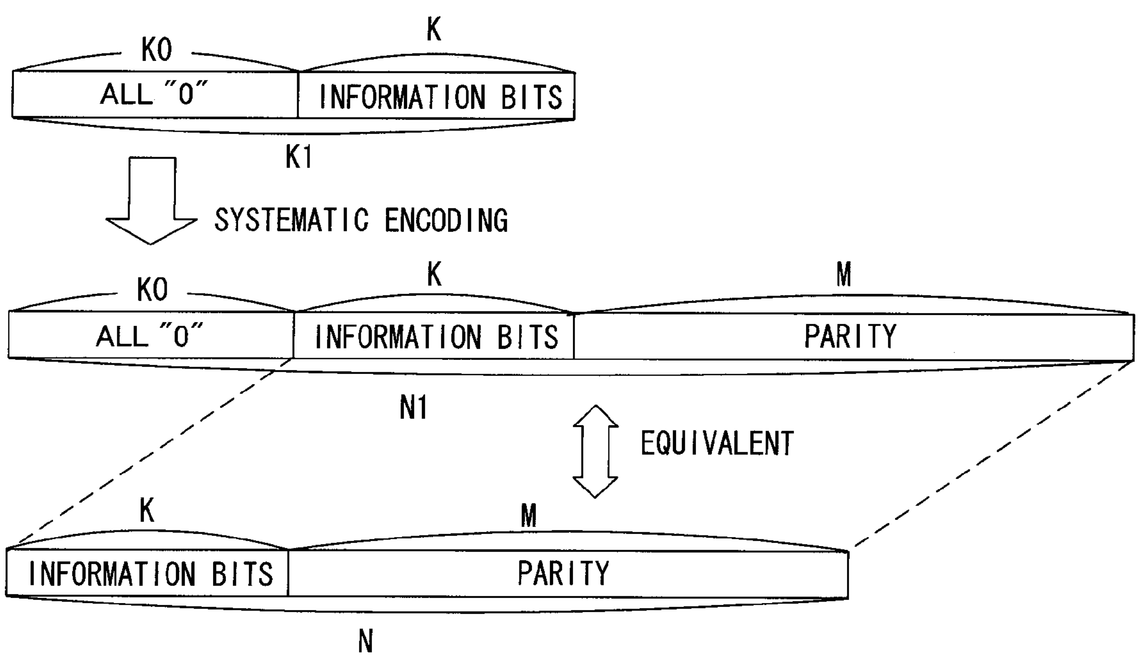
K0
K
ALL "0"
INFORMATION BITS
K1
SYSTEMATIC ENCODING
K0
K
M
ALL "0"
INFORMATION BITS
PARITY
N1
EQUIVALENT
K
M
INFORMATION BITS
PARITY
N

FIG. 45

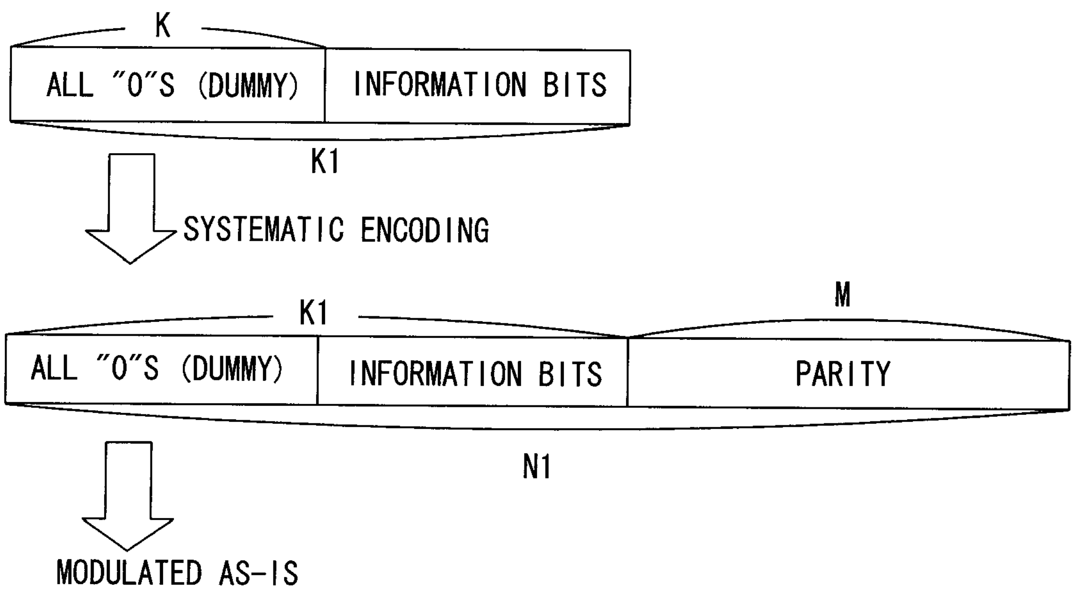
K
ALL "0"S (DUMMY)
INFORMATION BITS
K1
SYSTEMATIC ENCODING
K1
M
ALL "0"S (DUMMY)
INFORMATION BITS
PARITY
N1
MODULATED AS-IS

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- **T. Tian ; C. Jones ; J.D. Villasenor.** Rate-Compatible Low-Density Parity-Check Codes. *Int. Sym, on Information Theory,* 2004
- **S. Chung ; T. Richardson ; R. Urbanke.** Analysis of sum-product decoding of low-density parity-check codes using a Gaussian approximation. *IEEE Trans, Inform. Theory,* February 2001, vol. 47, 657-670